# EUROPEAN PATENT SPECIFICATION

(11) **EP 4 161 234 B1**
(45) Date of publication and mention of the grant of the patent: **04.03.2026**
(21) Application number: 22198331.5
(22) Date of filing: 28.09.2022
(51) Int. Cl.: H10K 30/88, H10K 85/50

(54) **PHOTOELECTRIC CONVERSION ELEMENT, PHOTOELECTRIC CONVERSION MODULE, AND ELECTRONIC DEVICE**
ELEMENT ZUR PHOTOELEKTRISCHEN UMWANDLUNG, MODUL ZUR PHOTOELEKTRISCHEN UMWANDLUNG UND ELEKTRONISCHE VORRICHTUNG
ÉLÉMENT DE CONVERSION PHOTOÉLECTRIQUE, MODULE DE CONVERSION PHOTOÉLECTRIQUE ET DISPOSITIF ÉLECTRONIQUE

(30) Priority: 30.09.2021 JP 2021162002; 10.08.2022 JP 2022128078
(43) Date of publication of application: 05.04.2023
(73) Proprietor: Ricoh Company, Ltd., Tokyo 143-8555 (JP)
(72) Inventor: TANAKA, Masato, Tokyo, 143-8555 (JP); TANAKA, Yuuji, Tokyo, 143-8555 (JP); TAMOTO, Nozomu, Tokyo, 143-8555 (JP); KANEI, Naomichi, Tokyo, 143-8555 (JP)
(74) Representative: J A Kemp LLP

(56) References cited:
- EP-A1- 4 060 700
- WO-A1-2011/065353
- WO-A1-2022/200898
- JP-A- 2014 150 081
- US-A1- 2018 019 423

## Description

### BACKGROUND OF THE INVENTION

### 1. Field of the Invention

The disclosures herein generally relate to a photoelectric conversion element, a photoelectric conversion module, and an electronic device.

### 2. Description of the Related Art

In recent years, the importance of solar cells as alternative energy of fossil fuel or measures against global warming has increased. Solar cells and photodiodes are obtained by applying photoelectric conversion elements that can convert light energy into electric energy.

Recently, indoor photoelectric conversion elements, which exhibit high power generation performance with not only sunlight (illuminance in direct sunlight: about 100,000 lux) but also light having a low illuminance (illuminance: 20 lux or more and 1,000 lux or less) such as light emitting diodes (LEDs) and fluorescent lamps, have attracted much attention.

However, there is a problem that when the photoelectric conversion element is stored under high temperature and high humidity environment, its output decreases significantly.

Therefore, in order to prevent water vapor or oxygen in the external environment from passing into the photoelectric conversion element under high temperature and high humidity environment to thereby decrease the photoelectric conversion efficiency, an organic thin film solar cell element, which includes an adhesive layer obtained by curing a photocurable resin or a thermosetting resin so that the resin covers the whole photoelectric conversion layer, has been proposed (see, for example, Japanese Unexamined Patent Application Publication No. 2013-168572).
WO 2011/065353 Al, US 2018/019423 Al, JP 2014 150081 A, EP 4 060 700 Al and WO 2022/200898 Al disclose background art to the invention.

### SUMMARY OF THE INVENTION

According to the present invention there is provided a photoelectric conversion element according to the appended claims.

### BRIEF DESCRIPTION OF THE DRAWINGS

Figures 1, 5, 6 and 7 are not according to the claimed invention as they fail to disclose the electrode protection layer.
Fig. 1 is a schematic view illustrating one example of a photoelectric conversion element of the present disclosure;
Fig. 2 is a drawing is a schematic view illustrating another example of a photoelectric conversion element of the present disclosure;
Fig. 3 is a schematic view illustrating another example of a photoelectric conversion element of the present disclosure;
Fig. 4 is a schematic view illustrating another example of a photoelectric conversion element of the present disclosure;
Fig. 5 is a schematic view illustrating another example of a photoelectric conversion element of the present disclosure;
Fig. 6 is a schematic view illustrating one example of a photoelectric conversion module of the present disclosure;
Fig. 7 is a schematic view of the photoelectric conversion module of Fig. 6 observed from a different angle;
Fig. 8 is a schematic view illustrating one example of a mouse as an electronic device of the present disclosure, which includes the photoelectric conversion module of the present disclosure;
Fig. 9 is a schematic view of one example of a mouse in which a photoelectric conversion element is mounted;
Fig. 10 is a schematic view illustrating one example of a keyboard used in a personal computer as an electronic device of the present disclosure, which includes the photoelectric conversion module of the present disclosure;
Fig. 11 is a schematic view illustrating one example of a keyboard in which a photoelectric conversion element is mounted;
Fig. 12 is a schematic view illustrating one example of a keyboard including a small photoelectric conversion element in part of keys of the keyboard;
Fig. 13 is a schematic diagram illustrating one example of a sensor as an electronic device of the present disclosure, which includes the photoelectric conversion module of the present disclosure;
Fig. 14 is a schematic diagram illustrating one example where a turntable is used as an electronic device of the present disclosure, which includes the photoelectric conversion module of the present disclosure;
Fig. 15 is a schematic diagram illustrating one example of an electronic device obtained by combining the photoelectric conversion element and/or the photoelectric conversion module of the present disclosure with a device configured to be driven by electric power generated through photoelectric conversion of the photoelectric conversion element and/or the photoelectric conversion module;
Fig. 16 is a schematic diagram illustrating one example where a power supply IC for a photoelectric conversion element is incorporated between the photoelectric conversion element and the circuit of the device of Fig. 15;
Fig. 17 is a schematic diagram illustrating one example where an electricity storage device is incorporated between the power supply IC and the circuit of the device of Fig. 16;
Fig. 18 is a schematic diagram illustrating one example of a power supply module including the photoelectric conversion element and/or the photoelectric conversion module of the present disclosure and a power supply IC;
Fig. 19 is a schematic diagram illustrating one example of a power supply module obtained by adding an electricity storage device to the power supply IC of Fig. 18; and
Fig. 20 is a drawing illustrating one example of X-ray absorption fine structure (XAFS) spectra measured using the photoelectric conversion module of Example 1.

### DESCRIPTION OF THE PREFERRED EMBODIMENTS

In the following, embodiments of the present invention will be described with reference to the accompanying drawings.

As a result of diligent studies performed by the present inventors, they found the following.

In the case of conventional photoelectric conversion elements, a sealing part that covers, for example, a side surface of a photoelectric conversion layer is provided using a photocurable resin or a thermosetting resin. However, storage under high temperature and high humidity environment and irradiation of light may significantly decrease the output and may fail to maintain the durability in some cases.

Then, the present inventors found that a photoelectric conversion element that can maintain high output under light having a low illuminance after storage under high temperature and high humidity and after continuous irradiation of light having a high illuminance can be provided when a sealing part includes a pressure-sensitive adhesive.

An object of the present disclosure is to provide a photoelectric conversion element that can maintain high output under light having a low illuminance after storage under high temperature and high humidity and after continuous irradiation of light having a high illuminance.

According to the present disclosure, it is possible to provide a photoelectric conversion element that can maintain high output under light having a low illuminance after storage under high temperature and high humidity and after continuous irradiation of light having a high illuminance.

### (Photoelectric conversion element)

A photoelectric conversion element of the present disclosure includes a first electrode, a photoelectric conversion layer, a second electrode, and a sealing part, and includes a substrate, a hole blocking layer, an electrode protection layer, and other layers if necessary.

In the specification of the present application, the "photoelectric conversion element" means an element that converts light energy into electric energy or an element that converts electric energy into light energy. Specific examples thereof include solar cells and photodiodes.

In the present disclosure, the layer may be a single film (single layer), or may be a stacked layer in which a plurality of films are stacked.

A layered direction means a direction perpendicular to a surface direction of each layer in a photoelectric conversion element. The connection means not only physical contact but also electric connection enough to be able to achieve the effect of the present disclosure.

### <Substrate>

A photoelectric conversion element of the present disclosure may include a substrate.

The shape, structure, and size of the substrate are not particularly limited and may be appropriately selected in accordance with the intended purpose.

The material of the substrate is not particularly limited and may be appropriately selected in accordance with the intended purpose as long as it has translucency and an insulation property. Examples thereof include substrates such as glass, plastic films, and ceramic. Among them, when a firing step for forming an electron transport layer is included as described hereinafter, a substrate having heat resistance to a firing temperature is preferable. Moreover, preferable examples of the first substrate include those having a flexibility.

The substrate may be disposed on the outermost part of the first electrode side of the photoelectric conversion element, on the outermost part of the second electrode side, or both.

A substrate disposed on the outermost part of the first electrode side will be referred to as "first substrate", and a substrate disposed on the outermost part of the second electrode side will be referred to as "second substrate" hereinafter.

### <First electrode>

The photoelectric conversion element includes a first electrode.

The shape and size of the first electrode are not particularly limited and may be appropriately selected in accordance with the intended purpose.

The structure of the first electrode is not particularly limited and may be appropriately selected in accordance with the intended purpose. The structure may be a single layer structure or a structure in which a plurality of materials is stacked.

The material of the first electrode is not particularly limited and may be appropriately selected in accordance with the intended purpose as long as it has transparency to visible rays and conductivity. Examples thereof include transparent conductive metal oxides, carbon materials, and metals.

Examples of the transparent conductive metal oxide include indium-tin oxide (referred to as "ITO" hereinafter), fluorine-doped tin oxide (referred to as "FTO" hereinafter), antimony-doped tin oxide (referred to as "ATO" hereinafter), niobium-doped tin oxide (referred to as "NTO" hereinafter), aluminum-doped zinc oxide, indium-zinc oxide, and niobium-titanium oxide.

Examples of the carbon include carbon black, carbon nanotube, graphene, and fullerene.

Examples of the metal include gold, silver, aluminum, nickel, indium, tantalum, and titanium.

These may be used alone or in combination. Among them, transparent conductive metal oxide having high transparency is preferable, and ITO, FTO, ATO, and NTO are more preferable.

An average thickness of the first electrode is not particularly limited and may be appropriately selected in accordance with the intended purpose. The average thickness of the first electrode is preferably 5 nm or more and 100 µm or less, more preferably 50 nm or more and 10 µm or less. When a material of the first electrode is carbon or metal, the average thickness of the first electrode is preferably an average thickness enough to obtain translucency.

The first electrode can be formed by conventional methods such as the sputtering method, the vapor deposition method, and the spray method.

Moreover, the first electrode is preferably formed on the first substrate. It is possible to use an integrated commercially available product where the first electrode has been formed on the first substrate in advance.

Examples of the integrated commercially available product include FTO-coated glass, ITO-coated glass, zinc oxide/aluminum coated glass, FTO-coated transparent plastic films, and ITO-coated transparent plastic films. Other examples of the integrated commercially available product include: glass substrates provided with a transparent electrode where tin oxide or indium oxide is doped with a cation or an anion having a different atomic value; and glass substrates provided with a metal electrode having such a structure that allows light in the form of a mesh or stripes to pass.

These may be used alone, or two or more products may be used in combination as a mixture or a laminate. Moreover, a metal lead wire may be used in combination in order to decrease an electric resistance value.

Examples of a material of the metal lead wire include aluminum, copper, silver, gold, platinum, and nickel.

The metal lead wire can be used in combination by forming the metal lead wire on a substrate through, for example, vapor deposition, sputtering, or pressure bonding, and disposing a layer of ITO or FTO thereon.

### <Hole blocking layer>

The photoelectric conversion element preferably includes a hole blocking layer.

The hole blocking layer is formed between the first electrode and an electron transport layer that will be described hereinafter.

The hole blocking layer is very effective in improving output and its persistence.

The hole blocking layer includes a photosensitization compound, transports, to a first electrode, electrons transported to an electron transport layer, and minimizes contact with a hole transport layer. As a result, the hole blocking layer does not easily allow holes to flow to the first electrode and can minimize a decrease in output due to recombining of electrons and holes.

A solid photoelectric conversion element including the hole transport layer has much greater effects achieved by formation of the hole blocking layer than a wet photoelectric conversion element including an electrolyte because of a higher recombining speed of holes in the hole transport material and electrons on the surface of the electrode.

The material of the hole blocking layer is not particularly limited and may be appropriately selected in accordance with the intended purpose as long as it has transparency to visible rays and an electron transport property. Examples thereof include: semiconductors of simple substances such as silicon and germanium; compound semiconductors such as chalcogenides of metal, and compounds having a perovskite structure.

Examples of the chalcogenide of metal include: oxides of titanium, tin, zinc, iron, tungsten, zirconium, hafnium, strontium, indium, cerium, yttrium, lanthanum, vanadium, niobium, and tantalum; sulfides of cadmium, zinc, lead, silver, antimony, and bismuth; selenide of cadmium and lead; and tellurides of cadmium. Examples of other compound semiconductors include: phosphides of zinc, gallium, indium, and cadmium; gallium arsenide, copper-indium selenide, and copper-indium sulfide.

Examples of the compound having a perovskite structure include strontium titanate, calcium titanate, sodium titanate, barium titanate, and potassium niobate.

Among them, an oxide semiconductor is preferable, titanium oxide, niobium oxide, magnesium oxide, aluminum oxide, zinc oxide, tungsten oxide, and tin oxide are more preferable, and titanium oxide is still more preferable.

These may be used alone or in combination. These may be a single layer or may be a stacked layer. The crystal type of these semiconductors is not particularly limited and may be appropriately selected in accordance with the intended purpose. The crystal type may be a single crystal, a polycrystal, or an amorphous crystal.

A method of producing the hole blocking layer is not particularly limited and may be appropriately selected in accordance with the intended purpose. Examples thereof include a method in which a thin film is formed in vacuum (vacuum film formation method); and a wet film formation method.

Examples of the vacuum film formation method include the sputtering method, the pulse laser deposition method (PLD method), the ion beam sputtering method, the ion assisted deposition method, the ion plating method, the vacuum deposition method, the atomic layer deposition method (ALD method), and the chemical vapor deposition method (CVD method).

Examples of the wet film formation method include a sol-gel method. The sol-gel method is the following method. Specifically, a solution is allowed to undergo a chemical reaction such as hydrolysis or polymerization ▪ condensation to prepare gel. Then, it is subjected to a heat treatment to facilitate compactness. When the sol-gel method is used, a method of coating the sol solution is not particularly limited and may be appropriately selected in accordance with the intended purpose. Examples thereof include the dip method, the spray method, the wire bar method, the spin coating method, the roller coating method, the blade coating method, the gravure coating method, and wet printing methods such as relief printing, offset printing, gravure printing, intaglio printing, rubber plate printing, and screen printing. A temperature at which the heat treatment is performed after the sol solution is coated is preferably 80°C or more, more preferably 100°C or more.

The average thickness of the hole blocking layer is not particularly limited and may be appropriately selected in accordance with the intended purpose. The average thickness is preferably 5 nm or more and 1 µm or less. **In** the case of the wet film formation, the average thickness is more preferably 500 nm or more and 700 nm or less. **In** the case of the drying film formation, the average thickness is more preferably 5 nm or more and 30 nm or less.

### <Photoelectric conversion layer>

The photoelectric conversion layer includes an electron transport layer and a hole transport layer, and further includes other layers if necessary.

The photoelectric conversion layer may be a single layer or a multilayer in which a plurality of layers is stacked.

The photoelectric conversion layer preferably includes a basic compound.

The basic compound is included in any of layers constituting the photoelectric conversion layer, but is preferably included in, for example, the hole transport layer.

### <<Electron transport layer>>

The photoelectric conversion element includes an electron transport layer.

The electron transport layer is formed for the purpose of transporting generated electrons to the hole blocking layer. Therefore, the electron transport layer is preferably disposed adjacent to the hole blocking layer.

The structure of the electron transport layer is not particularly limited and may be appropriately selected in accordance with the intended purpose. Preferably, in at least two photoelectric conversion elements adjacent to each other, the electron transport layers are not continuous and are separated. Separation of the electron transport layers is advantageous because diffusion of electrons is minimized to decrease leak current, resulting in improvement of photodurability.

The structure of the electron transport layer may be a continuous single layer or a multilayer in which a plurality of layers is stacked.

The electron transport layer includes an electron transport material, preferably includes a photosensitization compound, and includes, if necessary, other materials.

The electron transport material is not particularly limited and may be appropriately selected in accordance with the intended purpose. The electron transport material is preferably a semiconductor material.

Preferably, the semiconductor material has a particulate shape, and these particles are joined to form a porous film. On the surfaces of semiconductor particles constituting the porous electron transport layer, a photosensitization compound is chemically or physically adsorbed. When the electron transport layer is porous, an amount of the photosensitization compound adsorbed on the surface can be drastically increased, which is effective in achieving high output.

The semiconductor material is not particularly limited and conventional materials may be used. Examples thereof include semiconductors of simple substances, compound semiconductors, and compounds having a perovskite structure.

Examples of the semiconductor of the simple substance include silicon and germanium.

Examples of the compound semiconductor include chalcogenides of metal. Specific examples thereof include oxides of titanium, tin, zinc, iron, tungsten, zirconium, hafnium, strontium, indium, cerium, yttrium, lanthanum, vanadium, niobium, and tantalum; sulfides of cadmium, zinc, lead, silver, antimony, and bismuth; selenides of cadmium and lead; and telluride of cadmium. Examples of other compound semiconductors include phosphides of, for example, zinc, gallium, indium, and cadmium, gallium arsenide, copper-indium selenide, and copper-indium sulfide.

Examples of the compound having a perovskite structure include strontium titanate, calcium titanate, sodium titanate, barium titanate, and potassium niobate.

Among the semiconductor materials, an oxide semiconductor is preferable, and, particularly, titanium oxide, zinc oxide, tin oxide, and niobium oxide are more preferable. When the electron transport material of the electron transport layer is titanium oxide, a high open circuit voltage can be obtained because of its high conduction band level, resulting in high photoelectric conversion characteristics, which is advantageous. **In** addition, because titanium oxide has a high refractive index, a light confinement effect can be achieved, which makes it possible to obtain a high short circuit current. Moreover, because titanium oxide has high permittivity and high mobility, a high fill factor can be obtained, which is advantageous.

These may be used alone or in combination. The crystal type of the semiconductor material is not particularly limited and may be appropriately selected in accordance with the intended purpose. The crystal type may be a single crystal, a polycrystal, or an amorphous crystal.

A number average particle diameter of primary particles of the semiconductor material is not particularly limited and may be appropriately selected in accordance with the intended purpose. The number average particle diameter is preferably 1 nm or more and 100 nm or less, and more preferably 5 nm or more and 50 nm or less. Moreover, a semiconductor material having a number average particle diameter that is larger than the above upper limit of the number average particle diameter may be mixed or stacked. Such a semiconductor material can produce the effect of scattering incident light to improve conversion efficiency. **In** this case, the number average particle diameter is preferably 50 nm or more and 500 nm or less.

An average thickness of the electron transport layer is not particularly limited and may be appropriately selected in accordance with the intended purpose. The average thickness is preferably 50 nm or more and 100 µm or less, more preferably 100 nm or more and 50 µm or less, and still more preferably 120 nm or more and 10 µm or less. An average thickness of the electron transport layer falling within the preferable range is advantageous because an amount of the photosensitization compound per unit projection area can be sufficiently secured, a high light trapping rate can be maintained, the diffusion distance of injected electrons does not easily increase, and the loss caused due to recombining of electric charges can be decreased.

A method of producing the electron transport layer is not particularly limited and may be appropriately selected in accordance with the intended purpose. Examples thereof include: a method in which a thin film is formed in vacuum such as sputtering; a wet film formation method; and a wet printing method. Among them, in terms of production costs, the wet film formation method is preferable, and a method, in which paste (dispersion liquid of the semiconductor material) obtained by dispersing powder or sol of the semiconductor material is prepared and is coated on the first electrode as an electron collecting electrode substrate or on the hole blocking layer, is more preferable.

The wet film formation method is not particularly limited and may be appropriately selected in accordance with the intended purpose. Examples thereof include the dip method, the spray method, the wire bar method, the spin coating method, the roller coating method, the blade coating method, the gravure coating method, and the die coating method.

As the wet printing method, various methods such as relief printing, offset printing, gravure printing, intaglio printing, rubber plate printing, and screen printing can be used.

Examples of a method of preparing the dispersion liquid of the semiconductor material include a mechanically pulverizing method using, for example, a conventional milling device. This method makes it possible to prepare a dispersion liquid of a semiconductor material by dispersing, in water or a solvent, a particulate semiconductor material alone or a mixture of a semiconductor material and a resin.

Examples of the resin include polymers or copolymers of vinyl compounds such as styrene, vinyl acetate, acrylic ester, and methacrylate, silicon resins, phenoxy resins, polysulfone resins, polyvinyl butyral resins, polyvinyl formal resins, polyester resins, cellulose ester resins, cellulose ether resins, urethane resins, phenol resins, epoxy resins, polycarbonate resins, polyarylate resins, polyamide resins, and polyimide resins. These may be used alone or in combination.

Examples of the solvent include water, alcohol solvents, ketone solvents, ester solvents, ether solvents, amide solvents, halogenated hydrocarbon solvents, and hydrocarbon solvents.

Examples of the alcohol solvent include methanol, ethanol, isopropyl alcohol, and α-terpineol.

Examples of the ketone solvent include acetone, methyl ethyl ketone, and methyl isobutyl ketone.

Examples of the ester solvent include ethyl formate, ethyl acetate, and n-butyl acetate.

Examples of the ether solvent include diethyl ether, dimethoxy ethane, tetrahydrofuran, dioxolane, and dioxane.

Examples of the amide solvent include N,N-dimethylformamide, N,N-dimethylacetoamide, and N-methyl-2-pyrrolidone.

Examples of the halogenated hydrocarbon solvent include dichloromethane, chloroform, bromoform, methyl iodide, dichloroethane, trichloroethane, trichloroethylene, chlorobenzene, o-dichlorobenzene, fluorobenzene, bromobenzene, iodobenzene, and 1-chloronaphthalene.

Examples of the hydrocarbon solvent include n-pentane, n-hexane, n-octane, 1,5-hexadiene, cyclohexane, methylcyclohexane, cyclohexadiene, benzene, toluene, o-xylene, m-xylene, p-xylene, ethylbenzene, and cumene.

These may be used alone or in combination.

In order to minimize reaggregation of particles, acid, a surfactant, a chelating agent, or the like may be added to the dispersion liquid including the semiconductor material or the paste including the semiconductor material obtained through, for example, the sol-gel method.

Examples of the acid include hydrochloric acid, nitric acid, and acetic acid.

Examples of the surfactant include polyoxyethylene octylphenyl ether.

Examples of the chelating agent include acetylacetone, 2-aminoethanol, and ethylenediamine.

For the purpose of improving the film forming property, addition of a thickener is an effective means.

Examples of the thickener include polyethylene glycol, polyvinyl alcohol, and ethyl cellulose.

After the semiconductor material is coated, particles of the semiconductor material may be electronically brought into contact with each other, the semiconductor material may be fired to improve the film strength or adhesiveness to a substrate, microwave or electron beams may be emitted, or laser light may be emitted. These treatments may be performed alone or in combination.

When the electron transport layer formed from the semiconductor material is fired, the firing temperature is not particularly limited and may be appropriately selected in accordance with the intended purpose. If the temperature is too high, a substrate may have a high resistance and melting may occur. Therefore, the firing temperature is preferably 30°C or more and 700°C or less, and more preferably 100°C or more and 600°C or less. The firing time is not particularly limited and may be appropriately selected in accordance with the intended purpose. The firing time is preferably 10 minutes or more and 10 hours or less.

When the electron transport layer formed from the semiconductor material is irradiated with microwave, the irradiation time is not particularly limited and may be appropriately selected in accordance with the intended purpose. The irradiation time is preferably 1 hour or less. In this case, irradiation may be performed from a surface side where the electron transport layer is formed, or irradiation may be performed from a surface side where no electron transport layer is formed.

After the electron transport layer formed of the semiconductor material is fired, chemical plating using a mixed solution of a titanium tetrachloride aqueous solution and an organic solvent or an electrochemical plating treatment using a titanium trichloride aqueous solution may be performed in order to increase a surface area of the electron transport layer or to enhance an electron injection efficiency from a photosensitization compound that will be described hereinafter to the semiconductor material.

A film obtained by firing the semiconductor material having a diameter of several tens of nanometers may have a porous shape. Such a porous nanostructure has a considerably high surface area, and the surface area can be represented by a roughness factor. The roughness factor is a numerical value representing an actual area of the porous inner part relative to an area of the semiconductor particles coated on the first substrate. Therefore, the roughness factor is preferably larger, but is preferably 20 or more in relation to an average thickness of the electron transport layer.

The particles of the electron transport material may be doped with a lithium compound. Specifically, a solution of a lithium bis(trifluoromethanesulfonimide) compound is deposited on particles of the electron transport material through spin coating, followed by firing.

The lithium compound is not particularly limited and may be appropriately selected in accordance with the intended purpose. Examples thereof include lithium bis(trifluoromethanesulfonimide), lithium bis(fluoromethanesulfonimide), lithium bis(fluoromethanesulfonyl)(trifluoromethanesulfonyl)imide, lithium perchlorate, and lithium iodide.

### <<<Photosensitization compound>>>

The photosensitization compound is preferably disposed on the electron transport layer.

A compound that further improves output or photoelectric conversion efficiency can be used for the photosensitization compound. The photosensitization compound is preferably adsorbed on the surface of a semiconductor material constituting the electron transport layer.

The photosensitization compound is not particularly limited and may be appropriately selected in accordance with the intended purpose as long as it is photoexcited by light to be applied to the photoelectric conversion element. Examples thereof include the following conventional compounds.

Specific examples thereof include: metal complex compounds described in, for example, Japanese Translation of PCT International Application Publication No. 7-500630, Japanese Unexamined Patent Application Publication No. 10-233238, Japanese Unexamined Patent Application Publication No. 2000-26487, Japanese Unexamined Patent Application Publication No. 2000-323191, and Japanese Unexamined Patent Application Publication No. 2001-59062; coumarin compounds described in, for example, Japanese Unexamined Patent Application Publication No. 10-93118, Japanese Unexamined Patent Application Publication No. 2002-164089, Japanese Unexamined Patent Application Publication No. 2004-95450, and J. Phys. Chem. C, 7224, Vol. 111 (2007); polyene compounds described in, for example, Japanese Unexamined Patent Application Publication No. 2004-95450 and Chem. Commun., 4887 (2007); indoline compounds described in, for example, Japanese Unexamined Patent Application Publication No. 2003-264010, Japanese Unexamined Patent Application Publication No. 2004-63274, Japanese Unexamined Patent Application Publication No. 2004-115636, Japanese Unexamined Patent Application Publication No. 2004-200068, Japanese Unexamined Patent Application Publication No. 2004-235052, J. Am. Chem. Soc., 12218, Vol. 126 (2004), Chem. Commun., 3036 (2003), and Angew. Chem. Int. Ed., 1923, Vol. 47 (2008); thiophene compounds described in, for example, J. Am. Chem. Soc., 16701, Vol. 128 (2006), and J. Am. Chem. Soc., 14256, Vol.128 (2006); cyanine dyes described in, for example, Japanese Unexamined Patent Application Publication No. 11-86916, Japanese Unexamined Patent Application Publication No. 11-214730, Japanese Unexamined Patent Application Publication No. 2000-106224, Japanese Unexamined Patent Application Publication No. 2001-76773, and Japanese Unexamined Patent Application Publication No. 2003-7359; merocyanine dyes described in, for example, Japanese Unexamined Patent Application Publication No. 11-214731, Japanese Unexamined Patent Application Publication No. 11-238905, Japanese Unexamined Patent Application Publication No. 2001-52766, Japanese Unexamined Patent Application Publication No. 2001-76775, and Japanese Unexamined Patent Application Publication No. 2003-7360; 9-aryl xanthene compounds described in, for example, Japanese Unexamined Patent Application Publication No. 10-92477, Japanese Unexamined Patent Application Publication No. 11-273754, Japanese Unexamined Patent Application Publication No. 11-273755, and Japanese Unexamined Patent Application Publication No. 2003-31273; triarylmethane compounds described in, for example, Japanese Unexamined Patent Application Publication No. 10-93118 and Japanese Unexamined Patent Application Publication No. 2003-31273; and phthalocyanine compounds and porphyrin compounds described in, for example, Japanese Unexamined Patent Application Publication No. 9-199744, Japanese Unexamined Patent Application Publication No. 10-233238, Japanese Unexamined Patent Application Publication No. 11-204821, Japanese Unexamined Patent Application Publication No. 11-265738, J. Phys. Chem., 2342, Vol. 91 (1987), J. Phys. Chem. B, 6272, Vol. 97 (1993), Electroanal. Chem., 31, Vol. 537 (2002), Japanese Unexamined Patent Application Publication No. 2006-032260, J. Porphyrins Phthalocyanines, 230, Vol. 3 (1999), Angew. Chem. Int. Ed., 373, Vol. 46 (2007), and Langmuir, 5436, Vol. 24 (2008).

These may be used alone or in combination.

Among them, metal complex compounds, coumarin compounds, polyene compounds, indoline compounds, and thiophene compounds are preferable, and compounds expressed by the following Structural Formulas (1), (2), and (3) manufactured by Mitsubishi Paper Mills Limited are preferable.

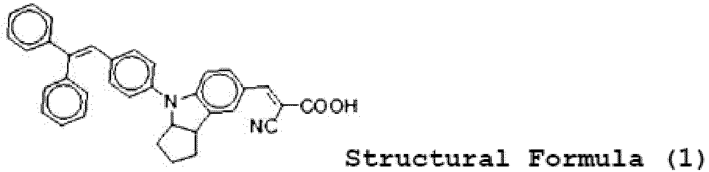

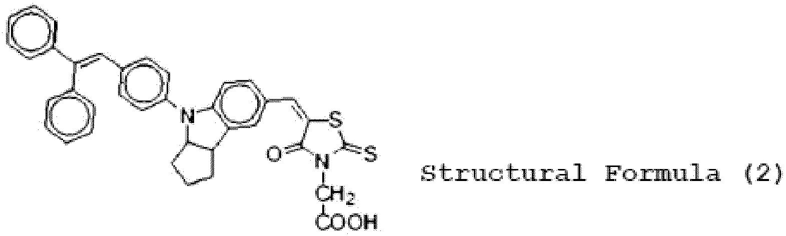

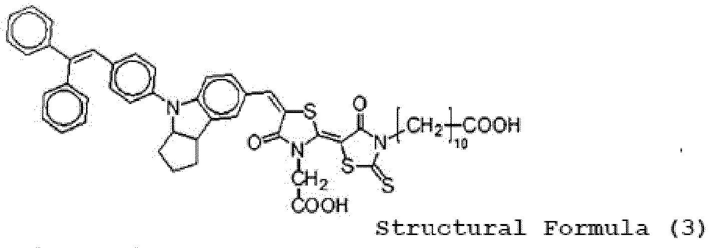

One example of a photosensitization compound that is more preferably used is, for example, a compound having the following Formula (5).

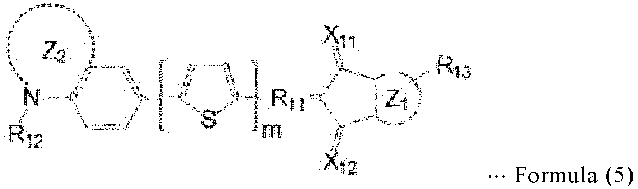

**In** Formula (5), X₁₁ and X₁₂ each independently represent an oxygen atom, a sulfur atom, or a selenium atom.

R₁₁ represents a methine group that may have a substituent. Examples of the substituent include: aryl groups such as a phenyl group and a naphthyl group; and heterocycles such as a thienyl group and a furyl group.

R₁₂ represents an alkyl group, an aryl group, or a heterocycle group, each of which may have a substituent. Examples of the alkyl group include a methyl group, an ethyl group, a 2-propyl group, and a 2-ethylhexyl group. Examples of the aryl group and the heterocycle group are exemplified above.

R₁₃ represents an acidic group such as carboxylic acid, sulfonic acid, phosphonic acid, boronic acid, or phenols. R₁₃ may be one substituent or may be two or more substituents.

Z₁ and Z₂ each independently represent a substituent that forms a cyclic structure. Examples of the Z₁ include condensed hydrocarbon-based compounds such as a benzene ring and a naphthalene ring; and heterocycles such as a thiophene ring and a furan ring, each of which may have a substituent. Specific examples of the substituent include: the aforementioned alkyl groups; and alkoxy groups such as a methoxy group, an ethoxy group, and a 2-isopropoxy group. Examples of a part including Z₂, a benzene ring fused to Z₂, and R₁₂ include the following (A-1) to (A-22).

Note that, m represents an integer of from 0 through 2.

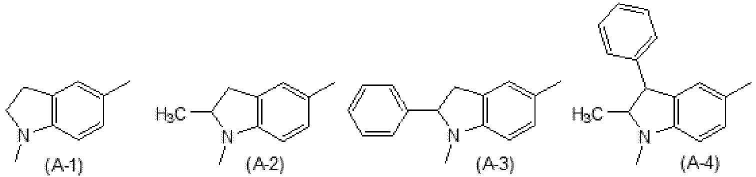

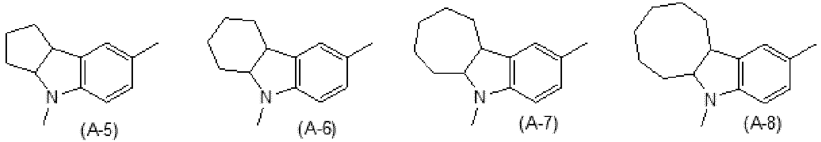

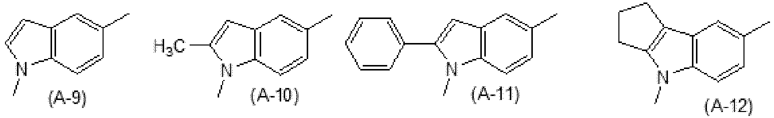

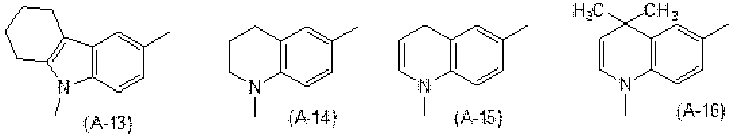

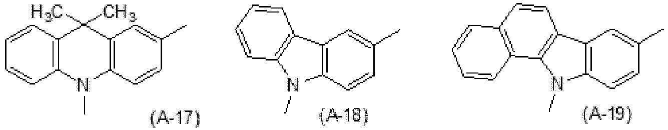

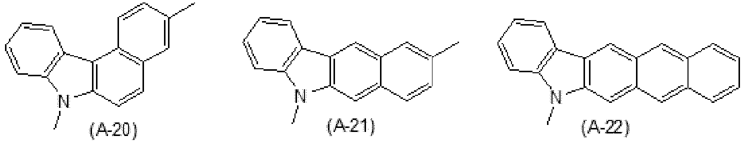

A compound represented by the following Formula (6) is more preferably used.

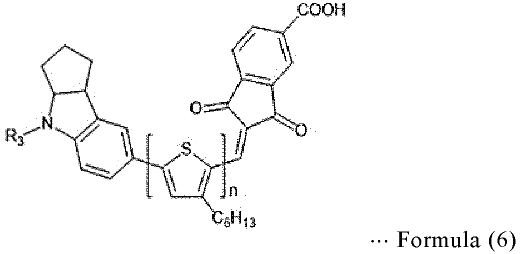

In Formula (6), n represents an integer of 0 or 1, and R₃ represent an aryl group that may have a substituent or one substituent selected from substituents expressed by the following three Structural Formulas.

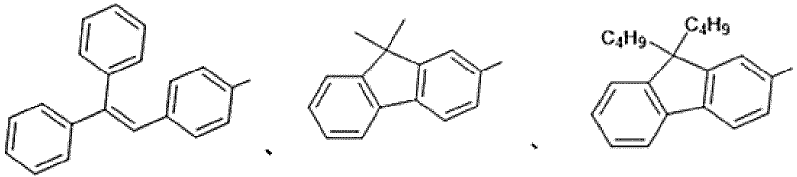

Specific examples of photosensitization compounds including Formula (5) and Formula (6) described above include the following (B-1) to (B-41), but are not limited thereto.

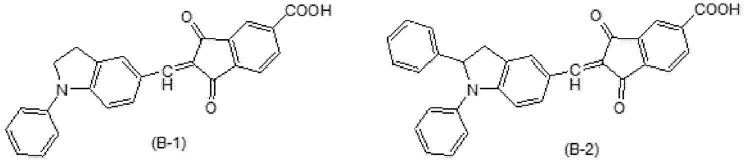

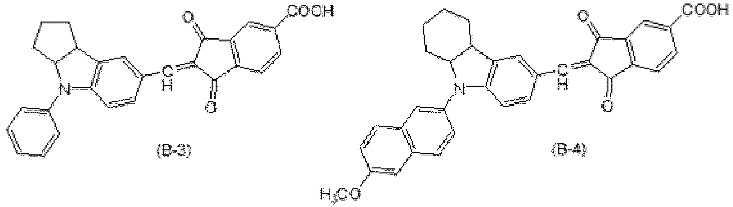

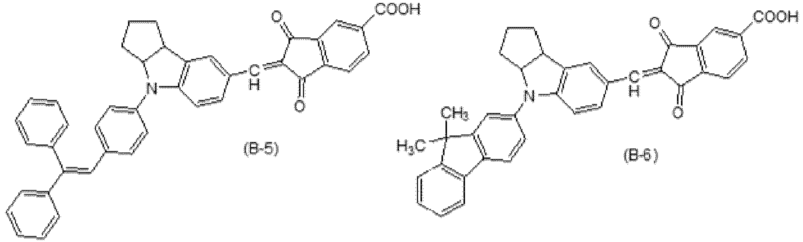

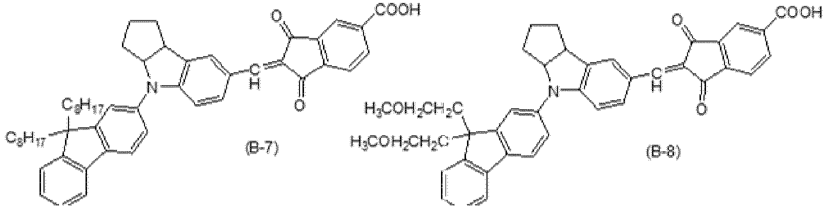

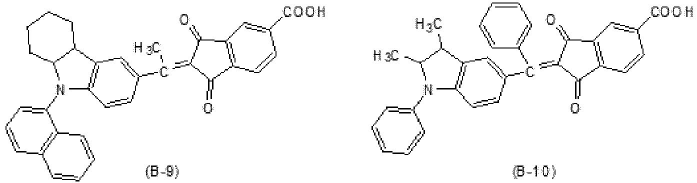

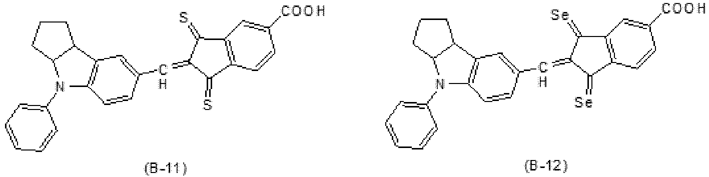

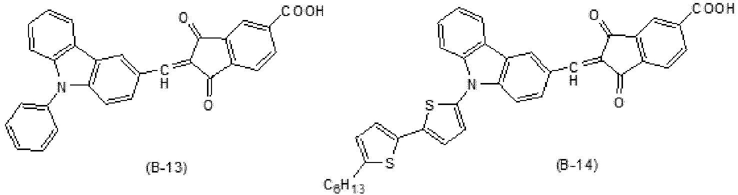

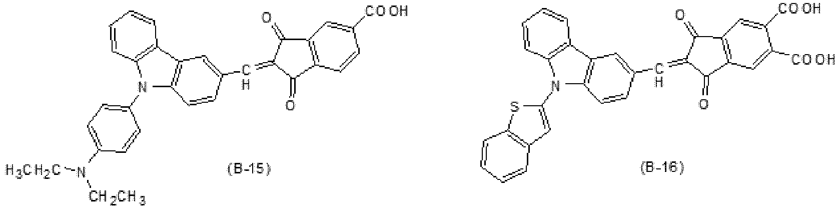

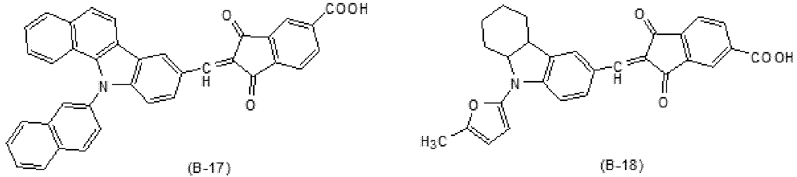

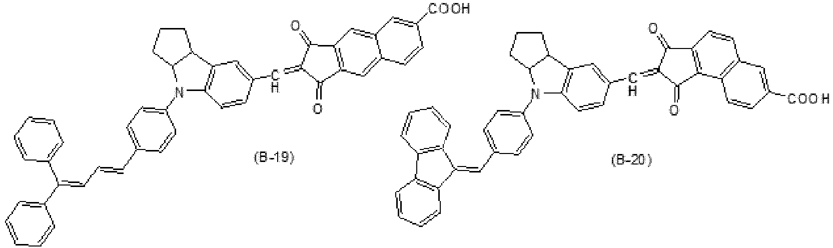

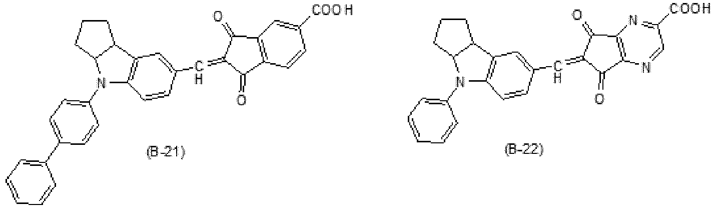

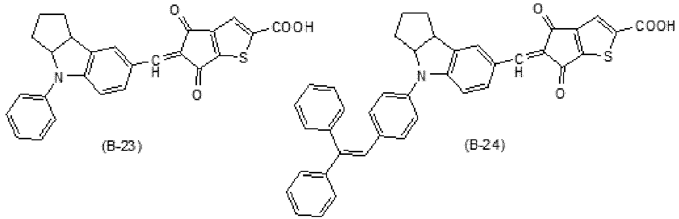

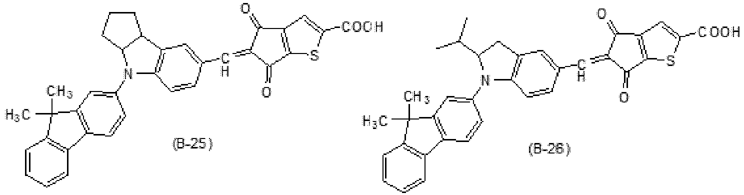

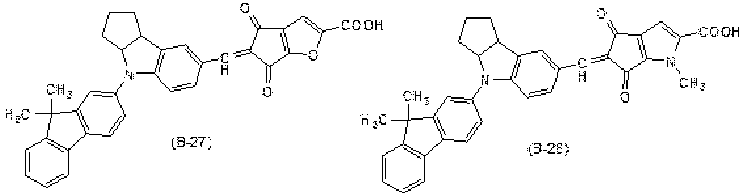

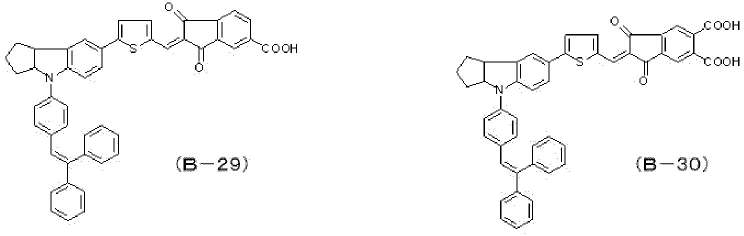

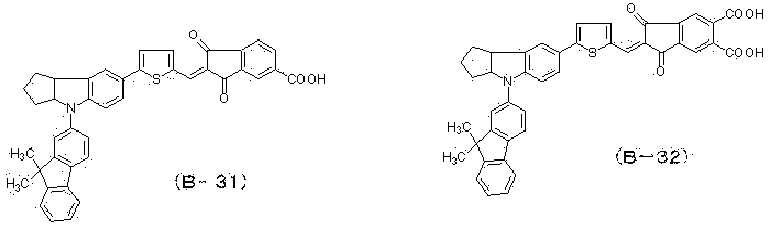

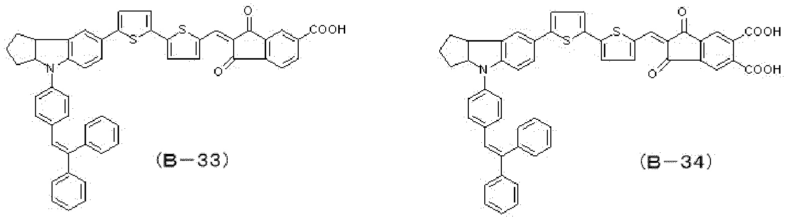

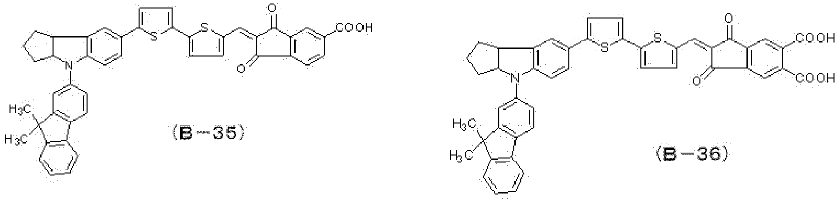

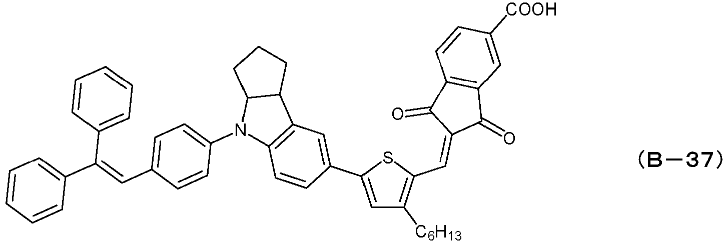

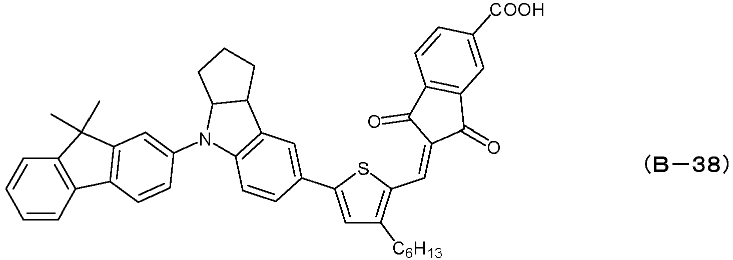

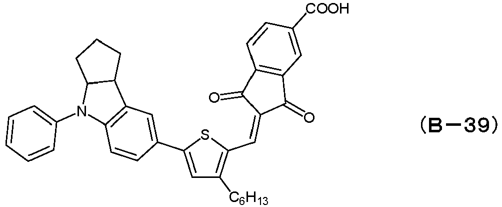

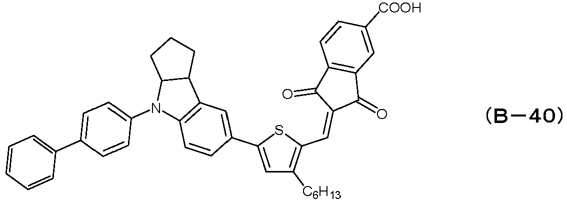

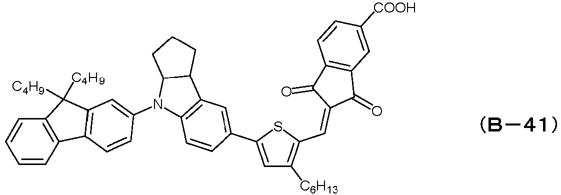

Moreover, examples of preferably used photosensitization compounds include compounds including the following Formula (7).

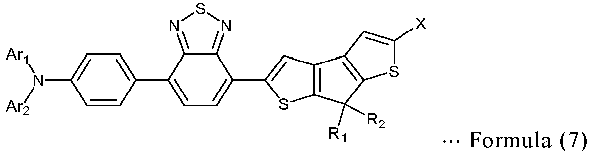

In Formula (7), Ar₁ and Ar₂ represent an aryl group that may have a substituent, R₁ and R₂ represent a straight-chain or branched alkyl group having from 4 through 10 carbon atoms, and X represents a substituent expressed by any one of the following Structural Formulas. 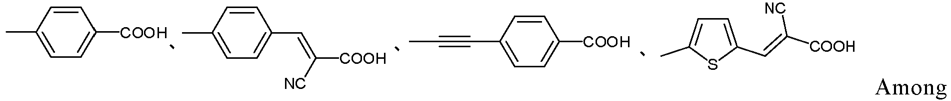 the photosensitization compounds represented by the above Formula (7), a compound represented by the following Formula (8) is more preferably used.

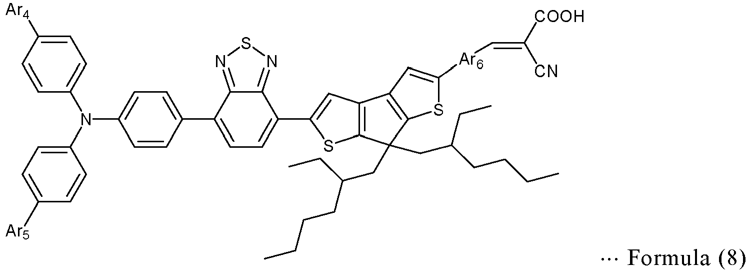

In Formula (8), Ar₄ and Ar₅ represent a phenyl group that may have a substituent or a naphthyl group that may have a substituent. Ar₆ represents a phenyl group that may have a substituent or a thiophene group that may have a substituent.

Specific exemplified compounds (B-42 to B-58) of the photosensitization compounds represented by the above Formula (7) and the above Formula (8) are presented below, but the photosensitization compounds in the present disclosure are not limited thereto.

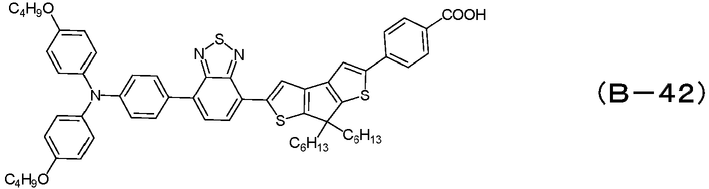

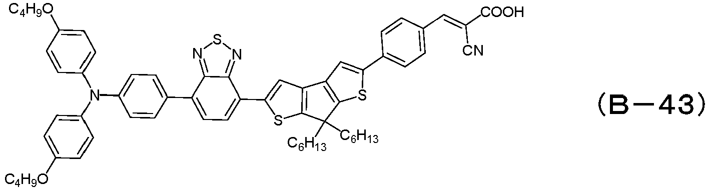

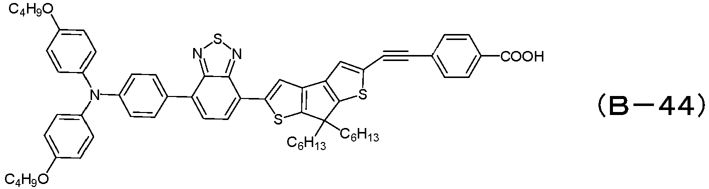

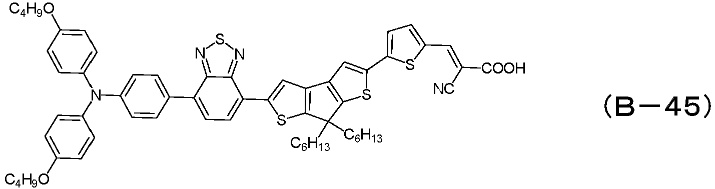

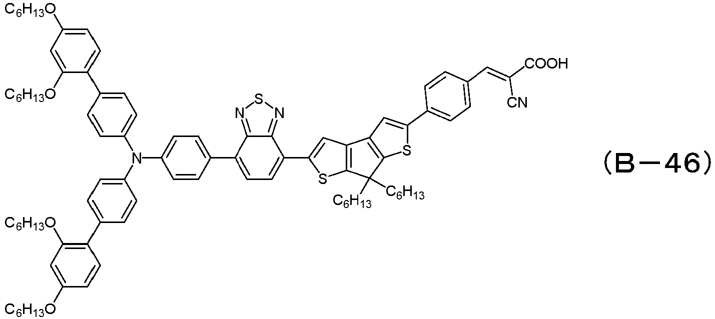

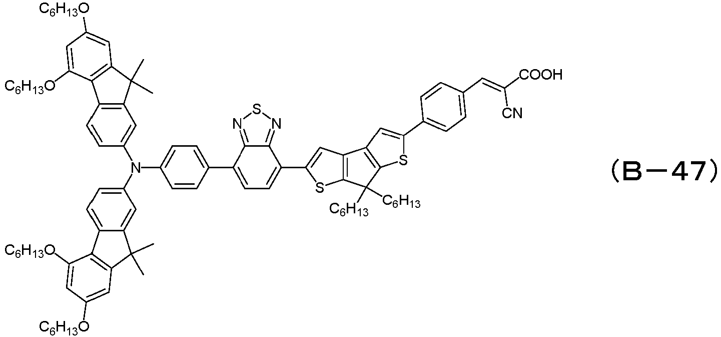

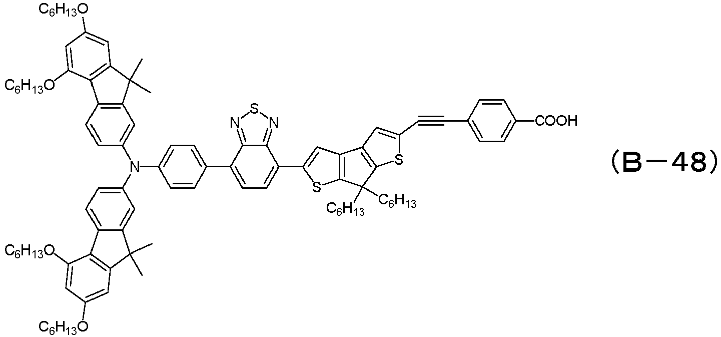

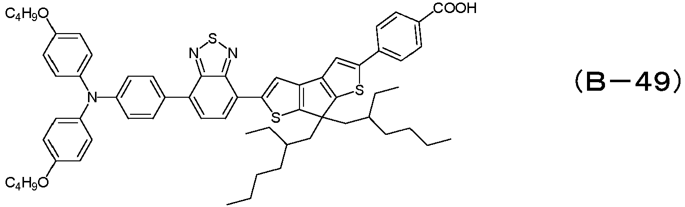

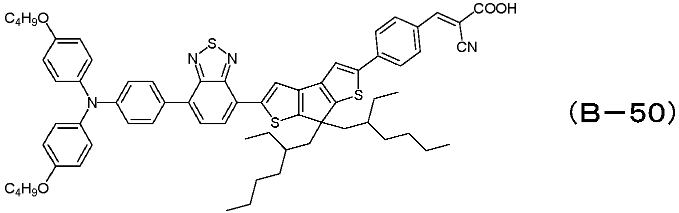

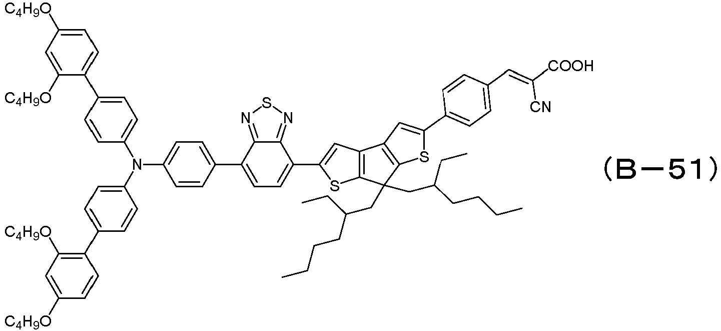

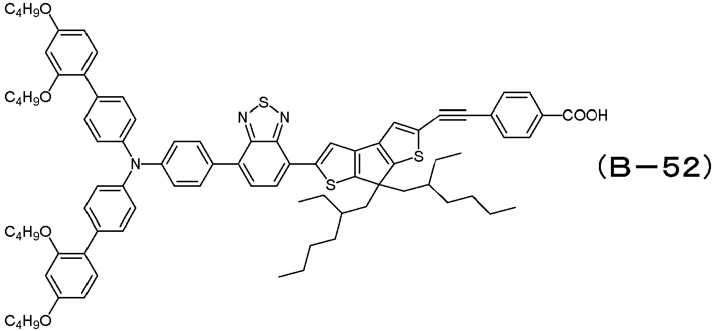

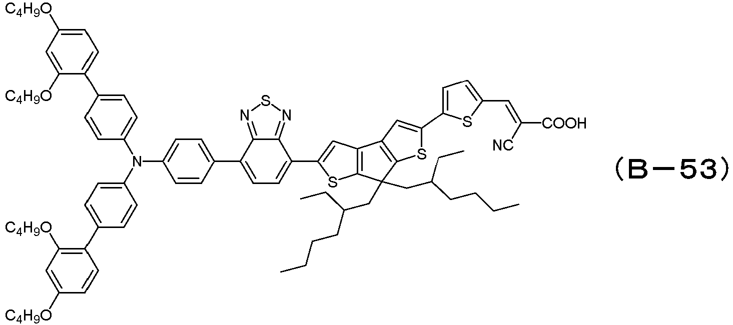

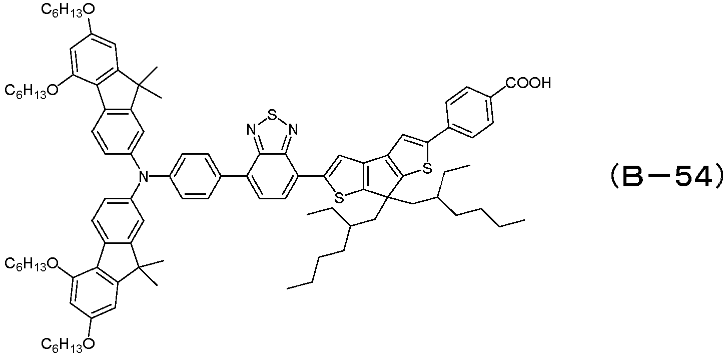

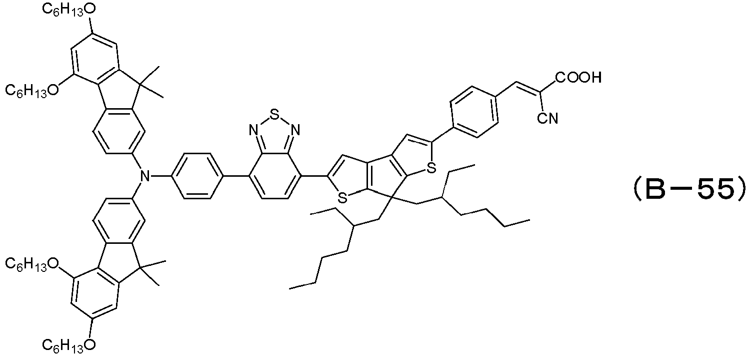

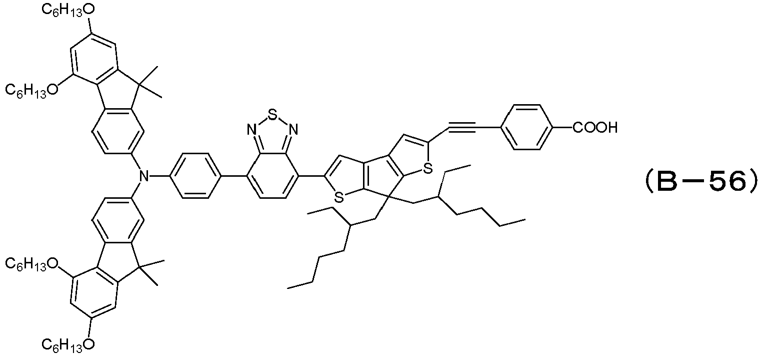

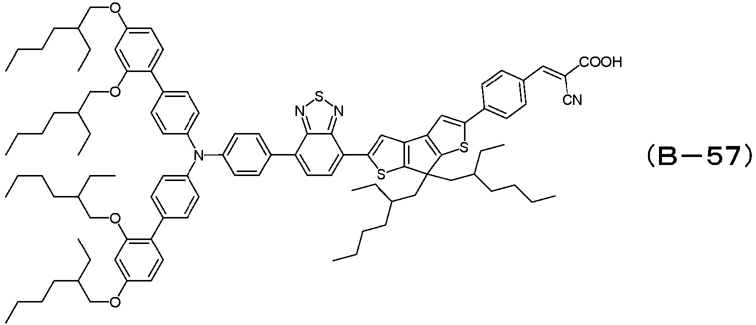

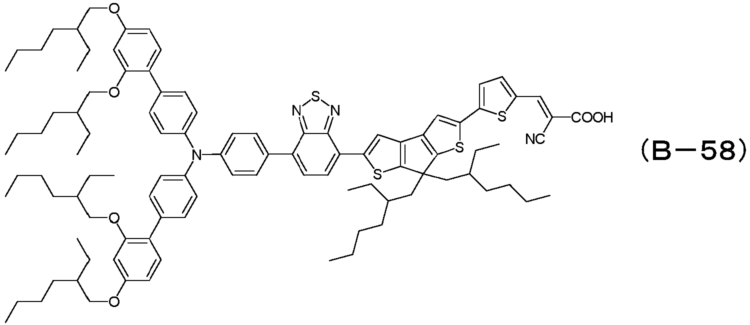

One kind of the photosensitization compound or two kinds or more of the photosensitization compounds may be included.

A LED light source used as a light source has different colors such as warm colors, cold colors, or white color. The spectra differ depending on colors.

For example, a color temperature of 3,000 K results in a relatively strong wavelength in a region of 600 nm, exhibiting a reddish light bulb color. Moreover, a color temperature of 5,000 K results in a well-balanced neutral white color as a whole. In addition, a color temperature of more than 6,500 K results in a relatively strong wavelength in a region of 450 nm, exhibiting a bluish daylight color.

Therefore, the photoelectric conversion element can preferably maintain high output even when an LED having a different color temperature is used. In this case, inclusion of mixed photosensitization compounds different in absorption wavelength in the photoelectric conversion layer is effective because the output difference caused by color temperatures can be decreased.

Examples of a method of adsorbing the photosensitization compound on the surface of the semiconductor material of the electron transport layer include: a method in which the electron transport layer including the semiconductor material is immersed in a solution of the photosensitization compound or a dispersion liquid of the photosensitization compound; and a method in which a solution of the photosensitization compound or a dispersion liquid of the photosensitization compound is coated and adsorbed on the electron transport layer.

In the case of the method in which the electron transport layer including the semiconductor material is immersed in the solution of the photosensitization compound or the dispersion liquid of the photosensitization compound, for example, any of the following methods may be used: the immersion method, the dip method, the roller method, or the air knife method.

In the case of the method in which the solution of the photosensitization compound or the dispersion liquid of the photosensitization compound is coated and adsorbed on the electron transport layer, for example, any of the following methods may be used: the wire bar method, the slide hopper method, the extrusion method, the curtain method, the spin method, or the spray method.

The photosensitization compound can be adsorbed in a supercritical fluid including carbon dioxide.

When the photosensitization compound is adsorbed on the semiconductor material, a condensation agent may be used in combination.

The condensation agent may be a substance exhibiting a catalytic action that physically or chemically binds the photosensitization compound on the surface of the semiconductor material, or may be a substance that acts stoichiometrically and advantageously transfers chemical equilibrium. As an auxiliary condensation agent, thiol or a hydroxy compound may be added.

Examples of a solvent that dissolves or disperses the photosensitization compound include water, alcohol solvents, ketone solvents, ester solvents, ether solvents, amide solvents, halogenated hydrocarbon solvents, hydrocarbon solvents, and other solvents.

Examples of the alcohol solvent include methanol, ethanol, isopropyl alcohol, and t-butanol.

Examples of the ketone solvent include acetone, methyl ethyl ketone, and methyl isobutyl ketone.

Examples of the ester solvent include ethyl formate, ethyl acetate, and n-butyl acetate.

Examples of the ether solvent include diethyl ether, dimethoxy ethane, tetrahydrofuran, dioxolane, and dioxane.

Examples of the amide solvent include N,N-dimethylformamide, N,N-dimethylacetoamide, and N-methyl-2-pyrrolidone.

Examples of the halogenated hydrocarbon solvent include dichloromethane, chloroform, bromoform, methyl iodide, dichloroethane, trichloroethane, trichloroethylene, chlorobenzene, o-dichlorobenzene, fluorobenzene, bromobenzene, iodobenzene, and 1-chloronaphthalene.

Examples of the hydrocarbon solvent include n-pentane, n-hexane, n-octane, 1,5-hexadiene, cyclohexane, methylcyclohexane, cyclohexadiene, benzene, toluene, o-xylene, m-xylene, p-xylene, ethylbenzene, and cumene.

Examples of the other solvents include acetonitrile.

These may be used alone or in combination.

The photosensitization compound may work effectively depending on its kind when aggregation between the compounds is minimized. Therefore, an aggregation dissociation agent may be used in combination.

The aggregation dissociation agent is not particularly limited and may be appropriately selected in accordance with a dye to be used. Preferable examples thereof include steroid compounds such as cholic acid and chenodeoxycholic acid, long chain alkylcarboxylic acid, and long chain alkylphosphonic acid.

An amount of the aggregation dissociation agent is preferably 0.01 parts by mass or more and 500 parts by mass or less, and more preferably 0.1 parts by mass or more and 100 parts by mass or less, relative to 1 part by mass of the photosensitization compound.

When the photosensitization compound, or the photosensitization compound and the aggregation dissociation agent are adsorbed on the surface of the semiconductor material constituting the electron transport layer, its temperature is preferably -50°C or more and 200°C or less. The adsorption time is preferably 5 seconds or more and 1,000 hours or less, more preferably 10 seconds or more and 500 hours or less, and still more preferably 1 minute or more and 150 hours or less. The adsorption step is preferably performed in a dark place. The adsorption step may be performed statically or under stirring.

The stirring method is not particularly limited and may be appropriately selected in accordance with the intended purpose. The method is, for example, a method using, for example, a stirrer, a ball mill, a paint conditioner, a sand mill, an attritor, a disperser, or ultrasonic dispersion.

The electron transport layer preferably includes a perovskite layer adjacent to the electron transport layer and a bulk heterojunction layer.

### <<Perovskite layer>>

The perovskite layer means a layer that contains a perovskite compound and absorbs light to sensitize the electron transport layer. Therefore, the perovskite layer is preferably disposed adjacent to the electron transport layer.

The shape and size of the perovskite layer are not particularly limited and may be appropriately selected in accordance with the intended purpose.

The perovskite compound is a complex substance of an organic compound and an inorganic compound, and is represented by the following Formula (X).

X_{α}Y_{β}Z_{γ}··· Formula (X)

**In** Formula (X), a ratio of α:β:γ is 3:1:1; β and y are each an integer of more than 1; X represents halogen; Y represents an organic compound including an amino group; and Z represents a metal ion.

X in Formula (X) is not particularly limited and may be appropriately selected in accordance with the intended purpose. Examples thereof include halogen such as chlorine, bromine, and iodine. These may be used alone or in combination.

Y in the above Formula (X) is not particularly limited and may be appropriately selected in accordance with the intended purpose as long as it is an organic cation. Examples thereof include: ions of alkyl amine compounds (e.g., methyl amine, ethyl amine, n-butylamine, and formamidine); and inorganic alkali metal cations (e.g., antimony ions, cesium ions, potassium ions, and rubidium ions). These may be used alone or in combination. The inorganic alkali metal cation and the organic cation may be each used in combination. Among them, an organic compound including an amino group (an ion of an alkyl amine compound) is preferable.

In the case of the perovskite compound of lead halide and methylammonium, a peak λmax of the optical absorption spectrum is about 350 nm when the halogen ion is Cl, the peak λmax is about 410 nm when the halogen ion is Br, and the peak λmax is about 540 nm when the halogen ion is I. As described above, the peak λmax is shifted to a longer wavelength side, so a usable spectrum width (band width) varies.

Z in the above Formula (X) is not particularly limited and may be appropriately selected in accordance with the intended purpose. Examples thereof include ions of metals such as lead, indium, antimony, tin, copper, and bismuth. These may be used alone or in combination.

The perovskite layer preferably has a stacked perovskite structure where a layer formed of metal halide and a layer of arranged organic cation molecules are stacked one after the other.

A film thickness of the perovskite layer is 50 nm or more and 2 µm or less, and more preferably 100 nm or more and 600 nm or less.

A method of forming the perovskite layer is not particularly limited and may be appropriately selected in accordance with the intended purpose. Examples of the method include a method in which a solution obtained by dissolving or dispersing, for example, metal halide and halogenated alkylamine or cesium halide is coated, followed by drying.

Moreover, examples of the method of forming the perovskite layer include a two-step precipitation method as described below. Specifically, for example, a solution obtained by dissolving or dispersing metal halide is coated, followed by drying. Then, the obtained product is immersed in a solution obtained by dissolving halogenated alkylamine, to form the perovskite compound.

Moreover, examples of the method of forming the perovskite layer include a method in which a poor solvent (solvent having a small solubility) for the perovskite compound is added while a solution obtained by dissolving or dispersing, for example, metal halide and halogenated alkylamine is coated thereon, to precipitate crystals.

In addition, examples of the method of forming the perovskite layer include a method in which metal halide is deposited in a gas filled with, for example, methylamine.

Among them, it is preferable to use a method in which a poor solvent for the perovskite compound is added while a solution obtained by dissolving or dispersing, for example, metal halide and halogenated alkylamine is coated thereon, to precipitate crystals.

A method of coating the solution is not particularly limited and may be appropriately selected in accordance with the intended purpose. Examples of the method include the immersion method, the spin coating method, the spray method, the dip method, the roller method, and the air knife method. As the method of coating the solution, a method of performing precipitation in a supercritical fluid using, for example, carbon dioxide may be used.

The perovskite layer may include a photosensitization dye (photosensitization compound).

A method of forming the perovskite layer including the photosensitization dye (photosensitization compound) is not particularly limited and may be appropriately selected in accordance with the intended purpose. Examples of the method include: a method in which the perovskite compound and the photosensitization dye (photosensitization compound) are mixed; and a method in which the perovskite layer is formed, followed by adsorbing the photosensitization dye (photosensitization compound).

The photosensitization dye (photosensitization compound) is not particularly limited and may be appropriately selected in accordance with the intended purpose, as long as it is a compound photoexcited by excitation light to be used.

Examples of the photosensitization dye (photosensitization compound) include metal complex compounds, coumarin compounds, polyene compounds, indoline compounds, thiophene compounds, cyanine dyes, merocyanine dyes, 9-aryl xanthene compounds, triarylmethane compounds, phthalocyanine compounds, and porphyrin compounds.

Examples of the metal complex compound include metal complex compounds described in, for example, Japanese Translation of PCT International Application Publication No. 7-500630, Japanese Unexamined Patent Application Publication No. 10-233238, Japanese Unexamined Patent Application Publication No. 2000-26487, Japanese Unexamined Patent Application Publication No. 2000-323191, and Japanese Unexamined Patent Application Publication No. 2001-59062.

Examples of the coumarin compound include coumarin compounds described in, for example, Japanese Unexamined Patent Application Publication No. 10-93118, Japanese Unexamined Patent Application Publication No. 2002-164089, Japanese Unexamined Patent Application Publication No. 2004-95450, and J. Phys. Chem. C, 7224, Vol. 111 (2007).

Examples of the polyene compound include polyene compounds described in, for example, Japanese Unexamined Patent Application Publication No. 2004-95450 and Chem. Commun., 4887 (2007).

Examples of the indoline compound include indoline compounds described in, for example, Japanese Unexamined Patent Application Publication No. 2003 -264010, Japanese Unexamined Patent Application Publication No. 2004-63274, Japanese Unexamined Patent Application Publication No. 2004-115636, Japanese Unexamined Patent Application Publication No. 2004-200068, Japanese Unexamined Patent Application Publication No. 2004-235052, J. Am. Chem. Soc., 12218, Vol. 126 (2004), Chem. Commun., 3036 (2003), and Angew. Chem. Int. Ed., 1923, Vol. 47 (2008).

Examples of the thiophene compound include thiophene compounds described in, for example, J. Am. Chem. Soc., 16701, Vol. 128 (2006) and J. Am. Chem. Soc., 14256, Vol. 128 (2006).

Examples of the cyanine dye include cyanine dyes described in, for example, Japanese Unexamined Patent Application Publication No. 11-86916, Japanese Unexamined Patent Application Publication No. 11-214730, Japanese Unexamined Patent Application Publication No. 2000-106224, Japanese Unexamined Patent Application Publication No. 2001-76773, and Japanese Unexamined Patent Application Publication No. 2003-7359.

Examples of the merocyanine dye include merocyanine dyes described in, for example, Japanese Unexamined Patent Application Publication No. 11-214731, Japanese Unexamined Patent Application Publication No. 11-238905, Japanese Unexamined Patent Application Publication No. 2001-52766, Japanese Unexamined Patent Application Publication No. 2001-76775, and Japanese Unexamined Patent Application Publication No. 2003-7360.

Examples of the 9-aryl xanthene compound include 9-aryl xanthene compounds described in, for example, Japanese Unexamined Patent Application Publication No. 10-92477, Japanese Unexamined Patent Application Publication No. 11-273754, Japanese Unexamined Patent Application Publication No. 11-273755, and Japanese Unexamined Patent Application Publication No. 2003-31273.

Examples of the triarylmethane compound include triarylmethane compounds described in, for example, Japanese Unexamined Patent Application Publication No. 10-93118 and Japanese Unexamined Patent Application Publication No. 2003-31273.

Examples of the phthalocyanine compound and the porphyrin compound include phthalocyanine compounds and porphyrin compounds described in, for example, Japanese Unexamined Patent Application Publication No. 9-199744, Japanese Unexamined Patent Application Publication No. 10-233238, Japanese Unexamined Patent Application Publication No. 11-204821, Japanese Unexamined Patent Application Publication No. 11-265738, J. Phys. Chem., 2342, Vol. 91 (1987), J. Phys. Chem. B, 6272, Vol. 97 (1993), Electroanal. Chem., 31, Vol. 537 (2002), Japanese Unexamined Patent Application Publication No. 2006-032260, J. Porphyrins Phthalocyanines, 230, Vol. 3 (1999), Angew. Chem. Int. Ed., 373, Vol. 46 (2007), and Langmuir, 5436, Vol. 24 (2008).

Among them, metal complex compounds, indoline compounds, thiophene compounds, and porphyrin compounds are preferable.

### <<Bulk heterojunction layer>>

The bulk heterojunction layer includes an electron-donating organic material and an electron-withdrawing organic material.

In the bulk heterojunction layer, the electron-donating organic material (P-type organic semiconductor) and the electron-withdrawing organic material (N-type organic semiconductor) are mixed, and thus the bulk heterojunction, which is the nano-sized PN junction, will occur. As a result, photocharge separation occurring at the junction surface can be used to obtain electric current.

### <<<Electron-donating organic material (P-type organic semiconductor)>>>

Examples of the P-type organic semiconductor include conjugated polymers and low-molecular-weight compounds such as polythiophene or derivatives thereof, arylamine derivatives, stilbene derivatives, oligothiophene or derivatives thereof, phthalocyanine derivatives, porphyrin or derivatives thereof, polyphenylene vinylene or derivatives thereof, polythienylene vinylene or derivatives thereof, benzodithiophene derivatives, and diketo - pyrrolo-pyrrole derivatives. These may be used alone or in combination.

Among them, polythiophene or derivatives thereof, which are π-conjugated conductive polymers, are preferable. The polythiophene and derivatives thereof are advantageous because they can ensure an excellent stereoregularity and have a relatively high solubility to a solvent.

The polythiophene and the derivatives thereof are not particularly limited and may be appropriately selected in accordance with the intended purpose, as long as they have a thiophene skeleton. Examples thereof include: polyalkylthiophene such as poly-3-hexylthiophene; polyalkylisothionaphthene such as poly-3-hexylisothionaphthene, poly-3-octylisothionaphthene, and poly-3-decylisothionaphthene; and polyethylenedioxythiophene.

In recent years, derivatives such as PTB7 (poly[{4,8-bis[(2-ethylhexyl)oxy]benzo[1,2-b:4,5-b']dithiophene-2,6-diyl}{3-fluoro-2-[(2-ethylhexyl)carbonyl]thieno[3,4-b]thiophenediyl}]) and PCDTBT (poly[N-9"-heptadecanyl-2,7-carbazole-alt-5,5-(4',7'-di-2-thienyl-2',1',3'-benzothiadiazole])), which are copolymers including benzodithiophene, carbazole, benzothiadiazole, and thiophene, have been exemplified as compounds that can achieve an excellent photoelectric conversion efficiency.

In addition to the conjugated polymers, even in the low-molecular-weight compounds obtained by binding an electron-donating unit with an electron-withdrawing unit, compounds that can achieve an excellent photoelectric conversion efficiency have been known and can also be used in the present disclosure (see, for example, ACSAppl. Mater. Interfaces 2014, 6, 803-810).

Among the low-molecular-weight compounds as the electron-donating organic material, a compound represented by the following Formula (A) is preferable.

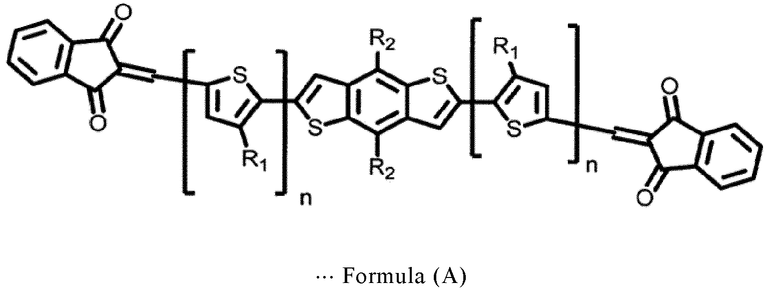

In Formula (A), n represents an integer of from 1 through 3.

R₁ represents an n-butyl group, an n-hexyl group, an n-octyl group, an n-decyl group, or an n-dodecyl group.

R₂ represents an oxygen atom that has an alkyl group having from 6 through 22 carbon atoms, a sulfur atom that has an alkyl group having from 6 through 22 carbon atoms, a carbon atom that has an alkyl group having from 6 through 22 carbon atoms, or a group represented by the following Formula (B). Among them, an oxygen atom that has an alkyl group having from 6 through 20 carbon atoms, a sulfur atom that has an alkyl group having from 6 through 20 carbon atoms, a carbon atom that has an alkyl group having from 6 through 20 carbon atoms, and a group represented by the following Formula (B) are preferable.

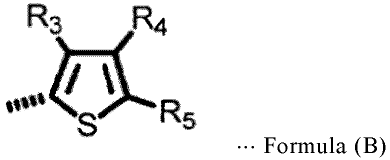

In Formula (B), R₃ and R₄ represent a hydrogen atom or an alkyl group having from 6 through 12 carbon atoms.

R₅ represents an alkyl group that may include a branched chain having from 6 through 22 carbon atoms. Among them, an alkyl group that may include a branched chain having from 6 through 12 carbon atoms is preferable.

As the electron-donating organic material, specific examples of the low-molecular-weight compound are preferably compounds represented by the following Formula (C).

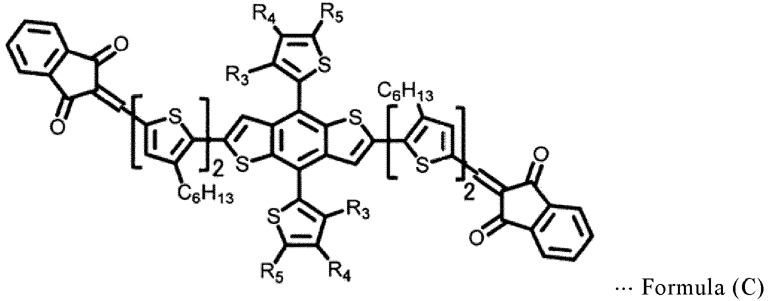

In Formula (C), R₃ and R₄ represent a hydrogen atom or an alkyl group having from 6 through 12 carbon atoms, and preferably represent a hydrogen atom or an alkyl group having from 6 through 10 carbon atoms.

R₅ represents an alkyl group that may include a branched chain having from 6 through 22 carbon atoms, and preferably represents an alkyl group that may include a branched chain having from 6 through 12 carbon atoms.

Specific examples of the compound represented by Formula (C) will be described below. However, the present disclosure is not limited thereto.

**Table 1**

| Exemplified compounds | R₃ | R₄ | R₅ |
|---|---|---|---|
| 1 | H | H | 2-ethylhexyl |
| 2 | H | n-hexyl | n-hexyl |
| 3 | H | H | n-hexyl |
| 4 | n-hexyl | H | n-hexyl |
| 5 | H | H | 2-butyloctyl |
| 6 | H | n-octyl | n-octyl |
| 7 | H | H | n-octyl |
| 8 | n-octyl | H | n-octyl |
| 9 | H | H | 2-decyldodecyl |
| 10 | H | n-dodecyl | n-dodecyl |
| 11 | H | H | n-dodecyl |
| 12 | n-dodecyl | H | n-dodecyl |

### <<<Electron-withdrawing organic material (N-type organic semiconductor)>>>

Examples of the electron-withdrawing organic material include imide derivatives, fullerene, and fullerene derivatives. Among them, fullerene derivatives are preferable in terms of charge separation and charge transport.

As the fullerene derivative, an appropriately synthesized product may be used or a commercially available product may be used. Examples thereof include PC71BM (phenyl C71 butyric acid methyl ester, manufactured by Frontier Carbon Corporation), PC61BM (phenyl C61 butyric acid methyl ester, manufactured by Frontier Carbon Corporation), PC85BM (phenyl C85 butyric acid methyl ester, manufactured by Frontier Carbon Corporation), and ICBA (fullerene indene 2 adduct, manufactured by Frontier Carbon Corporation). In addition to the above, fulleropyrrolidine-based fullerene derivatives represented by the following Formula (D) may be used.

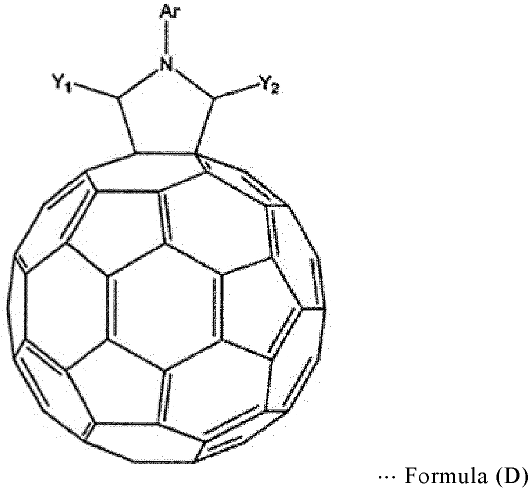

**In** Formula (D), Y₁ and Y₂, which may be identical to or different from each other, represent a hydrogen atom, an alkyl group that may have a substituent, an alkenyl group that may have a substituent, an alkynyl group that may have a substituent, an aryl group that may have a substituent, or an aralkyl group that may have a substituent.

Note that, Y₁ and Y₂ are not a hydrogen atom at the same time.

The Ar represents an aryl group that may have a substituent.

Specific examples of the aryl group include a phenyl group, a naphthyl group, an anthryl group, and a phenanthryl group. Among them, a phenyl group is preferable.

As the substituent in the aryl group that has a substituent and is represented by the Ar, the substituent preferably excludes an oxygen atom. Examples of the substituent include an aryl group, an alkyl group, a cyano group, an alkoxy group, and an alkoxycarbonyl group.

Among these substituents, examples of the aryl group include a phenyl group.

The alkyl group and the alkyl group portion of the alkoxy group are, for example, an alkyl group having from 1 through 22 carbon atoms similarly with alkyl groups represented by Y₁ and Y₂ that will be described below.

The number and substitution site of these substituents are not particularly limited. For example, one to three substituent(s) can exist at any position of the aryl group represented by Ar.

Among the groups represented by the Y₁ and the Y₂, the alkyl group is preferably an alkyl group having from 1 through 22 carbon atoms, more preferably an alkyl group having from 1 through 12 carbon atoms, and particularly preferably an alkyl group having from 6 through 12 carbon atoms. These alkyl groups may be a straight-chain alkyl group or may be a branched alkyl group, but are particularly preferably a straight-chain alkyl group.

The alkyl group may further include one or two or more hetero elements such as S and O in the carbon chain thereof.

Among the groups represented by the Y₁ and the Y₂, the alkenyl group is preferably an alkenyl group having from 2 through 10 carbon atoms. Particularly preferable specific examples thereof include straight-chain or branched alkenyl groups having from 2 through 4 carbon atoms such as a vinyl group, a 1-propenyl group, an allyl group, an isopropenyl group, a 1-butenyl group, a 2-butenyl group, a 3-butenyl group, a 1-methyl-2-propenyl group, and a 1,3-butadienyl group.

Among the groups represented by the Y₁ and the Y₂, the alkynyl group is preferably an alkynyl group having from 1 through 10 carbon atoms. Particularly preferable specific examples thereof include straight-chain or branched alkynyl groups having from 2 through 4 carbon atoms such as an ethynyl group, a 1-propynyl group, a 2-propynyl group, a 1-methyl-2-propynyl group, a 1-butynyl group, a 2-butynyl group, and a 3-butynyl group.

Among the groups represented by the Y₁ and the Y₂, examples of the aryl group include a phenyl group, a naphthyl group, an anthryl group, and a phenanthryl group.

Among the groups represented by the Y₁ and the Y₂, examples of the aralkyl group include aralkyl groups having from 7 through 20 carbon atoms such as 2-phenylethyl, benzyl, 1-phenylethyl, 3-phenylpropyl, and 4-phenylbutyl.

As described above, the alkyl group, the alkenyl group, the alkynyl group, the aryl group, and the aralkyl group of the groups represented by the Y₁ and the Y₂ include a case of including a substituent or a case of including no substituent.

Examples of the substituents that can be included in the groups represented by the Y₁ and the Y₂ include an alkyl group, an alkoxycarbonyl group, a polyether group, an alkanoyl group, an amino group, an aminocarbonyl group, an alkoxy group, an alkylthio group, a group: -CONHCOR' (wherein R' is an alkyl group), a group: -C(=NR')-R" (wherein R' and R" are an alkyl group), and a group: -NR'=CR"R‴ (wherein R', R", and R‴ are an alkyl group).

Among these substituents, examples of the polyether group include a group represented by the formula: Y₃-(OY₄)n-O-. Here, Y₃ represents a monovalent hydrocarbon group such as an alkyl group, and Y₄ represents a bivalent aliphatic hydrocarbon group.

In the polyether group represented by the above formula, specific examples of a recurring unit represented by -(OY₄)ₙ- include alkoxy chains such as -(OCH₂)ₙ-, -(OC₂H₄)ₙ-, and -(OC₃H₆)ₙ-. The recurring number n of these recurring units is preferably from 1 through 20, more preferably from 1 through 5. The recurring unit represented by -(OY₄)ₙ-may include not only the same recurring unit but also two or more kinds of different recurring units. Among the aforementioned recurring units, -OC₂H₄- and -OC₃H₆- may have a straight chain or a branched chain.

Among the substituents, the alkyl group, and the alkyl group portion (R', R") in the alkoxycarbonyl group, the alkanoyl group, the alkoxy group, the alkylthio group, the polyether group, the group: -CONHCOR', the group: -C(=NR')-R", and the group: - NR'=CR"R‴ are preferably an alkyl group having from 1 through 22 carbon atoms, more preferably an alkyl group having from 1 through 12 carbon atoms, and particularly preferably an alkyl group having from 6 through 12 carbon atoms, similarly with the aforementioned alkyl group.

The amino group, and the amino group portion in the aminocarbonyl group are particularly preferably an amino group to which one or more alkyl groups having from 1 through 20 carbon atoms are bound.

Among the fullerene derivatives represented by the Formula (D), examples of the compound having preferable performances include compounds represented by the Formula (D), where, in the Formula (D), Ar represents a phenyl group that has a substituent or a phenyl group that has no substituent; and one of Y₁ and Y₂ is a hydrogen atom, and the other is an alkyl group including an alkoxycarbonyl group as a substituent, an alkyl group including an alkoxy group as a substituent, an alkyl group including a polyether group as a substituent, an alkyl group including an amino group as a substituent, or a phenyl group that includes a substituent or includes no substituent.

Among such compounds, examples of the compound having particularly preferable performances include compounds represented by Formula (D), where Ar includes, as a substituent, a phenyl group, a cyano group, an alkoxy group, an alkoxycarbonyl group, or an alkyl group, or is a phenyl group without a substituent; and one of Y₁ and Y₂ is a hydrogen atom, and the other is an alkyl group including an alkoxycarbonyl group as a substituent, an alkyl group including an alkoxy group as a substituent, an alkyl group including a polyether group as a substituent, a phenyl group, a phenyl group including an alkyl group as a substituent, a phenyl group including an alkoxycarbonyl group as a substituent, or a phenyl group including an alkoxycarbonyl group as a substituent.

These compounds include a group having an appropriate polarity on the pyrrolidine skeleton and are excellent in a self-assembling property. Therefore, when a photoelectric conversion layer having a bulk heterojunction structure is formed, it is possible to form a photoelectric conversion part that has a bulk heterojunction structure having an appropriate layer separation structure. As a result, it is believed that, for example, the electron mobility is improved to exhibit a high conversion efficiency.

Examples of the most preferable compound include compounds represented by Formula (D), where Ar is a phenyl group; one of Y₁ and Y₂ represents a hydrogen atom, and the other represents a non-substituted alkyl group (alkyl group having from 4 through 6 carbon atoms), a non-substituted phenyl group, a 1-naphthyl group, or a 2-naphthyl group.

The method of forming the bulk heterojunction layer is not particularly limited and may be appropriately selected in accordance with the intended purpose. Examples of the method include spin coating, blade coating, slit die coating, screen-print coating, bar coater coating, mold coating, transfer printing method, dip drawing method, the inkjet method, the spray method, and vacuum deposition method. The method can be appropriately selected from the above depending on the characteristics (e.g., thickness control and orientation control) of the thin film of the organic material to be produced.

For example, when the spin coating is performed, the P-type organic semiconductor and the N-type organic semiconductor preferably have a concentration of 5 mg/mL or more and 40 mg/mL or less. This concentration makes it possible to easily produce a uniform thin film of an organic material.

**In** order to remove an organic solvent from the produced thin film of the organic material, an annealing treatment may be performed under reduced pressure or under an inert atmosphere (under nitrogen or argon atmosphere). The temperature of the annealing treatment is preferably 40°C or more and 300°C or less, and more preferably 50°C or more and 200°C or less. The annealing treatment can increase an effective area where stacked layers permeate at the boundary to contact each other. Therefore, the short circuit current can be increased. Note that, the annealing treatment may be performed after formation of electrodes.

The organic solvent is not particularly limited and may be appropriately selected in accordance with the intended purpose. Examples of the solvent include methanol, ethanol, butanol, toluene, xylene, o-chlorophenol, acetone, ethyl acetate, ethylene glycol, tetrahydrofuran, dichloromethane, chloroform, dichloroethane, chlorobenzene, dichlorobenzene, trichlorobenzene, chloronaphthalene, dimethylformamide, dimethyl sulfoxide, N-methylpyrrolidone, and γ-butyrolactone. These may be used alone or in combination. Among them, chlorobenzene, chloroform, and o -dichlorobenzene are preferable.

**In** order to control the phase separation structure of the P-type organic semiconductor and the N-type organic semiconductor, an additive may be added to the organic solvent in an amount of 0.1% by mass or more and 10% by mass or less. Examples of the additive include diiodoalkanes (e.g., 1,8-diiodooctane, 1,6-diiodohexane, and 1,10-diiododecane), alkane dithiols (e.g., 1,8-octanedithiol, 1,6-hexanedithiol, and 1,10-decanedithiol), **1-**chloronaphthalene, and polydimethylsiloxane derivatives.

The average thickness of the photoelectric conversion layer is preferably 50 nm or more and 400 nm or less, and more preferably 60 nm or more and 250 nm or less. When the average thickness is 50 nm or more, insufficient generation of carriers, which is caused by decreasing light absorption in the photoelectric conversion layer, does not occur. When the average thickness is 400 nm or less, the transport efficiency of carriers generated by light absorption is not further decreased.

### <<Hole transport layer>>

The photoelectric conversion element preferably includes a hole transport layer.

The hole transport layer is a layer that transports holes and includes a basic compound. The hole transport layer preferably includes a hole transport material and an alkali metal salt, and may further include other materials if necessary.

### <<<Basic compound>>>

The basic compound preferably has an acid dissociation constant (pKa) of 6 or more and 10 or less. Examples thereof include pyridine compounds and imidazole compounds. Among them, pyridine compounds are preferable.

The pyridine compound is a compound represented by at least one selected from the following Formula (1) and the following Formula (2).

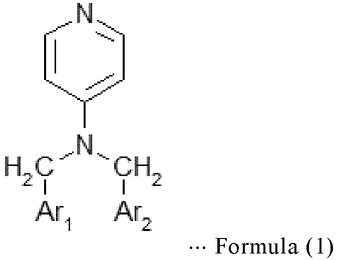

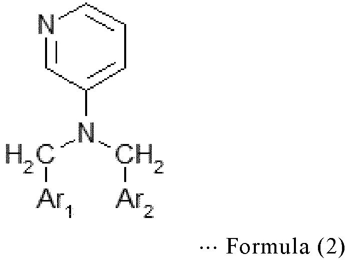

In Formula (1) and Formula (2), Ar₁ and Ar₂ represent an aryl group that may have a substituent, and the Ar₁ and the Ar₂, which may be identical to or different from each other, may be bound to each other.

Specific examples of the aryl group include phenyl groups, naphthyl groups, and biphenyl groups. Examples of the substituent include alkyl groups and alkoxy groups.

Hereinafter, specific exemplified compounds of the pyridine compound represented by the above Formula (1) are presented, but the pyridine compound of the present disclosure is not limited thereto.

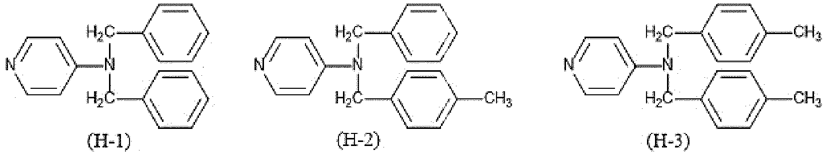

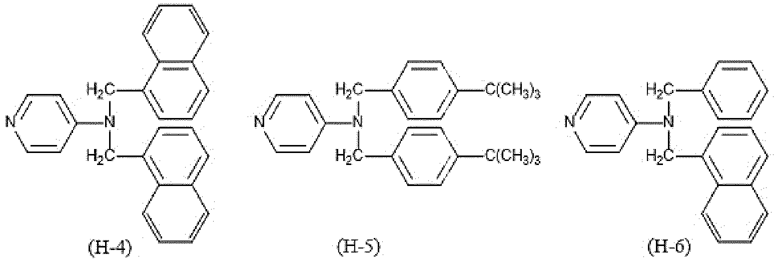

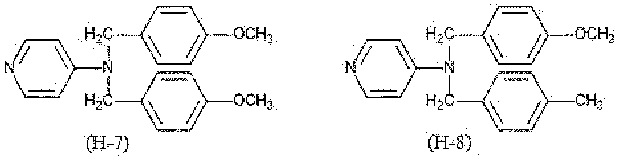

The amount of the above pyridine compound in the hole transport layer is preferably 20 mol% or more and 65 mol% or less, and more preferably 35 mol% or more and 50 mol% or less, relative to the hole transport material. When the amount of the pyridine compound satisfies the preferable range, high open circuit voltage can be maintained, high output can be obtained, and high stability and durability can be obtained even after long-term use under various conditions (particularly, low temperature environment).

### <<<Hole transport material>>>

**In** order to obtain the function of transporting holes, the hole transport layer preferably includes a hole transport material or a p-type semiconductor material as a hole transport material.

As the hole transport material or the p-type semiconductor material, a conventional organic hole transport compound can be used.

Specific examples of the organic hole transport compound include oxadiazole compounds, triphenylmethane compounds, pyrazoline compounds, hydrazone compounds, oxadiazole compounds, tetraarylbenzidine compounds, stilbene compounds, and spiro -type compounds.

Among them, spiro-type compounds are more preferable.

The spiro-type compound is preferably a compound including the following Formula (10).

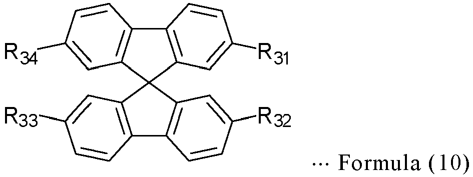

In Formula (10), R₃₁ to R₃₄ each independently represent a substituted amino group such as a dimethylamino group, a diphenylamino group, or a naphthyl 4 -tolylamino group.

Specific examples of the spiro-type compound include the following (D-1) to (D-22), but are not limited thereto.

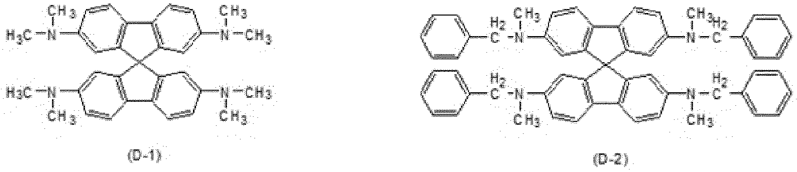

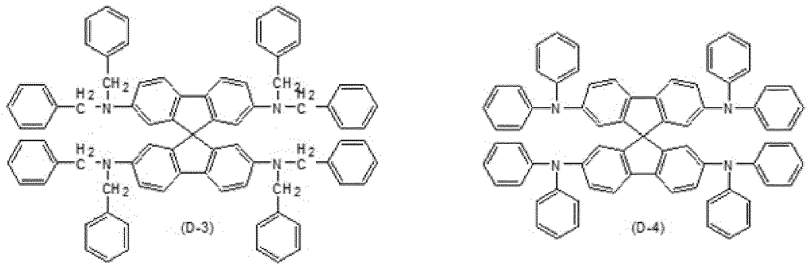

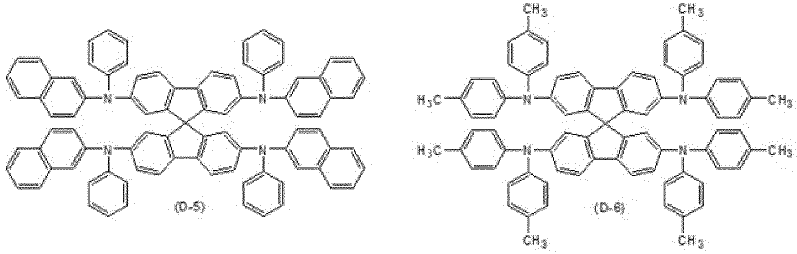

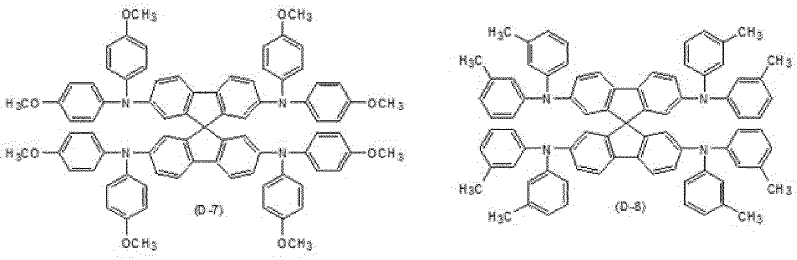

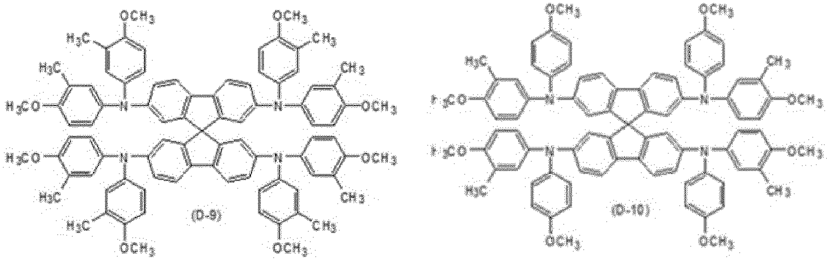

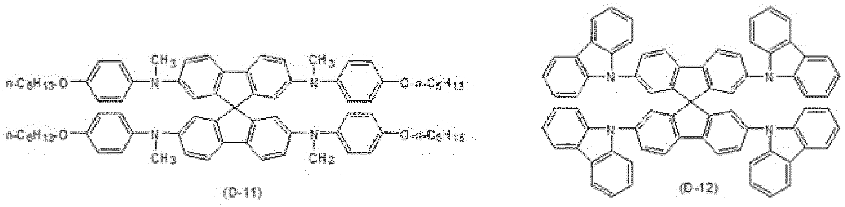

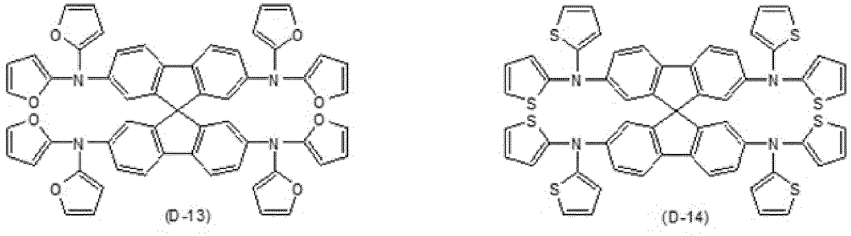

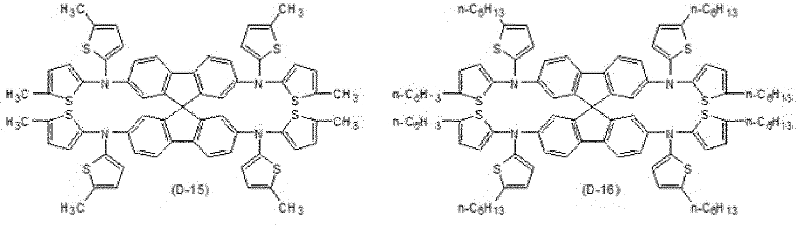

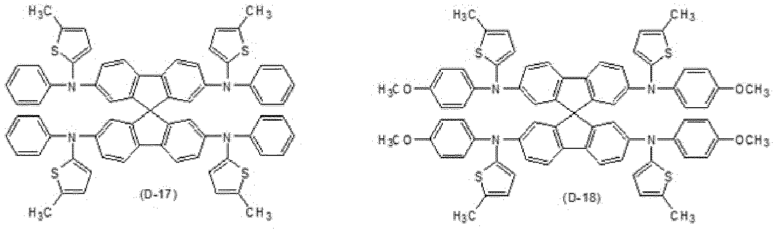

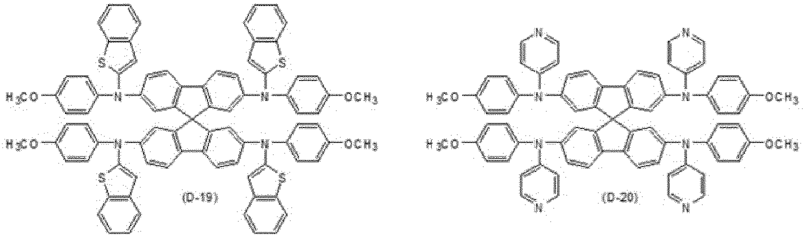

A compound represented by the following Formula (4) can be particularly suitably used as the spiro-type compound that is the hole transport material.

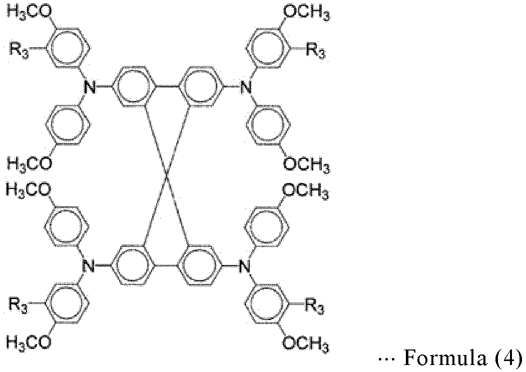

In Formula (4), R₃ represents a hydrogen atom or an alkyl group.

For example, among the above (D-1) to (D-22), those represented by the above Formula (4) are (D-7) and (D-10).

These spiro-type compounds have a high hole mobility. In addition, the spiro-type compounds exhibit excellent photoelectric conversion characteristic because two benzidine skeleton molecules are bound with being twisted to thereby form almost spherical electron cloud, and intermolecular hopping conductivity is good. Moreover, the spiro-type compounds are dissolved in various organic solvents because of high solubility, and are densely filled in the porous electron transport layer because of its amorphous property (amorphous substance having no crystal structure). The spiro-type compounds allow the photosensitization compound to efficiently absorb light because they have no light absorption characteristics of 450 nm or more. Therefore, such spiro-type compounds are particularly preferable for solid-type dye sensitized solar cells.

### <<<Alkali metal salt>>>

Examples of the alkali metal salt include lithium salts, sodium salts, and potassium salts.

Examples of the lithium salt include lithium chloride, lithium bromide, lithium iodide, lithium perchlorate, lithium bis(trifluoromethanesulfonyl)diimide, lithium diisopropylimide, lithium acetate, lithium tetrafluoroborate, lithium pentafluorophosphate, and lithium tetracyanoborate.

Examples of the sodium salt include sodium chloride, sodium bromide, sodium iodide, sodium perchlorate, sodium bis(trifluoromethanesulfonyl)diimide, sodium acetate, sodium tetrafluoroborate, sodium pentafluorophosphate, and sodium tetracyanoborate.

Examples of the potassium salt include potassium chloride, potassium bromide, potassium iodide, and potassium perchlorate.

Among them, lithium salt is preferable, and lithium bis(trifluoromethanesulfonyl)diimide and lithium diisopropylimide are more preferable because electric conductivity can be improved and the durability and the stability of output characteristics can be improved.

The lithium salt is preferably a compound represented by the following Formula (3).

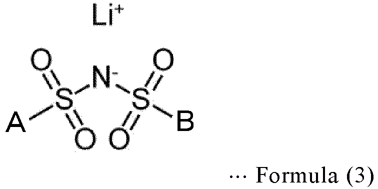

In Formula (3), A and B represent any one of substituents F, CF₃, C₂F₅, C₃F₇, and C₄F₉. The substituent A and the substituent B are preferably different from each other.

Examples of the lithium salt include lithium (fluorosulfonyl)(trifluoromethanesulfonyl)imide (Li-FTFSI), lithium (fluorosulfonyl)(pentafluoroethanesulfonyl)imide (Li-FPFSI), lithium (fluorosulfonyl)(nonafluorobutanesulfonyl)imide (Li-FNFSI), lithium (nonafluorobutanesulfonyl)(trifluoromethanesulfonyl)imide (Li-NFTFSI), and lithium (pentafluoroethanesulfonyl)(trifluoromethanesulfonyl)imide (Li-PFTFSI). Among them, lithium (fluorosulfonyl)(trifluoromethylsulfonyl)imide (Li-FTFSI) is particularly preferable.

The Structural Formulas of the specific examples of the lithium salts are, for example, as follows.

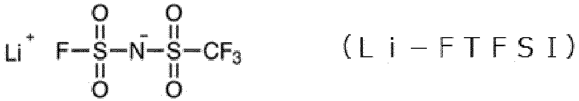

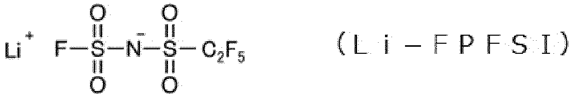

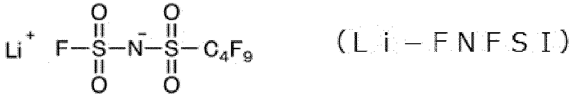

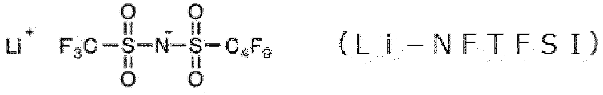

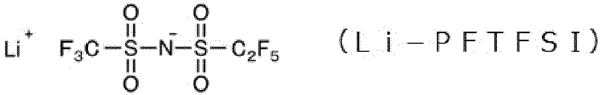

Here, when a coating liquid for forming the hole transport layer that includes the lithium salt is coated, the above lithium salt does not need to be contained in the formed film in a salt state where a cation and an anion are bound to each other, and may be included in the state where a cation and an anion are separated. Specifically, the present inventors found that when the hole transport layer is formed with the lithium salt being included in the coating liquid for the hole transport layer, lithium cations migrate to the electron transport layer, and therefore the electron transport layer includes more lithium cations than the hole transport layer. On the other hand, the present inventors found that anions partially migrate to the electron transport layer, but the hole transport layer includes more anions than the electron transport layer.

Preferably, in the present disclosure, cations and anions of the lithium salt are separated, and each have a different distribution state. When they are included in the photoelectric conversion layer, high output can be obtained with light having a low illuminance under low temperature environments and the effect such as excellent persistence of the output can be further improved.

The hole transport layer in the photoelectric conversion layer may include a lithium salt having another structure in addition to a lithium salt represented by the above Formula (3). Examples of the lithium salts include, in addition to the aforementioned lithium salts, lithium salts having symmetric anion species. Specific examples thereof include: lithium bis(fluorosulfonyl)imide (Li-FSI), lithium bis(trifluoromethanesulfonyl)imide (Li-TFSI), lithium bis(pentafluoroethanesulfonyl)imide (Li-BETI), and lithium bis(nonafluorobutanesulfonyl)imide; and cyclic imides such as lithium (cyclohexafluoropropane)(disulfone)imide.

These lithium salts, however, have a low solubility because anions are symmetric. Therefore, its addition amount is not easily increased, and is preferably a small amount even when the lithium salt is added.

An amount of the lithium salt represented by the above Formula (3) is preferably 5 mol% or more and 50 mol% or less, and more preferably 20 mol% or more and 35 mol% or less, relative to the hole transport material. When the amount falls within the aforementioned range, a high output with respect to light having a low illuminance can be achieved, the maintenance rate of the output can be improved, and high durability can be achieved.

Particularly, a molar ratio (a/b) of the pyridine compound to the lithium salt in the photoelectric conversion layer is preferably less than 2.0, more preferably 1.8 or less, and still more preferably 1.7 or less, where the a is a molar amount of the pyridine compound in the photoelectric conversion layer and the b is an amount of the lithium salt in the photoelectric conversion layer.

The molar ratio (a/b) of less than 2.0 is advantageous because high output can be maintained for longer period of time when light having a low illuminance is emitted under low temperature environments and the durability of the photoelectric conversion element can be further improved.

**In** addition to the hole transport material or the lithium salt, an oxidizing agent is preferably added to the hole transport layer. Addition of the oxidizing agent improves the hole transport property and can enhance output characteristics or its durability or the stability.

### <<<Oxidizing agent>>>

Examples of the oxidizing agent include tris(4-bromophenyl) aminium hexachloroantimonate, silver hexafluoroantimonate, nitrosonium tetrafluoroborate, nitric acid silver, metal complexes, and hypervalent iodine compounds.

Among them, metal complexes and hypervalent iodine compounds are suitably used.

When the oxidizing agent is a metal complex or a hypervalent iodine compound, a large amount of the oxidizing agent can be added because of its high solubility in an organic solvent. As a result, the hole transport property is improved and the persistence of the effect is excellent.

The metal complex includes a metal cation, a ligand, and an anion.

Examples of the metal cation include cations such as chromium, manganese, iron, cobalt, nickel, copper, molybdenum, ruthenium, rhodium, palladium, silver, tungsten, rhenium, osmium, iridium, gold, and platinum. Among them, a cation such as cobalt, iron, nickel, or copper is preferable, and a cobalt complex is more preferable.

The ligand preferably includes a 5-membered and/or 6-membered heterocycle including at least one nitrogen, which may have a substituent. Specific examples thereof include the following but are not limited thereto.

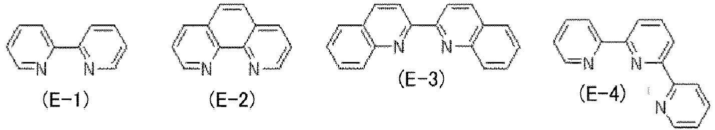

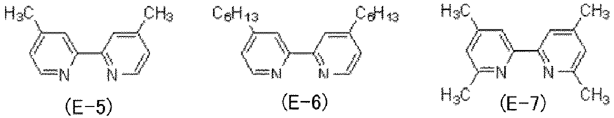

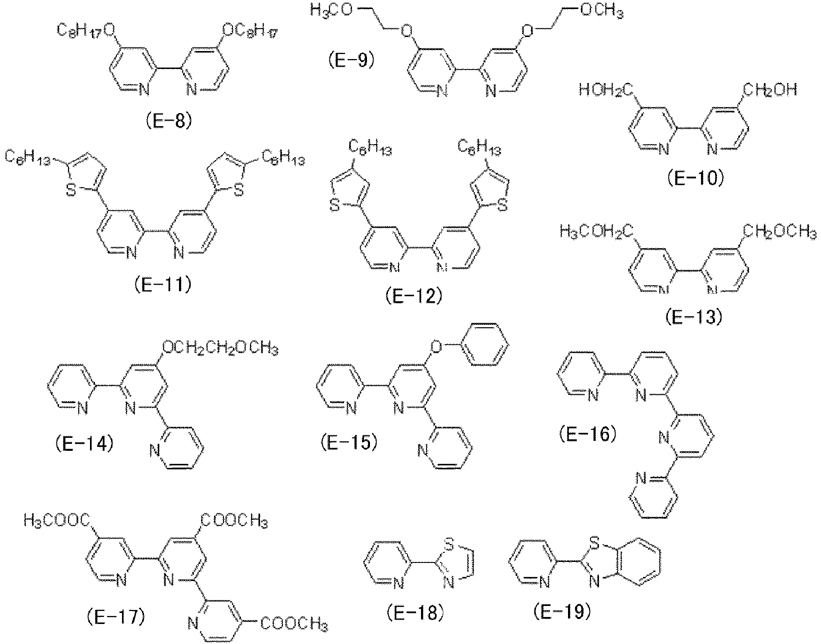

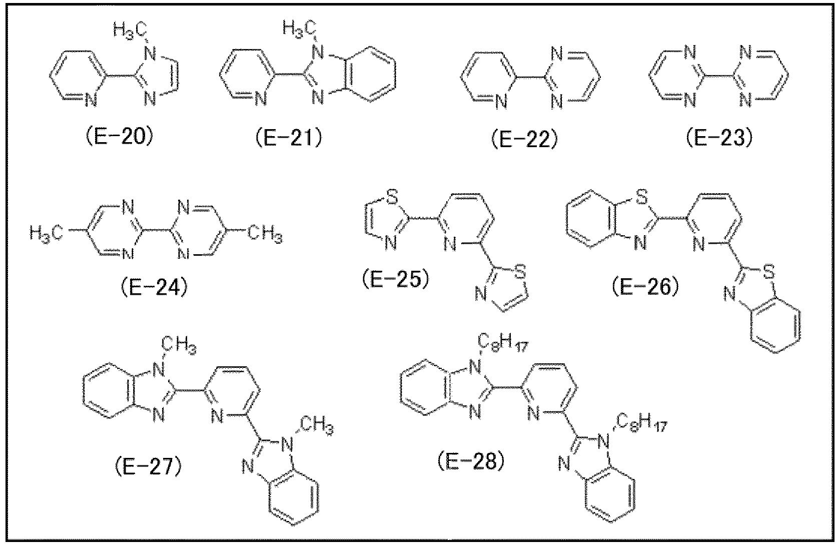

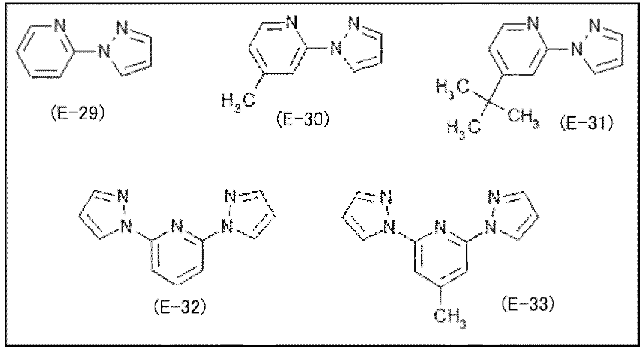

Examples of the suitable anion include hydride ions (H⁻), fluoride ions (F⁻), chloride ions (Cl⁻), bromide ions (Br⁻), iodide ions (I⁻), hydroxide ions (OH⁻), cyanide ions (CN⁻), nitric acid ions (NO₃⁻), nitrous acid ions (NO₂⁻), hypochlorous acid ions (ClO⁻), chlorous acid ions (ClO₂⁻), chloric acid ions (ClO₃⁻), perchloric acid ions (ClO₄⁻), permanganic acid ions (MnO₄⁻), acetic acid ions (CH₃COO⁻), hydrogen carbonate ions (HCO₃⁻), dihydrogen phosphate ions (H₂PO₄⁻), hydrogen sulfate ions (HSO₄⁻), hydrogen sulfide ions (HS⁻), thiocyanic acid ions (SCN⁻), tetrafluoroboric acid ions (BF₄⁻), hexafluorophosphate ions (PF₆⁻), tetracyanoborate ions (B(CN)₄⁻), dicyanoamine ions (N(CN)₂⁻), p-toluenesulfonic acid ions (TsO⁻), trifluoromethyl sulfonate ions (CF₃SO₂⁻), bis(trifluoromethylsulfonyl)amine ions (N(SO₂CF₃)²⁻), tetrahydroxoaluminate ions ([Al(OH)₄]⁻ or [Al(OH)₄(H₂O)₂]⁻), dicyanoargentate(I) ions ([Ag(CN)₂]⁻), tetrahydroxochromate(III) ions ([Cr(OH)₄]⁻), tetrachloroaurate(III) ions ([AuCl₄]⁻), oxide ions (O²⁻), sulfide ions (S²⁻), peroxide ions (O₂²⁻), sulfuric acid ions (SO₄²⁻), sulfurous acid ions (SO₃²⁻), thiosulfuric acid (S₂O₃²⁻), carbonic acid ions (CO₃²⁻), chromic acid ions (CrO₄²⁻), dichromic acid ions (Cr₂O₇²⁻), monohydrogen phosphate ions (HPO₄²⁻), tetrahydroxozincate(II) ions ([Zn(OH)₄]²⁻), tetracyanozincate(II) ions ([Zn(CN)₄]²⁻), tetrachlorocuprate(II) ions ([CuCl₄]²⁻), phosphoric acid ions (PO₄³⁻), hexacyanoferrate(III) ions ([Fe(CN)₆]³⁻), bis(thiosulfate)argentate(I) ions ([Ag(S₂O₃)₂]³⁻), and hexacyanoferrate(II) ions ([Fe(CN)₆]⁴⁻).

These may be used alone or in combination.

Among them, tetrafluoroboric acid ions, hexafluorophosphate ions, tetracyanoborate ions, bis(trifluoromethylsulfonyl)amine ions, and perchloric acid ions are preferable.

Among these metal complexes, a trivalent cobalt complex is particularly preferably added. When the trivalent cobalt complex as the oxidizing agent is added, the hole transport material can be oxidized and stabilized, resulting in improvement of the hole transport property.

In the present disclosure, a trivalent cobalt complex is preferably used for, for example, the cobalt complex to be added to a coating liquid for forming the hole transport layer. However, the hole transport layer of the photoelectric conversion element obtained by using the coating liquid for forming the hole transport layer preferably includes a bivalent cobalt complex. The reason for this is because when the trivalent cobalt complex is mixed with the hole transport material, the hole transport material is oxidized, and therefore the trivalent cobalt complex turns into a bivalent cobalt complex. **In** other words, in the present disclosure, preferably, the photoelectric conversion layer further includes a bivalent cobalt complex.

Particularly preferably, in the hole transport layer of the photoelectric conversion element, almost no trivalent cobalt complexes remain and almost all cobalt complexes are bivalent. This improves and stabilizes the hole transport property, improves high output and its persistence, and further achieves the effect even under low temperature environment.

The valence of the cobalt complex included in the hole transport layer can be determined through, for example, XAFS analysis. The XAFS analysis is an abbreviation of X-ray Absorption Fine Structure and is referred to as X-ray absorption fine structure analysis. For example, the XAFS spectrum can be obtained when a sample is irradiated with X-rays and its absorption dose is measured.

**In** the XAFS spectrum, an absorption near edge structure is referred to as XANES (X-ray Absorption Near Edge Structure), and an extended X-ray absorption fine structure is referred to as EXAFS (Extended X-ray Absorption Fine Structure) that appears on the energy side about 100 eV higher than the absorption edge. Information about the valence and the structure of a targeted atom can be mainly obtained using the XANES of the former. **In** this case, for example, the XAFS spectra of bivalent cobalt complex powder and trivalent cobalt complex powder are separately measured, and are compared with the XAFS spectrum of the cobalt complex included in the hole transport layer. Then, the valence of the cobalt complex included in the hole transport layer can be determined.

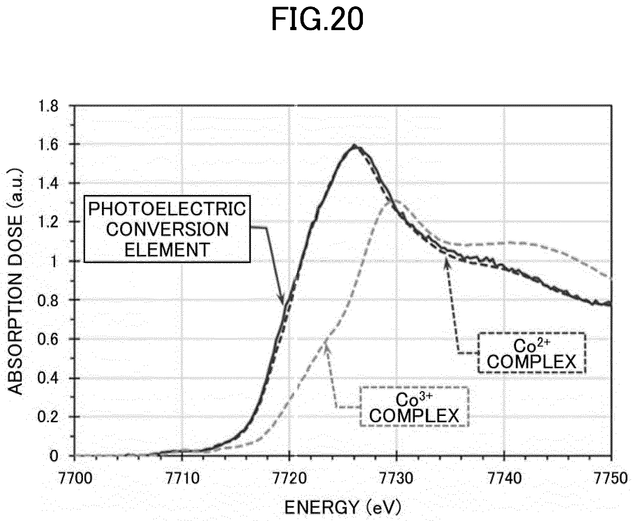

Fig. 20 shows the result of XAFS spectrum of the photoelectric conversion module (the photoelectric conversion module of Example 1) using one example of the photoelectric conversion element of the present disclosure obtained in the above manner. As presented in Fig. 20, the cobalt complex included in the hole transport layer of the photoelectric conversion module using one example of the photoelectric conversion element of the present disclosure considerably corresponds to the bivalent cobalt complex powder, and does not correspond to the trivalent cobalt complex powder. Therefore, almost all the cobalt complexes can be thought to be bivalent.

As the trivalent cobalt complex added to the coating liquid for forming the hole transport layer, cobalt complexes expressed by the following Structural Formulas (4) and (5) can be preferably used.

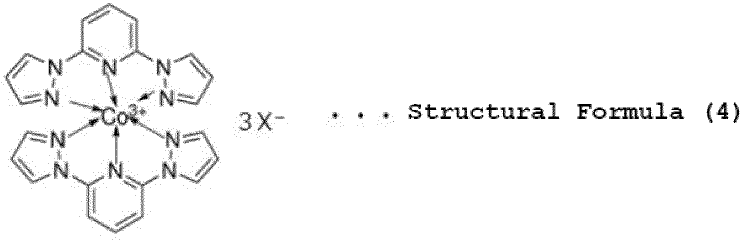

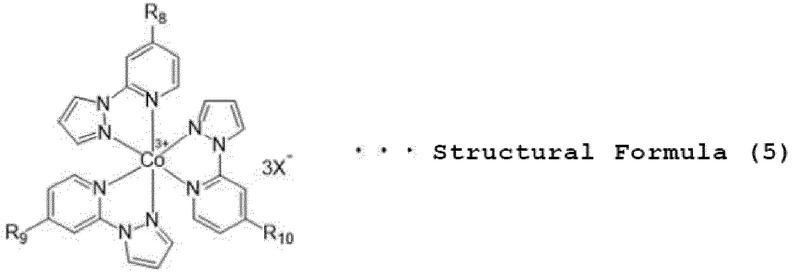

In the Structural Formula (5), R₈ to R₁₀ represent a hydrogen atom, a methyl group, an ethyl group, a tertiary butyl group, or a trifluoromethyl group. X represents any one of the following Structural Formulas (6) to (9).

BF₄ ··· **Structural formula** (6)

PF₆ ··· **Structural** Formula (7)

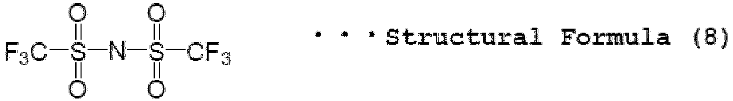

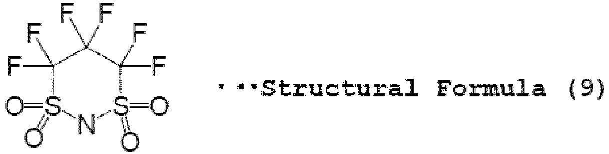

The X is preferably the Structural Formula (8) among the Structural Formulas (6) to (9). Use of the Structural Formula (8) is effective because the hole transport material can be safely maintained in an oxidation state.

Specific examples of these cobalt complexes include the following (F-1) to (F-24), but are not limited thereto.

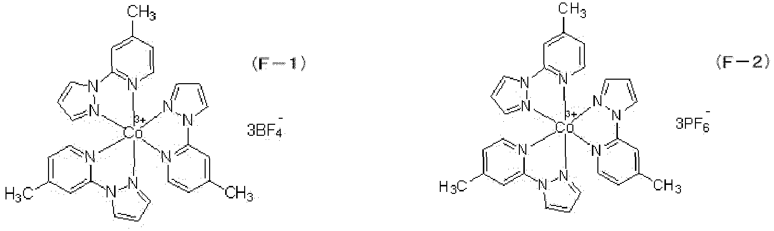

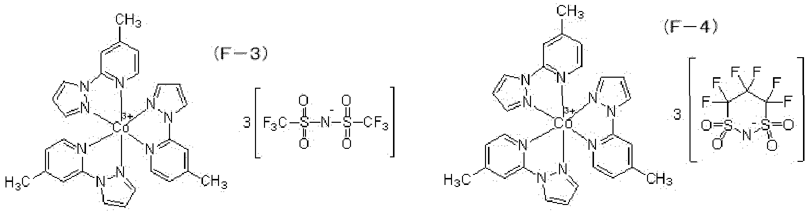

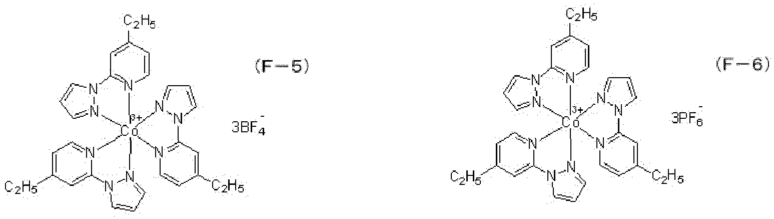

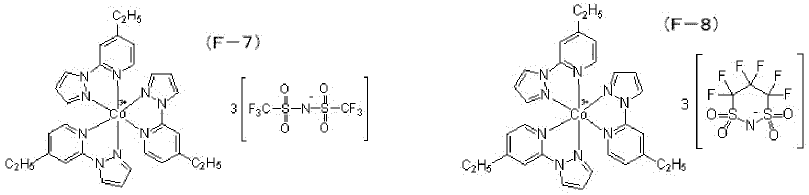

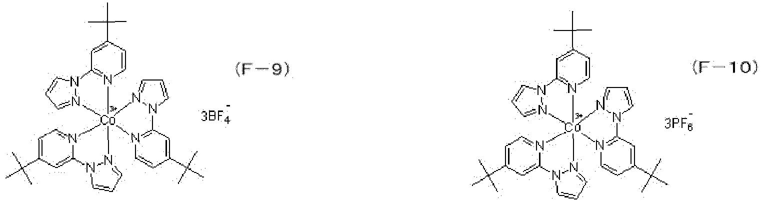

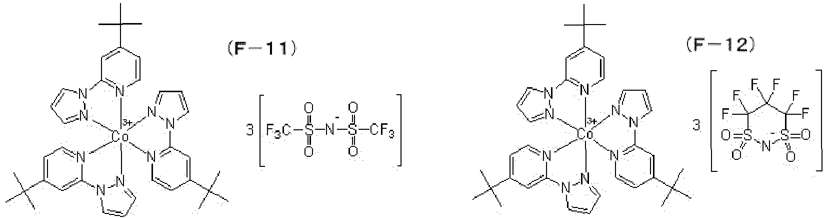

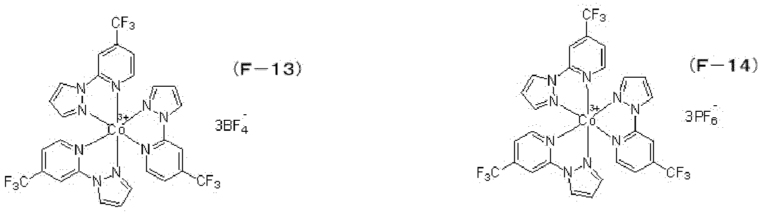

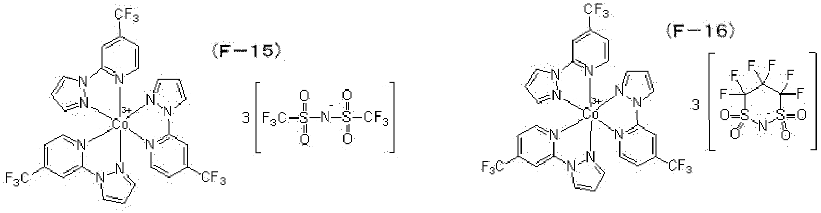

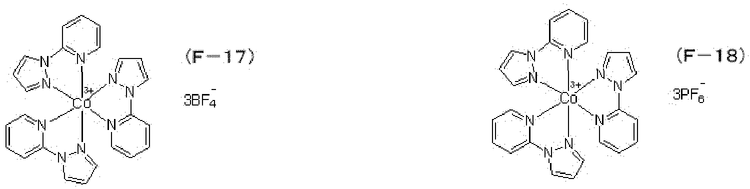

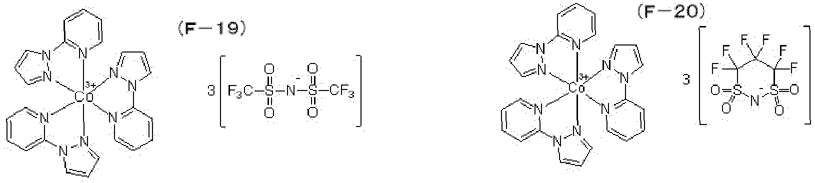

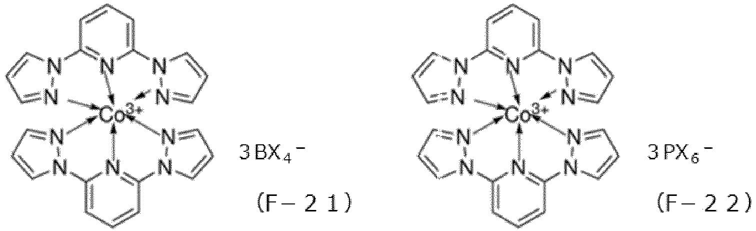

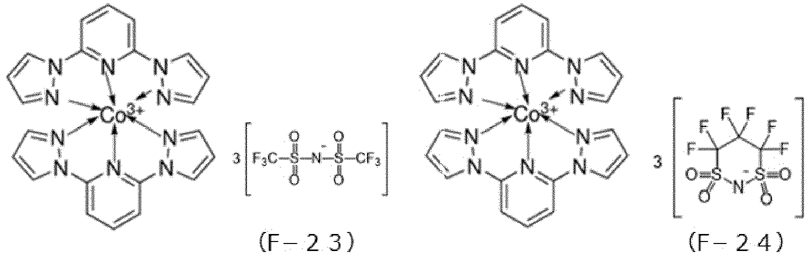

An amount of the oxidizing agent is preferably 1 mol% or more and 30 mol% or less, and more preferably 5 mol% or more and 20 mol% or less relative to the hole transport material.

The oxidizing agent may be used alone or in combination. When two or more kinds of oxidizing agents are used in combination, the hole transport layer is not easily crystalized, which may achieve high heat resistance in some cases.

The hole transport layer may have a single layer structure formed of a single material or may have a stacked layer structure including a plurality of compounds.

When the hole transport layer has a stacked layer structure, it is preferable to use a polymer material in the hole transport layer near the second electrode.

Use of the polymer material excellent in a film formation property is advantageous because it is possible to make the surface of the porous electron transport layer smoother and to improve the photoelectric conversion characteristics.

In addition, the polymer material does not easily permeate into the inside of the porous electron transport layer. Therefore, the polymer material has an excellent property of covering the surface of the porous electron transport layer, and may achieve an effect of minimizing short circuit when electrodes are provided.

### <<<Polymer material>>>

Examples of the polymer material used in the hole transport layer include conventional hole transport polymer materials.

Examples of the hole transport polymer material include polythiophene compounds, polyphenylene vinylene compounds, polyfluorene compounds, polyphenylene compounds, polyarylamine compounds, and polythiadiazole compounds.

Examples of the polythiophene compound include poly(3-n-hexylthiophene), poly(3-n-octyloxythiophene), poly(9,9'-dioctyl-fluorene-co-bithiophene), poly(3,3‴-didodecyl-quarter thiophene), poly(3,6-dioctylthieno[3,2-b]thiophene), poly(2,5-bis(3-decylthiophen-2-yl)thieno[3,2-b]thiophene), poly(3,4-didecylthiophene-co-thieno[3,2-b]thiophene), poly(3,6-dioctylthieno[3,2-b]thiophene-co-thieno[3,2-b]thiophene), poly(3,6-dioctylthieno[3,2-b]thiophene-co-thiophene), and poly(3,6-dioctylthieno[3,2-b]thiophene-co-bithiophene).

Examples of the polyphenylene vinylene compound include poly[2-methoxy-5-(2-ethylhexyloxy)-1,4-phenylenevinylene], poly[2-methoxy-5-(3,7-dimethyloctyloxy)-1,4-phenylenevinylene], and poly[(2-methoxy-5-(2-ethylhexyloxy)-1,4-phenylenevinylene)-co-(4,4'-biphenylene-vinylene)].

Examples of the polyfluorene compound include poly(9,9'-didodecylfluorenyl-2,7-diyl), poly[(9,9-dioctyl-2,7-divinylenefluorene)-alt-co-(9,10-anthracene)], poly[(9,9-dioctyl-2,7-divinylenefluorene)-alt-co-(4,4'-biphenylene)], poly[(9,9-dioctyl-2,7-divinylenefluorene)-alt-co-(2-methoxy-5-(2-ethylhexyloxy)-1,4-phenylene)], and poly[(9,9-dioctyl-2,7-diyl)-co-(1,4-(2,5-dihexyloxy)benzene)].

Examples of the polyphenylene compound include poly[2,5-dioctyloxy-1,4-phenylene] and poly[2,5-di(2-ethylhexyloxy-1,4-phenylene].

Examples of suitable polyarylamine compound include poly[(9,9-dioctylfluorenyl-2,7-diyl)-alt-co-(N,N'-diphenyl)-N,N'-di(p-hexylphenyl)-1,4-diaminobenzene], poly[(9,9-dioctylfluorenyl-2,7-diyl)-alt-co-(N,N'-bis(4-octyloxyphenyl)benzidine-N,N'-(1,4-diphenylene)], poly[(N,N'-bis(4-octyloxyphenyl)benzidine-N,N'-(1,4-diphenylene)], poly[(N,N'-bis(4-(2-ethylhexyloxy)phenyl)benzidine-N,N'-(1,4-diphenylene)], poly[phenylimino-1,4-phenylenevinylene-2,5-dioctyloxy-1,4-phenylenevinylene-1,4-phenylene], poly[p-tolylimino-1,4-phenylenevinylene-2,5-di(2-ethylhexyloxy)-1,4-phenylenevinylene-1,4-phenylene], and poly[4-(2-ethylhexyloxy)phenylimino-1,4-biphenylene].

Examples of the polythiadiazole compound include poly[(9,9-dioctylfluorenyl-2,7-diyl)-alt-co-(1,4-benzo(2,1',3)thiadiazole] and poly(3,4-didecylthiophene-co-(1,4-benzo(2,1',3)thiadiazole).

Among the hole transport polymer materials, polythiophene compounds and polyarylamine compounds are preferable in terms of carrier mobility and ionization potential.

The average thickness of the hole transport layer is not particularly limited and may be appropriately selected in accordance with the intended purpose. The hole transport layer preferably has such a structure that the hole transport layer enters pores of the porous electron transport layer. The hole transport layer having an average thickness of 0.01 µm or more and 20 µm or less is more preferably disposed on the electron transport layer, the hole transport layer having an average thickness of 0.1 µm or more and 10 µm or less is still more preferably disposed on the electron transport layer, and the hole transport layer having an average thickness of 0.2 µm or more and 2 µm or less is particularly preferably disposed on the electron transport layer.

The hole transport layer can be directly formed on the electron transport layer to which the photosensitization compound is adsorbed.

The method of producing the hole transport layer is not particularly limited and may be appropriately selected in accordance with the intended purpose. Examples of the method include a method of forming a thin film under vacuum such as vacuum deposition and the wet film formation method. Among them, particularly, the wet film formation method is preferable, and a method of performing coating on the electron transport layer is preferable, in terms of production cost.

When the wet film formation method is used, the coating method is not particularly limited and can be performed according to the conventional methods. Examples thereof include the dip method, the spray method, the wire bar method, the spin-coating method, the slit die coating method, the roller coating method, the blade coating method, and the gravure coating method. Examples of the wet printing method include various methods such as relief printing, offset printing, gravure printing, intaglio printing, rubber plate printing, and screen printing.

The film may be formed in a supercritical fluid or subcritical fluid having a lower temperature and pressure than a critical point.

The supercritical fluid is not particularly limited and may be appropriately selected in accordance with the intended purpose, as long as it is a fluid, which exists as a non-condensable high-dense fluid in a temperature and pressure region exceeding the limit (critical point) at which a gas and a liquid can coexist, does not condense even when being compressed, and is a fluid in a state of being equal to or higher than the critical temperature and the critical pressure. However, the supercritical fluid preferably has a lower critical temperature.

Examples of the supercritical fluid include carbon monoxide, carbon dioxide, ammonia, nitrogen, water, alcohol solvents, hydrocarbon solvents, halogen solvents, and ether solvents.

Examples of the alcohol solvent include methanol, ethanol, and n-butanol.

Examples of the hydrocarbon solvent include ethane, propane, 2,3 - dimethylbutane, benzene, and toluene. Examples of the halogen solvent include methylene chloride and chlorotrifluoromethane.

Examples of the ether solvent include dimethyl ether.

These may be used alone or in combination.

Among them, carbon dioxide, which has a critical pressure of 7.3 MPa and a critical temperature of 31°C, is preferable because carbon dioxide easily generates a supercritical state, and it is incombustible and is easily handled.

The subcritical fluid is not particularly limited and may be appropriately selected in accordance with the intended purpose, as long as it is present as a highpressure liquid in a temperature and pressure region near the critical point.

The compounds as exemplified as the supercritical fluid can be suitably used as the subcritical fluid.

The critical temperature and the critical pressure of the supercritical fluid are not particularly limited and may be appropriately selected in accordance with the intended purpose. The critical temperature is preferably -273°C or more and 300°C or less, and more preferably 0°C or more and 200°C or less.

**In** addition to the supercritical fluid and the subcritical fluid, an organic solvent or an entrainer may be used in combination.

Solubility in the supercritical fluid can be easily adjusted by addition of the organic solvent and the entrainer.

The organic solvent is not particularly limited and may be appropriately selected in accordance with the intended purpose. Examples of the organic solvent include ketone solvents, ester solvents, ether solvents, amide solvents, halogenated hydrocarbon solvents, and hydrocarbon solvents.

Examples of the ketone solvent include acetone, methyl ethyl ketone, and methyl isobutyl ketone.

Examples of the ester solvent include ethyl formate, ethyl acetate, and n-butyl acetate.

Examples of the ether solvent include diisopropyl ether, dimethoxy ethane, tetrahydrofuran, dioxolane, and dioxane.

Examples of the amide solvent include N,N-dimethylformamide, N,N-dimethylacetoamide, and N-methyl-2-pyrrolidone.

Examples of the halogenated hydrocarbon solvent include dichloromethane, chloroform, bromoform, methyl iodide, dichloroethane, trichloroethane, trichloroethylene, chlorobenzene, o-dichlorobenzene, fluorobenzene, bromobenzene, iodobenzene, and 1-chloronaphthalene.

Examples of the hydrocarbon solvent include n-pentane, n-hexane, n-octane, 1,5-hexadiene, cyclohexane, methylcyclohexane, cyclohexadiene, benzene, toluene, o-xylene, m-xylene, p-xylene, ethylbenzene, and cumene.

These may be used alone or in combination.

After the hole transport material is stacked on the electron transport layer to which the photosensitization compound is adsorbed, a press processing step may be performed.

The press processing allows the hole transport material to closely adhere to the electron transport layer that is a porous electrode, which may improve efficiency in some cases.

The press processing method is not particularly limited and may be appropriately selected in accordance with the intended purpose. Examples of suitable methods include: the press molding method using a plate, which is represented by the infrared spectroscopy (IR) tablet molding device; and the roll press method using, for example, a roller.

The pressure is preferably 10 kgf/cm² or more, and more preferably 30 kgf/cm² or more.

The duration of the press processing is not particularly limited and may be appropriately selected in accordance with the intended purpose. The duration thereof is preferably 1 hour or less. Moreover, heat may be applied at the time of the press processing. At the time of the press processing, a release agent may be disposed between a pressing machine and the electrode.

Examples of the release agent include fluororesins, such as polyethylene tetrafluoride, polychloro ethylene trifluoride, ethylene tetrafluoride-propylene hexafluoride copolymers, perfluoroalkoxy fluoride resins, polyvinylidene fluoride, ethylene-ethylene tetrafluoride copolymers, ethylene-chloroethylene trifluoride copolymers, and polyvinyl fluoride. These may be used alone or in combination.

After the press processing but before disposition of the second electrode, a metal oxide may be disposed between the hole transport layer and the second electrode.

Examples of the metal oxide include molybdenum oxide, tungsten oxide, vanadium oxide, and nickel oxide. These may be used alone or in combination. Among them, molybdenum oxide is preferable.

A method of disposing the metal oxide on the hole transport layer is not particularly limited and may be appropriately selected in accordance with the intended purpose. Examples of the method include: a method in which a thin film is formed in vacuum, such as sputtering and vacuum vapor deposition; and a wet film forming method.

Preferable examples of the wet film forming method include a method in which paste obtained by dispersing powder or sol of the metal oxide is prepared, followed by coating the paste on the hole transport layer.

A coating method used in the wet film forming method is not particularly limited and may be performed according to conventional methods. For example, various methods such as the dip method, the spray method, the wire bar method, the spin coating method, the roller coating method, the blade coating method, and the gravure coating method, or the wet printing method, such as relief printing, offset printing, gravure printing, intaglio printing, rubber plate printing, or screen printing may be used.

The average thickness of the coated metal oxide is preferably 0.1 nm or more and 50 nm or less, more preferably 1 nm or more and 10 nm or less.

### <Second electrode>

The photoelectric conversion element of the present disclosure includes a second electrode.

The second electrode can be formed on the hole transport layer or on the metal oxide on the hole transport layer.

The same material as the first electrode may be used for the second electrode. When the strength is sufficiently maintained, a support is not always required.

Examples of suitable materials for the second electrode include metals, carbon compounds, conductive metal oxides, and conductive polymers.

Examples of the metal include platinum, gold, silver, copper, and aluminum.

Examples of the carbon compound include graphite, fullerene, carbon nanotube, and graphene.

Examples of the conductive metal oxide include ITO, FTO, and ATO.

Examples of the conductive polymer include polythiophene and polyaniline.

These may be used alone or in combination.

The second electrode can be appropriately formed on the hole transport layer by a method such as coating, laminating, vapor deposition, CVD, or bonding, depending on the kind of material to be used or the kind of the hole transport layer.

In the photoelectric conversion element of the present disclosure, at least one of the first electrode and the second electrode is preferably substantially transparent.

A method in which the first electrode is transparent to allow incident light to pass from a side of the first electrode is preferable. In this case, a material that reflects light is preferably used for the second electrode, and glass, plastic, or a metal thin film on which a metal or conductive oxide is deposited is preferably used. In addition, disposition of an anti-reflection layer at a side where the incident light is to be received is an effective means.

### <Electrode protection layer (passivation layer)>

The photoelectric conversion element of the present disclosure includes the electrode protection layer (may be referred to as a passivation layer).

The electrode protection layer is a layer disposed between a sealing part that will be described later and the second electrode.

The electrode protection layer is a layer that minimizes peeling of the second electrode that is caused by the sealing part.

The electrode protection layer is not particularly limited as long as it is disposed on a surface side of the second electrode where the sealing part is to be disposed. The electrode protection layer may be disposed so that the second electrode is not completely in contact with the sealing part. The electrode protection layer may be disposed so that the second electrode is partially in contact with the sealing part as long as the effect of the present disclosure can be achieved.

The electrode protection layer includes a fluorine compound having a silane structure.

An average thickness of the electrode protection layer is preferably 10 nm or more, and more preferably 50 nm or more.

### <Sealing part>

The sealing part includes a pressure-sensitive adhesive.

The sealing part is disposed so as to cover at least side surfaces of the photoelectric conversion layer and the second electrode, and is a layer that shields the photoelectric conversion layer and the second electrode from the external environment.

The sealing part can shield at least the photoelectric conversion layer and the second electrode from the external environment of the photoelectric conversion element.

Here, the "shielding the photoelectric conversion layer and the second electrode from the external environment" is not particularly limited as long as at least the photoelectric conversion layer and the second electrode are placed in an environment different from the external environment of the photoelectric conversion element. For example, "surface sealing" is preferable. In the surface sealing, the sealing part is disposed on the whole surface of a power generation region constituted with the photoelectric conversion layer of the photoelectric conversion element, and is attached to the second substrate.

The sealing methods can be mainly classified into "frame sealing" and "surface sealing". In the "frame sealing", a sealing member is disposed on the peripheral part of a power generation region constituted with the photoelectric conversion layer of the photoelectric conversion element, and is attached to the second substrate. In the "surface sealing", a sealing member is disposed on the whole surface of the power generation region, and is attached to the second substrate. In the "frame sealing" of the former, because a hollow part can be formed inside the sealed part, an amount of moisture and an amount of oxygen inside the sealed part can be appropriately adjusted. Moreover, the effect caused by a peeled electrode can be decreased because the second electrode is not in contact with the sealing member. On the other hand, the "surface sealing" of the latter is excellent in minimizing entry of excessive water or oxygen from the outside. Moreover, an attachment area with the sealing member is large, and therefore the sealing strength is high. Therefore, the "surface sealing" is particularly preferable when a flexible substrate is used for the first substrate.

The sealing part preferably has a 180° peel strength of 5 N/1 cm or more when the 180° peel strength is measured under the following conditions.

When the peel strength of the sealing part falls within the above range, durability after storage under high temperature and high humidity environment and after continuous irradiation of light can be improved. It is assumed that the reason for this is as follows. Specifically, when the peel strength of the sealing part falls within the above range, the shielding property from the external environment can be enhanced because the sealing part has a strong adhesive force. Moreover, it is assumed that an UV curable resin or a thermosetting resin is contracted when cured and forms a gap between the sealing part and the substrate or the like, resulting in a concern about durability under high temperature and high humidity environment.

### <Condition>

The 180° peel strength means the peel strength obtained by measuring glass pasted with a film attached to a sealing part by the measuring method according to the JIS standard K6854-2.

The sealing part includes a pressure-sensitive adhesive. A material of the sealing part is not particularly limited and may be appropriately selected in accordance with the intended purpose as long as the material can decrease entry of excessive water or oxygen from the external environment and is a material corresponding to the above sealing part.

The sealing part has an effect of minimizing mechanical destruction caused through external pressing, and conventional materials can be used as long as this effect can be achieved.

The pressure-sensitive adhesive is an adhesive that constantly has tackiness (stickiness), a force (adhesive force) of strongly adhering to a surface, and a property (aggregation force) by which the adhesive hardens. Since the pressure-sensitive adhesive has stickiness and an adhesive force, it enables adhesion in the moment of contact without affecting the surface shape of an object. On the other hand, a curing-type adhesive does not enable adhesion simply by contacting with the object and enables adhesion with a curing reaction. In addition, since the pressure-sensitive adhesive constantly has an aggregation force, it does not spread over parts other than the part that contacts with the object. On the other hand, since the curing-type adhesive has no aggregation force, it spreads over the parts other than the part that contacts with the object, and the adhesive possibly contaminates unwanted areas.

The pressure-sensitive adhesive includes at least one of olefin-based resins, rubber-based resins, silicon-based resins, and acrylic resins.

As the sealing part, a sheet-type sealing material can be used.

The sheet-type sealing material is, for example, a material obtained by forming a sealing part such as an epoxy resin on a sheet in advance, and the sheet used is, for example, glass or a film having a high gas barrier property. The sheet-type sealing material corresponds to a second substrate or a combination of a second substrate and a sealing substrate in the present disclosure.

The sheet-type sealing material is pasted on a second electrode, and pressure is applied thereon while the sheet-type sealing material is warmed, which can form a sealing substrate and a second substrate at one time.

Depending on the formation pattern of the sealing part formed on the sheet, the photoelectric conversion element can have such a structure that a hollow part is provided, such a structure is effective.

When the sealing part formed on the sheet is formed on the whole surface of the power generation region, such a configuration can be "surface sealing". Depending on the formation pattern of the sealing part, when the sealing part is formed through patterning so that a hollow part is provided inside the photoelectric conversion element, such a configuration can be "frame sealing".

Examples of the sheet-type sealing material include a rubber-based sealing part-including aluminum PET sheet (manufactured by Tesa, product name: 61539), an olefin-based sealing part-including aluminum PET sheet (manufactured by Moresco, product name: S2191), and a sealing part-including aluminum PET sheet (manufactured by from Ajinomoto Fine-Techno Co., Inc., product name: FD21).

The pressure-sensitive adhesive preferably includes an additive if necessary.

Examples of the additive include fillers, gap agents, drying agents (moisture absorbents), flexibilizers, colorants, flame retardant auxiliaries, antioxidants, and organic solvents. Among them, fillers, gap agents, and drying agents (moisture absorbents) are preferable, and fillers are more preferable.

The filler is effective in minimizing entry of moisture or oxygen, and is very effective in achieving effects such as reduction in volumetric shrinkage, reduction in an amount of outgas at the time of heating, improvement of mechanical strength, and control of thermal conductivity or fluidity and in maintaining stable output under various environments. Particularly, regarding output properties or durability of a photoelectric conversion element, not only influence of passing of moisture or oxygen, but also influence of outgas generated at the time of heating the sealing member cannot be ignored. Particularly, the influence of outgas generated at the time of heating greatly affects output properties stored under a high temperature environment.

In this case, inclusion of the filler, the gap agent, or the drying agent in the sealing part can minimize entry of moisture or oxygen, and can decrease an amount of the sealing part to be used, which can achieve an effect of decreasing outgas. This is effective in terms of output characteristics in the storage under high temperature and high humidity and is effective in storing the photoelectric conversion element under a high temperature environment.

The filler is not particularly limited and may be appropriately selected in accordance with the intended purpose. Preferable examples of the filler include inorganic fillers such as crystalline or amorphous silica, talc, alumina, aluminum nitride, silicon nitride, calcium silicate, and calcium carbonate. These may be used alone or in combination.

An average primary particle diameter of the filler is preferably 0.1 µm or more and 10 µm or less, more preferably 1 µm or more and 5 µm or less.

An amount of the filler is preferably 10 parts by mass or more and 90 parts by mass or less, more preferably 20 parts by mass or more and 70 parts by mass or less, relative to 100 parts by mass of the whole sealing member.

When the amount of the filler falls within the above range, an effect of minimizing entry of moisture or oxygen can be sufficiently obtained, the viscosity becomes appropriate, adhesiveness to a substrate and a defoaming property are improved, and workability are effective.

The drying agent is also called a moisture absorbent and is a material having a function of physically or chemically adsorbing or absorbing moisture. Inclusion of the drying agent in the sealing part is effective because moisture resistance is further enhanced and a decrease in influence of outgas may be decreased.

The drying agent is preferably a particulate material. Examples of the drying agent include inorganic water-absorbing materials such as calcium oxide, barium oxide, magnesium oxide, magnesium sulfate, sodium sulfate, calcium chloride, silica gel, molecular sieve, and zeolite. Among them, zeolite is preferable because zeolite absorbs a large amount of moisture. These may be used alone or in combination.

The sealing part preferably includes a moisture-trapping material.

The moisture-trapping material is not particularly limited and may be appropriately selected in accordance with the intended purpose as long as it can trap moisture in gas or liquid. Examples thereof include water absorbing materials and water absorbing resins.

The moisture-trapping material preferably has a measured moisture-trapping property of 20 mg/100 mm² or more, more preferably has a measured moisture-trapping property of 30 mg/100 mm² or more, and still more preferably has a measured moisture-trapping property of 60 mg/100 mm² or more.

Examples of the water absorbing material include drying agents. Examples of the drying agent include activated carbon, zeolite, calcium compounds, magnesium compounds, silica gel, and organometallic compounds.

A method of forming the sealing part is not particularly limited and can be performed according to conventional methods. Examples of the method include various methods such as the vacuum pasting method, the heat roller method, the dispensing method, the wire bar method, the spin-coating method, the roller coating method, the blade coating method, the gravure coating method, the relief printing, the offset printing, the intaglio printing, the rubber plate printing, and the screen printing.

The photoelectric conversion element of the present disclosure may include a sealing substrate on a surface of the sealing part opposite to a surface of the sealing part facing the second electrode.

### <Sealing substrate>

The sealing substrate can be provided to further minimize entry of gases, such as water vapor, in the sealing part.

The material of the sealing substrate is not particularly limited and may be appropriately selected in accordance with the intended purpose as long as it can minimize entry of gases. Examples of the material of the sealing substrate include aluminum, glass, and PET films.

The size and the structure of the sealing substrate are not particularly limited and may be appropriately selected in accordance with the intended purpose.

### <Second substrate>

The photoelectric conversion element of the present disclosure may include a second substrate.

The second substrate is not particularly limited and may be appropriately selected in accordance with the intended purpose. The same material as the first substrate can be used.

The second substrate is not particularly limited and conventional products can be used. Examples thereof include substrates such as glass, plastic films, ceramic, and PET. A convex-concave part may be formed at a connection part between the second substrate and the sealing member, in order to increase adhesiveness.

A formation method of the convex-concave part is not particularly limited and may be appropriately selected in accordance with the intended purpose. Examples of the formation method include the sand blasting method, the water blasting method, abrasive paper, the chemical etching method, and the laser processing method.

As a method of increasing adhesiveness between the second substrate and the sealing part or the sealing substrate, for example, organic matter on the surface may be removed, or hydrophilicity may be improved. The method of removing organic matter on the surface of the second substrate is not particularly limited and may be appropriately selected in accordance with the intended purpose. Examples of the method include UV ozone washing and an oxygen plasma treatment.

### [Embodiments]

Hereinafter, one example of a photoelectric conversion element of the present disclosure will be described with reference to drawings. However, the present disclosure is not limited thereto, those that are not described in the embodiments of the present disclosure regarding the number, the position, and the shape of the following constituent components can be also included in the scope of the present disclosure.

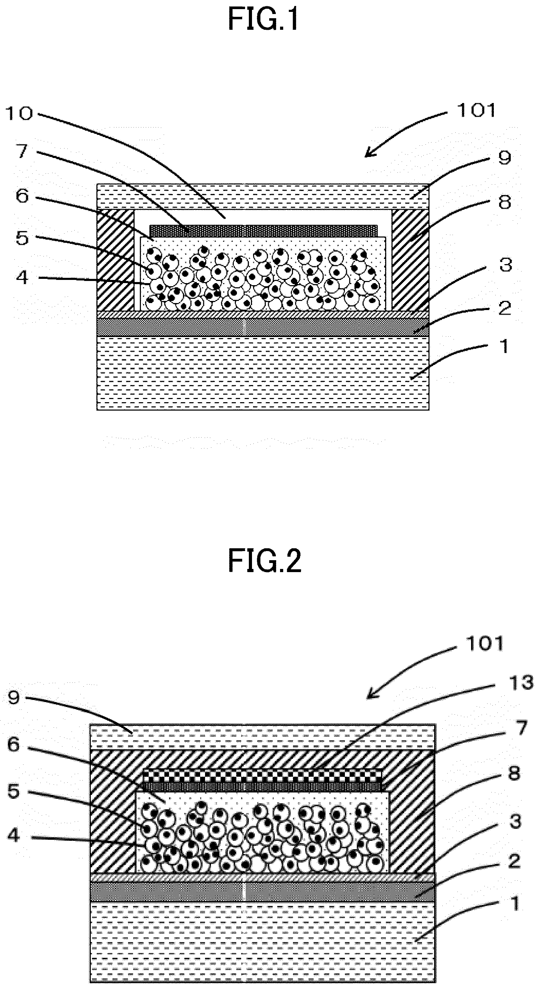

Fig. 1 is a schematic view illustrating one example of a photoelectric conversion element not according to the invention.

As presented in Fig. 1, in a photoelectric conversion element 101, a first electrode 2 is formed on a first substrate 1, and a hole blocking layer 3 is formed on the first electrode 2. An electron transport layer 4 is formed on the hole blocking layer 3, and a photosensitization compound 5 is adsorbed on a surface of an electron transport material constituting the electron transport layer 4. A hole transport layer 6 is formed on and in the electron transport layer 4, and a second electrode 7 is formed on the hole transport layer 6. A second substrate 9 is provided above the second electrode 7, and the second substrate 9 is fixed by a sealing part 8 between the second substrate 9 and the hole blocking layer 3. Formation of the hole blocking layer 3 can minimize recombining of electrons and holes, thereby improving the power generation performance.

The photoelectric conversion element presented in Fig. 1 may include a gap part 10 between the second electrode 7 and the second substrate 9. Inclusion of the gap part can control the oxygen concentration in the gap part, which results in improvement of the power generation performance and the durability. Moreover, because the second electrode 7 is not directly in contact with the second substrate 9, peeling or breakage of the second electrode 7 may be minimized.

Note that, the first electrode 2 and the second electrode 7 can each have a path configured to allow electric current to pass to an electrode extraction terminal, which is not presented in the figure.

Fig. 2 to Fig. 4 are each a schematic view presenting another example of the photoelectric conversion element of the present disclosure, and present a case where no gap part is provided and the photoelectric conversion layer (electron transport layer 4 and hole transport layer 6) of Fig. 1 is completely covered with the sealing part 8.

A method of producing the photoelectric conversion element including no gap part is not particularly limited and may be appropriately selected in accordance with the intended purpose. Examples thereof include: a method in which the sealing part 8 is coated on the whole surface of a second electrode 7 and a second substrate 9 is provided thereon; and a method using the aforementioned sheet-type sealing material.

In this case, a passivation layer 13 can be provided between the second electrode 7 and the sealing part 8, and may be effective in minimizing peeling of the second electrode.

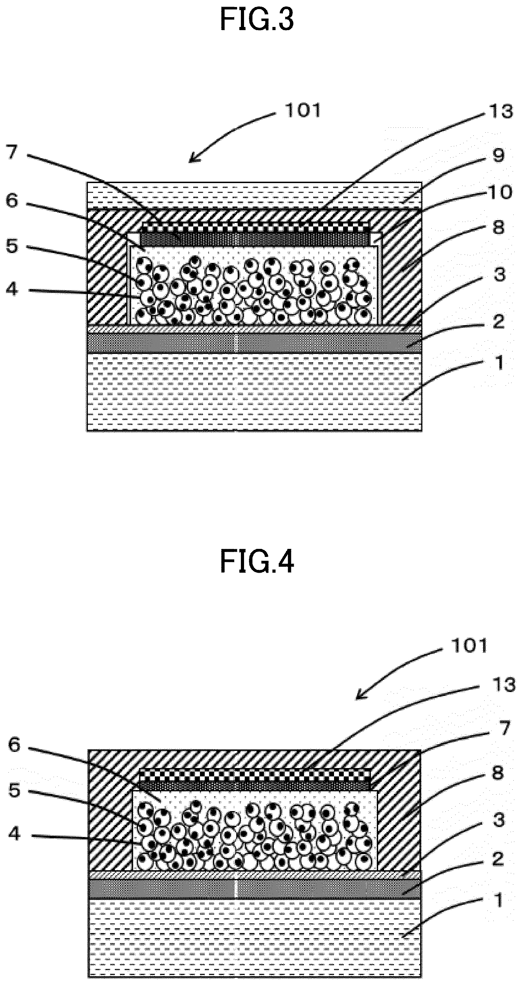

The gap part may be completely eliminated as presented in Fig. 2, or the gap part may partially remain as presented in Fig. 3. Complete covering of the photoelectric conversion layer with the sealing part 8 can minimize peeling or breakage of the second substrate 9 when stress caused by, for example, twist or fall is applied to the photoelectric conversion element, which can enhance the mechanical strength of the photoelectric conversion element. As a modification example of Fig. 2, such a configuration that no second substrate is provided can be used as presented in Fig. 4.

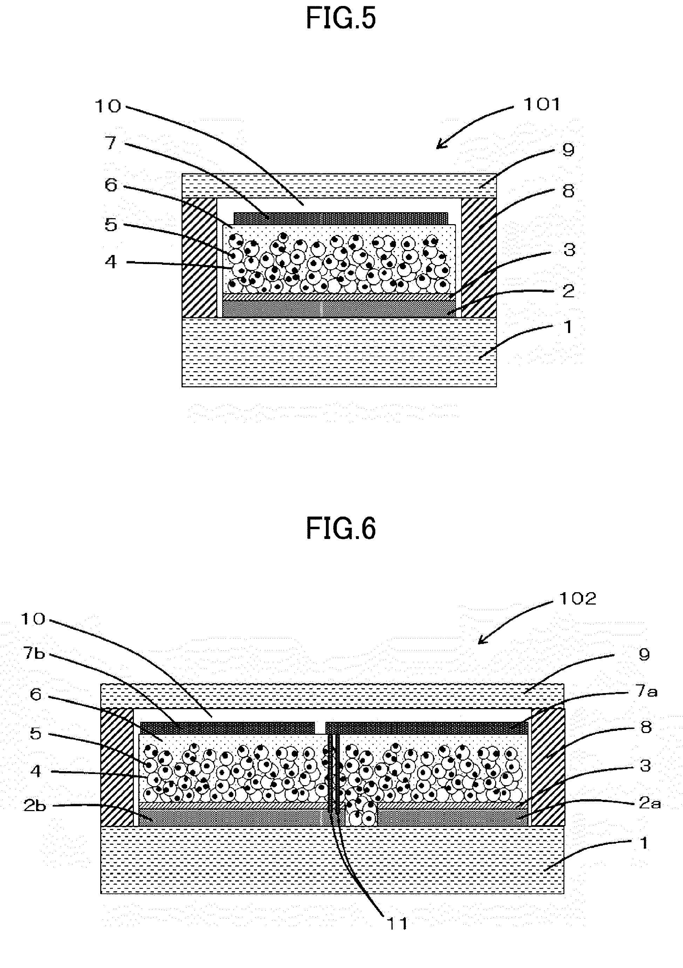

Fig. 5 is a schematic view presenting another example of a photoelectric conversion element not according to the invention and presents the case where a sealing part 8 is attached to a first substrate 1 and a second substrate 9. Such configuration increases adhesiveness between the substrate and the sealing part 8 and can obtain an effect of enhancing the mechanical strength of the photoelectric conversion element. When the adhesiveness is enhanced, such a sealing effect that minimizes entry of excessive moisture or oxygen can be further enhanced.

### (Photoelectric conversion module)

The photoelectric conversion module of the present disclosure includes a photoelectric conversion element including a first electrode, a photoelectric conversion layer, and a second electrode, and includes a sealing part disposed so as to cover at least side surfaces of the photoelectric conversion layer and the second electrode. The photoelectric conversion module of the present disclosure includes other layers if necessary. Each layer may have a single layer structure or may have a stacked layer structure.

The photoelectric conversion module of the present disclosure includes a plurality of the photoelectric conversion elements of the present disclosure that are disposed adjacent to each other, and preferably includes an arrangement region of photoelectric conversion elements connected in series or in parallel.

Preferably, in the photoelectric conversion module of the present disclosure including at least two of the photoelectric conversion elements adjacent to each other, the first electrode in one of the photoelectric conversion elements is electrically connected to the second electrode in another of the photoelectric conversion elements through a conduction part penetrating the photoelectric conversion layer.

The photoelectric conversion module can have such a configuration that the photoelectric conversion module includes a pair of substrates, an arrangement region of photoelectric conversion elements connected in series or in parallel is provided between the pair of substrates, and the sealing member is sandwiched with the pair of substrates.

### [Embodiments]

Hereinafter, one example of a photoelectric conversion module of the present disclosure will be described with reference to drawings. However, the present disclosure is not limited thereto, those that are not described in the embodiments of the present disclosure regarding the number, the position, and the shape of the following constituent components can be also included in the scope of the present disclosure.

Fig. 6 is a schematic view presenting one example of a photoelectric conversion module of the present disclosure, and presents one example of a cross section of a part of the photoelectric conversion module that includes a plurality of photoelectric conversion elements that are connected in series.

In a photoelectric conversion module 102 of Fig. 6, which is not according to the invention, after a hole transport layer 6 is formed, a penetration part 11 is formed. When a second electrode 7 is formed thereon, a material of the second electrode is introduced inside the penetration part 11, and this makes it possible to allow electric current to pass to a first electrode 2b of the adjacent cell. Note that, a first electrode 2a and a second electrode 7b each have an electrode of a further adjacent cell or a path configured to allow electric current to pass to an electrode extraction terminal, which is not presented in Fig. 6.

The penetration part 11 may penetrate through the first electrode 2 to reach a first substrate 1, or may not reach the first substrate 1 by stopping processing inside the first electrode 2.

In the case where a shape of the penetration part 11 is such a micropore that penetrates through the first electrode 2 and reaches the first substrate 1, when a total opening area of the micropore with respect to an area of the penetration part 11 is too large, a cross-sectional area of the film of the first electrode 2 is decreased to thereby increase the resistance value, which may cause a decrease of photoelectric conversion efficiency. Therefore, a ratio of the total opening area of the micropore to the area of the penetration part 11 is preferably 5/100 or more and 60/100 or less.

A method of forming the penetration part 11 is not particularly limited and may be appropriately selected in accordance with the intended purpose. Examples thereof include the sand blasting method, the water blasting method, abrasive paper, the chemical etching method, and the laser processing method. Among them, the laser processing method is preferable. This makes it possible to form a minute hole without using, for example, sand, etching, or resist, and to perform processing with good cleanness and reproducibility. In addition, when the penetration part 11 is formed, at least one of a hole blocking layer 3, an electron transport layer 4, the hole transport layer 6, and the second electrode 7 can be removed through impact peeling using the laser processing method. As a result, it is not necessary to provide a mask at the time of laminating, the aforementioned removal and formation of the minute penetration part 11 can be easily performed at one time.

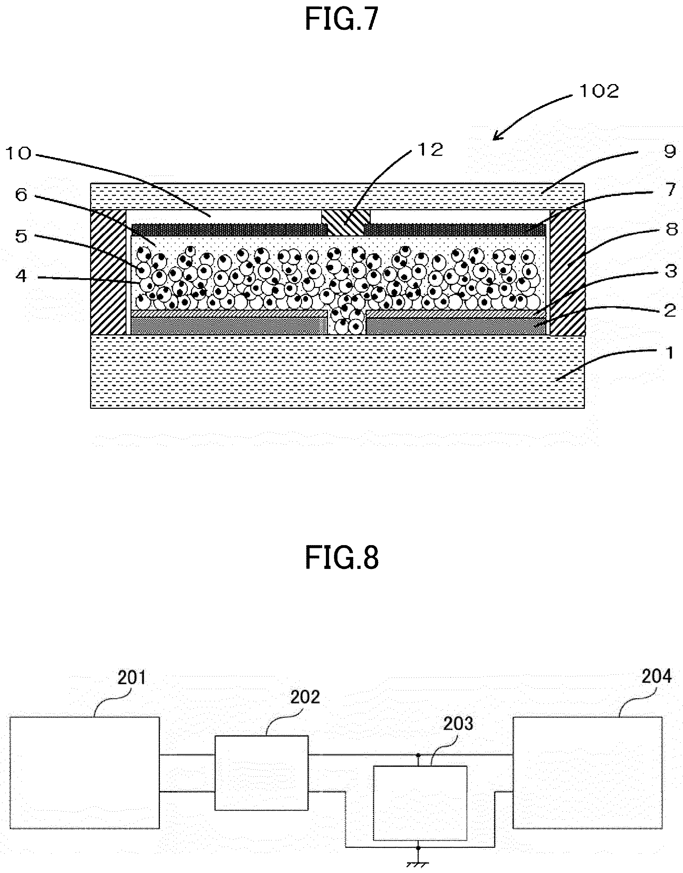

Fig. 7 is a schematic view presenting one example of the photoelectric conversion module not according to the invention, and presents one example of a cross section of a part of the photoelectric conversion module in which a photoelectric conversion module 102 includes a plurality of photoelectric conversion elements that are connected in series, and includes a sealing part 12 like a beam in a gap part between the cells.

As presented in Fig. 3, when the gap part is provided between the second electrode 7 and the second substrate 9, peeling or breakage of the second electrode 7 can be minimized, but the mechanical strength of the sealing may be reduced in some cases. Meanwhile, as presented in Fig. 2, a space between the second electrode 7 and the second substrate 9 is filled with the sealing part 8, the mechanical strength of the sealing is enhanced, but there may be a risk that the second electrode 7 is peeled. In order to enhance power generation force, increasing an area of the photoelectric conversion module is effective, but a decrease of the mechanical strength is inevitable in the case where the gap part is included therein.

Therefore, as presented in Fig. 7, providing the sealing part 12 like a beam is effective because peeling or breakage of the second electrode 7 can be minimized and the mechanical strength of the sealing can be enhanced.

Here, a material of the sealing part 12 may be identical to or different from a material of a sealing part 8.

### (Electronic device)

An electronic device of the present disclosure includes: at least one of a photoelectric conversion element and a photoelectric conversion module of the present disclosure; and a device configured to be driven by electric power generated through photoelectric conversion of at least one of the photoelectric conversion element and the photoelectric conversion module. The electronic device of the present disclosure further includes other devices if necessary.

The electronic device of the present disclosure includes: at least one of the photoelectric conversion element and the photoelectric conversion module of the present disclosure; an electricity storage cell that can store electric power generated through photoelectric conversion of the at least one of the photoelectric conversion element and the photoelectric conversion module; and a device configured to be driven by the electric power stored in the electricity storage cell. The electronic device of the present disclosure includes other devices if necessary.

### (Power supply module)

A power supply module of the present disclosure includes: the photoelectric conversion element and/or the photoelectric conversion module of the present disclosure; and a power supply integrated circuit (power supply IC). The power supply module of the present disclosure further includes other devices if necessary.

A specific embodiment of an electronic device including the photoelectric conversion element and/or the photoelectric conversion module of the present disclosure and a device configured to be driven by electric power obtained through power generation of the photoelectric conversion element and/or the photoelectric conversion module will be described.

Fig. 8 presents one example of the electronic device including a mouse.

As presented in Fig. 8, a photoelectric conversion element 201, a power supply IC 202, and an electricity storage device 203 are combined and the supplied electric power is allowed to pass to a power supply of a control circuit 204 of a mouse. As a result, the electricity storage device is charged when the mouse is not used, and the mouse can be driven by the electric power. Therefore such a mouse that requires neither wiring nor replacement of a cell can be obtained. Since a cell is not required, a weight thereof can be decreased, and such a configuration is effective.

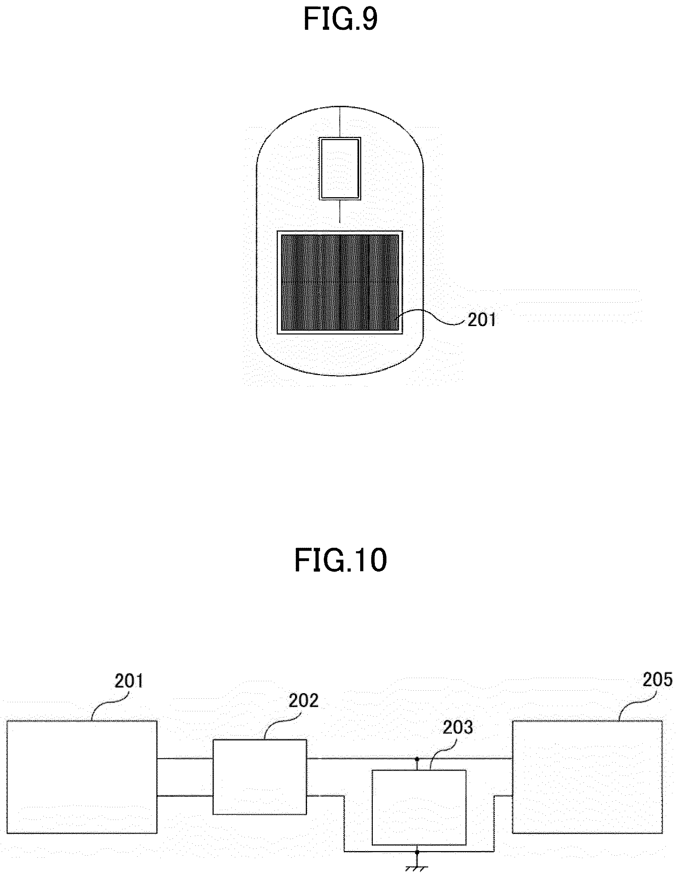

Fig. 9 presents a schematic view of a mouse including a photoelectric conversion element 201. The photoelectric conversion element 201, a power supply IC 202, and an electricity storage device 203 are mounted inside a mouse, but an upper part of the photoelectric conversion element 201 is covered with a transparent housing so that the photoelectric conversion element 201 receives light. Moreover, the whole housing of the mouse can be formed with a transparent resin. The arrangement of the photoelectric conversion element 201 is not limited to the above. For example, the photoelectric conversion element 201 may be arranged in a position to which light is emitted even when the mouse is covered with a hand, and such arrangement may be preferable.

Another embodiment of an electronic device including the photoelectric conversion element and/or the photoelectric conversion module of the present disclosure and a device configured to be driven by electric power obtained through power generation of the photoelectric conversion element and/or the photoelectric conversion module will be described.

Fig. 10 presents one example of a keyboard as the electronic device, which is used in a personal computer.

As presented in Fig. 10, a photoelectric conversion element 201, a power supply IC 202, and an electricity storage device 203 are combined, and the supplied electric power is allowed to pass to a power supply of a control circuit 205 of a keyboard. As a result, the electricity storage device 203 is charged when the keyboard is not used, and the keyboard can be driven by the electric power. Therefore, such a keyboard that requires neither wiring nor replacement of a cell can be obtained. Such a configuration is effective because a cell is not required and therefore a weight thereof can be decreased.

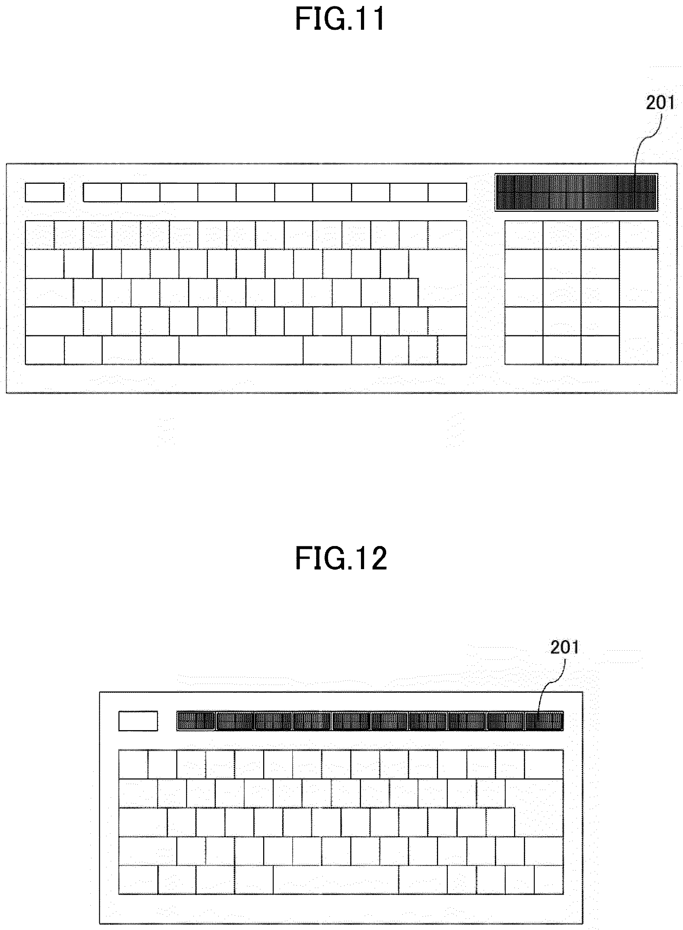

Fig. 11 presents a schematic view of a keyboard including a photoelectric conversion element 201. The photoelectric conversion element 201, a power supply IC 202, and an electricity storage device 203 are mounted inside the keyboard, but an upper part of the photoelectric conversion element 201 is covered with a transparent housing so that the photoelectric conversion element 201 receives light. The whole housing of the keyboard can be formed with a transparent resin. The arrangement of the photoelectric conversion element 201 is not limited to the above.

In the case of a small keyboard in which a space for incorporating the photoelectric conversion element is small, a small photoelectric conversion element may be embedded in some keys as presented in Fig. 12, and such arrangement is effective.

Another embodiment of an electronic device including the photoelectric conversion element and/or the photoelectric conversion module of the present disclosure and a device configured to be driven by electric power obtained through power generation of the photoelectric conversion element and/or the photoelectric conversion module will be described.

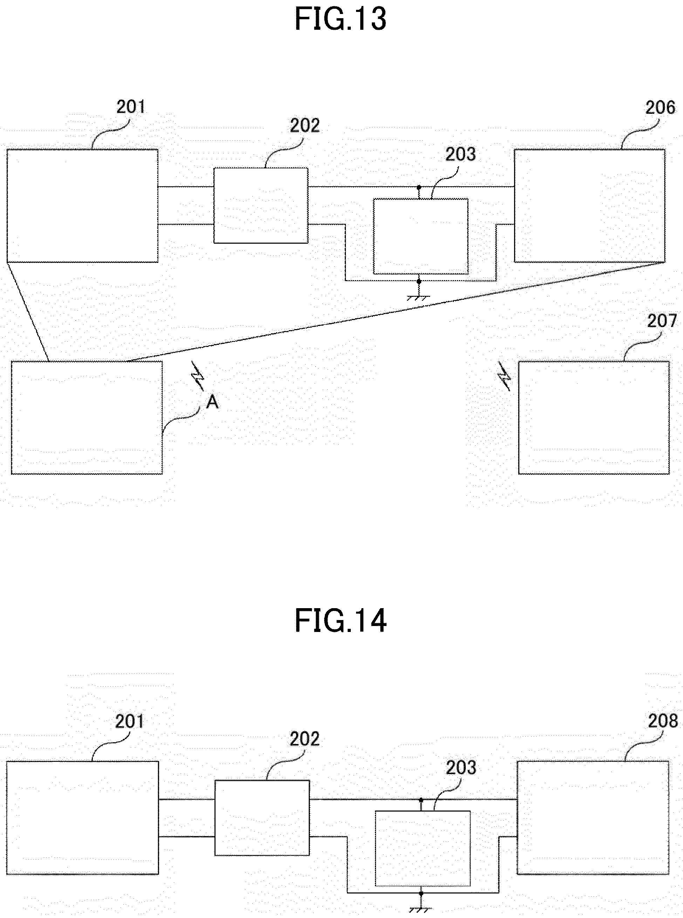

Fig. 13 illustrates one example where a sensor is used as the electronic device.

As presented in Fig. 13, a photoelectric conversion element 201, a power supply IC 202, and an electricity storage device 203 are combined, and the supplied electric power is allowed to pass to a power supply of a sensor circuit 206. As a result, a sensor module A can be constituted without requiring connection to an external power supply and without requiring replacement of a cell. A sensing target is, for example, temperature and humidity, illuminance, human detection, CO₂ concentration, acceleration, UV intensity, noise, terrestrial magnetism, and atmospheric pressure, and such an electronic device can be applied to various sensors, which is effective. As presented in Fig. 13, the sensor module is configured to sense a target to be measured on a regular basis and to transmit the read data to a device 207 such as a personal computer (PC) or a smartphone through wireless communication.

It is expected that use of sensors is significantly increased as the internet of things (IoT) society approaches. Replacing batteries of numerous sensors one by one is time consuming and is not realistic. Moreover, a sensor is installed at a position such as a ceiling and a wall where a cell is not easily replaced, and this arrangement makes workability bad. The fact that electricity can be supplied by the photoelectric conversion element is also significantly advantageous. In addition, the photoelectric conversion element of the present disclosure has such advantages that a high output can be obtained even with light of a low illuminance, and a high degree of freedom in installation can be achieved because dependence of light incident angle for the output is small.

Another embodiment of an electronic device including the photoelectric conversion element and/or the photoelectric conversion module of the present disclosure and a device configured to be driven by electric power obtained through power generation of the photoelectric conversion element and/or the photoelectric conversion module will be described.

Fig. 14 illustrates one example where a turntable is used as the electronic device.

As illustrated in Fig. 14, a photoelectric conversion element 201, a power supply IC 202, and an electricity storage device 203 are combined, and the supplied electric power is allowed to pass to a power supply of a turntable control circuit 208. As a result, a turntable can be constituted without requiring connection to an external power supply and without requiring replacement of a cell.

The turntable is used in, for example, a display case in which products are displayed. Wiring of a power supply degrades appearance of the display, and moreover displayed products need to be removed at the time of replacing a cell, which is time-consuming. Use of the photoelectric conversion element of the present disclosure is effective because the aforementioned problems can be solved.

### <Use>

As described above, the electronic device and the power supply module, which include the photoelectric conversion element and/or the photoelectric conversion module of the present disclosure and the device configured to be driven by electric power obtained through power generation of the photoelectric conversion element and/or the photoelectric conversion module, have been described. However, the embodiments described are only part of applicable embodiments, and use of the photoelectric conversion element or the photoelectric conversion module of the present disclosure is not limited to the above-described uses.

The photoelectric conversion element and the photoelectric conversion module can be applied to, for example, a power supply device by combining the photoelectric conversion element and/or the photoelectric conversion module with a circuit board configured to control generated electric current.

Examples of devices using the power supply device include electronic desk calculators, watches, mobile phones, electronic organizers, and electronic paper.

Moreover, a power supply device including the photoelectric conversion element can be used as an auxiliary power supply for prolonging the continuous operation time of electrical devices powered by rechargeable or disposable batteries.

The photoelectric conversion element and the photoelectric conversion module of the present disclosure can function as a self-sustaining power supply, and electric power generated through photoelectric conversion can be used to drive a device. Since the photoelectric conversion element and the photoelectric conversion module of the present disclosure can generate electricity by irradiation of light, it is not necessary to connect the electronic device to a power supply or to replace a cell. Therefore, the electronic device can be driven in a place without power supply facility, the electronic device can be worn or carried, and the electronic device can be driven without replacement of a cell even in a place where a cell is not easily replaced. Moreover, when a dry cell is used, the electronic device becomes heavy by a weight of the dry cell, or the electronic device becomes large by a size of the dry cell. Therefore, there may be a problem in installing the electronic device on a wall or ceiling, or transporting the electronic device. However, since the photoelectric conversion element and the photoelectric conversion module of the present disclosure are light and thin, they can be freely installed, and can be worn or carried, which is advantageous.

As described above, the photoelectric conversion element and the photoelectric conversion module of the present disclosure can be used as a self-sustaining power supply, and can be combined with various electronic devices. For example, the photoelectric conversion element and the photoelectric conversion module of the present disclosure can be used in combination with a display device (e.g., an electronic desk calculator, a watch, a mobile phone, an electronic organizer, and electronic paper), an accessory device of a personal computer (e.g., a mouse and a keyboard), various sensor devices (e.g., a temperature and humidity sensor and a human detection sensor), a transmitter (e.g., a beacon and a global positioning system (GPS)), and numerous electronic devices (e.g., an auxiliary lamp and a remote controller).

The photoelectric conversion element and the photoelectric conversion module of the present disclosure are widely applied because they can generate electricity particularly with light of a low illuminance and can generate electricity indoors and in further darker shade. Moreover, the photoelectric conversion element and the photoelectric conversion module are highly safe, because liquid leakage in the case of a dry cell does not occur, and accidental ingestion in the case of a button cell does not occur. Furthermore, the photoelectric conversion element and the photoelectric conversion module can be used as an auxiliary power supply for the purpose of prolonging the continuous operation time of electrical devices powered by rechargeable or disposable batteries. As described above, when the photoelectric conversion element and/or the photoelectric conversion module of the present disclosure are/is combined with a device configured to be driven by electric power generated through photoelectric conversion of the photoelectric conversion element and/or the photoelectric conversion module, it is possible to obtain an electronic device, which is light and easy to use, has a high degree of freedom in installation, does not require replacement of a cell, is excellent in safety, and is effective in reducing environmental impact.

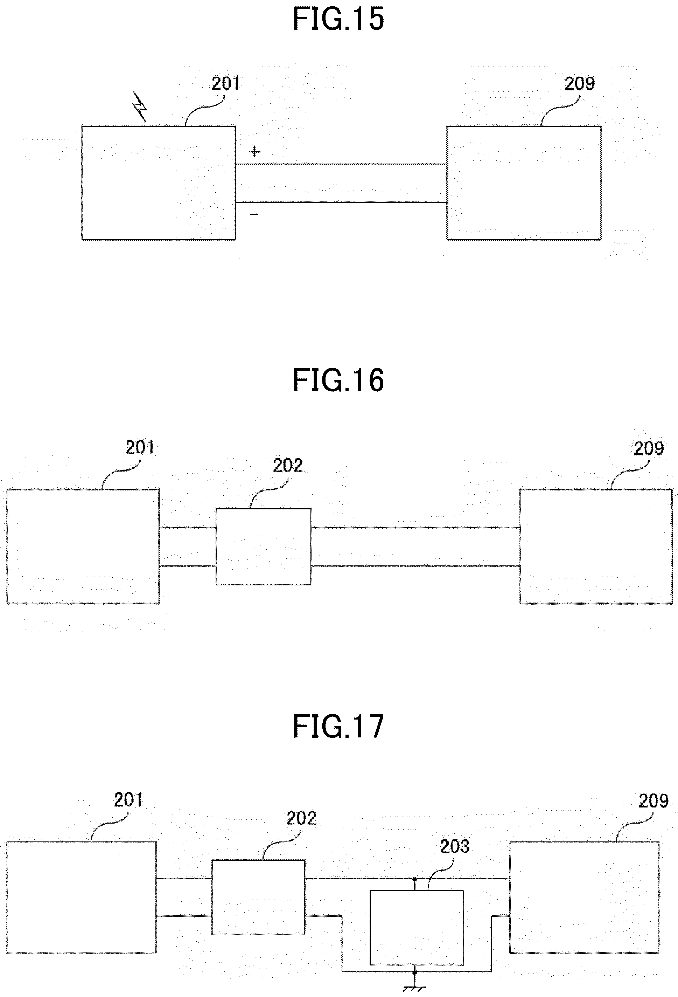

Fig. 15 presents a basic configuration diagram of an electronic device obtained by combining the photoelectric conversion element and/or photoelectric conversion module of the present disclosure with a device configured to be driven by electric power generated through photoelectric conversion of the photoelectric conversion element and/or photoelectric conversion module. The electronic device can generate electricity when the photoelectric conversion element is irradiated with light, and can extract electric power. A circuit of the device can be driven by the generated electric power.

Since the output of the photoelectric conversion element varies depending on circumferential illuminance, the electronic device presented in Fig. 15 may not be stably driven in some cases. In this case, as presented in Fig. 16, a power supply IC 202 for a photoelectric conversion element can be incorporated between a photoelectric conversion element 201 and a device circuit 209 in order to supply stable voltage to a side of the circuit, and such arrangement is effective.

However, the photoelectric conversion element can generate electricity as long as light of a sufficient illuminance is emitted. However, when the photoelectric conversion element lacks illuminance enough to generate electricity, desired electric power cannot be obtained, which is a disadvantage of the photoelectric conversion element. In this case, as presented in Fig. 17, when an electricity storage device 203 such as a capacitor is mounted between a power supply IC 202 and a device circuit 209, excessive electric power from a photoelectric conversion element 201 can be stored in an electricity storage device 203. In addition, the electric power stored in the electricity storage device 203 can be supplied to the device circuit 209 to thereby enable stable operation when the illuminance is too low or even when no light is applied to the photoelectric conversion element 201.

As described above, the electronic device obtained by combining the photoelectric conversion element and/or the photoelectric conversion module of the present disclosure with the device circuit can be driven even in an environment without a power supply, does not require replacement of a cell, and can be stably driven, in combination with a power supply IC or an electricity storage device. Therefore, it is possible to make the most of advantages of the photoelectric conversion element.

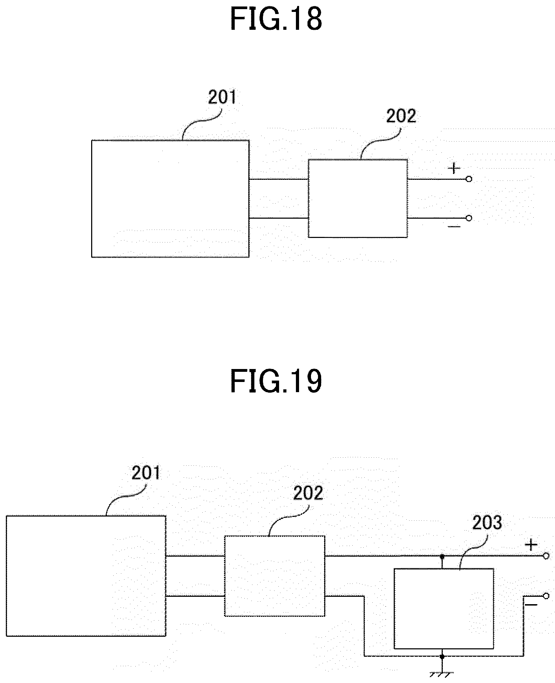

Meanwhile, the photoelectric conversion element and/or the photoelectric conversion module of the present disclosure can also be used as a power supply module, and such use is effective. As presented in Fig. 18, for example, when the photoelectric conversion element and/or the photoelectric conversion module of the present disclosure are/is connected to a power supply IC 202 for a photoelectric conversion element, it is possible to constitute a DC power supply module, which is capable of supplying electric power generated through photoelectric conversion of a photoelectric conversion element 201 to the power supply IC 202 at a predetermined voltage level.

Moreover, as presented in Fig. 19, when an electricity storage device 203 is added to a power supply IC 202, electric power generated by a photoelectric conversion element 201 can be stored in the electricity storage device 203. Therefore, it is possible to constitute a power supply module capable of supplying electric power when the illuminance is too low or even when no light is applied to the photoelectric conversion element 201.

The power supply modules of the present disclosure presented in Fig. 18 and Fig. 19 can be used as a power supply module without replacement of a cell as in case of conventional primary cells.

### Examples

Hereinafter, Examples of the present disclosure will be described, but the present disclosure shall not be construed as being limited to these Examples.

### (Example 1)

### <Production of photoelectric conversion module>

On a glass substrate as a first substrate, a film of indium-doped tin oxide (ITO) and a film of niobium-doped tin oxide (NTO) as a first electrode were sequentially formed through sputtering (ITO: average thickness 250 nm, and NTO: average thickness 150 nm). Then, a compact layer (average thickness 20 nm) formed of titanium oxide as a hole blocking layer was formed through reactive sputtering using an oxygen gas.

Next, a titanium oxide paste (manufactured by JGC Catalysts and Chemicals Ltd., product name: PST-18NR) was coated on the hole blocking layer through screen printing so as to have an average thickness of about 0.7 µm. After the coated paste was dried at 120°C, it was fired at 550°C for 30 minutes in the air to form a porous electron transport layer. Then, the ITO/NTO layer, the hole blocking layer, and the electron transport layer were each divided into eight cells through laser processing.

The glass substrate on which the electron transport layer was formed was immersed in a solution, which was obtained by adding an acetonitrile/t-butanol (volume ratio 1:1) mixed liquid to a photosensitization compound (0.2 mM) expressed by the following (B-5) under stirring. Then, the mixture was left to stand for an hour in a dark place, and the photosensitization compound was adsorbed on the surface of the electron transport layer.

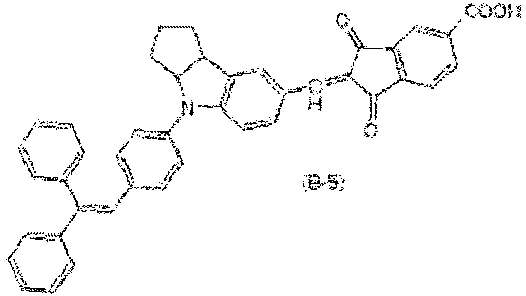

Next, to a chlorobenzene solution, lithium (fluorosulfonyl)(trifluoromethanesulfonyl)imide (Li-FTFSI) (manufactured by KISHIDA CHEMICAL CO.,LTD.) (65.1 mM) as a lithium salt, a pyridine compound expressed by the following (H-1) (146.5 mM), an organic hole transport material (HTM) (SHT-263, manufactured by Merck) (162.8 mM) expressed by the following (D-7), and a cobalt complex expressed by the following (F-11) (manufactured by Greatcell solar materials) (12.7 mM) were added, followed by dissolving these materials, to thereby prepare a coating liquid for hole transport layer. Note that, a molar ratio of the pyridine compound (a) to the lithium salt (b) was 2.25.

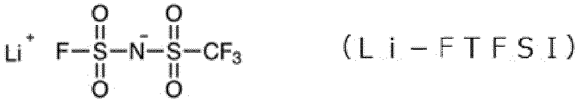

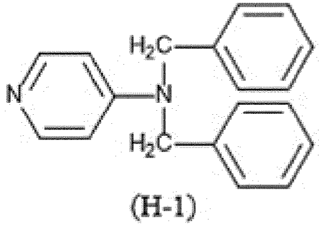

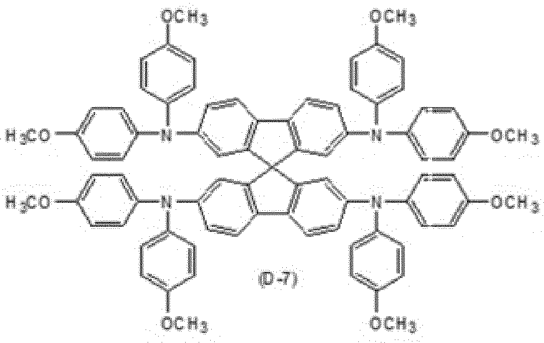

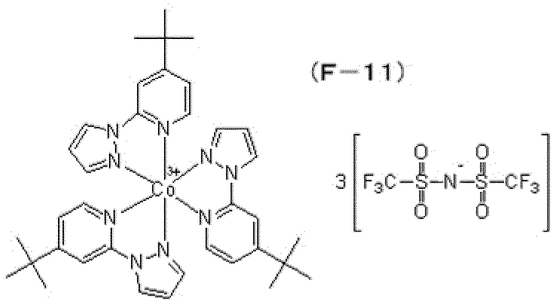

Then, on the electron transport layer on which the photosensitization compound was adsorbed, a hole transport layer having an average thickness of about 600 nm was formed through die coating using the coating liquid for hole transport layer. As described above, a photoelectric conversion layer including the electron transport layer and the hole transport layer was formed.

Then, after a mask was placed between the edge and the cell of the glass substrate, silver was deposited in vacuum to form a second electrode having an average thickness of about 70 nm.

On the second electrode, a film of a silane structure-including fluorine compound (manufactured by Harves Co., Ltd., product name: DURASURF DS-5935F130) as an electrode protection layer was formed through die coating so as to have an average thickness of 10 nm.

Then, in order to form parts where the sealing parts were to be in contact with the glass substrate, an etching treatment (deletion treatment) through laser processing was applied to 1.0 mm-wide parts from the edges of the glass substrate to be provided with the sealing parts. The etching treatment was applied between the cells in the same manner. Moreover, a through hole connected to the ITO/NTO layer, which is a terminal extraction part, was formed through laser processing, and a through hole to connect the cells in series was formed through laser processing.

A sealing part-including aluminum PET sheet (manufactured by Tesa, pressure-sensitive adhesive A, moisture-trapping property of 60 mg/100 mm², peel strength: 5 N/1 cm or more, a drying agent: calcium oxide), in which a sealing part and a second substrate were integrated, was pasted to the whole glass substrate using a vacuum assembly machine (manufactured by JOYO ENGINEERING CO., LTD., machine name: airbag-type vacuum laminator). The pasted products were joined with pressure while being warmed to 70°C using a heat laminator, to form a sealing part, a sealing substrate, and a second substrate.

As described above, the power generation region was sealed, and an UV protection film (manufactured by LINTEC Corporation, product name: PET50 HD UV400 PET25) was finally pasted to a surface that receives light, to produce a photoelectric conversion module as presented in Fig. 6.

The peel strength is a peel strength measured by a 180° peel test according to JIS K6854-2.

### (Example 2)

The photoelectric conversion module of Example 2 was produced in the same manner as in Example 1 except that the width for the laser etching treatment after the film formation of the electrode protection layer was changed to 1.5 mm from the edge.

### (Example 3)

The photoelectric conversion module of Example 3 was produced in the same manner as in Example 1 except that the width for the laser etching treatment after the film formation of the electrode protection layer was changed to 0.5 mm from the edge.

### (Example 4)

The photoelectric conversion module of Example 4 was produced in the same manner as in Example 1 except that the average thickness of the coating liquid for hole transport layer was changed to 400 nm.

### (Example 5)

The photoelectric conversion module of Example 5 was produced in the same manner as in Example 1 except that the average thickness of the coating liquid for hole transport layer was changed to 900 nm.

### (Example 6)

The photoelectric conversion module of Example 6 was produced in the same manner as in Example 1 except that the sealing part-including aluminum PET sheet (manufactured by Tesa, pressure-sensitive adhesive A, moisture-trapping property of 60 mg/100 mm², peel strength: 5 N/1 cm or more, a drying agent: calcium oxide) was changed to "AFTINNOVA (registered trademark) EF (a pressure-sensitive adhesive, moisture-trapping property of 20 mg/100 mm², including a drying agent)" (manufactured by Ajinomoto Fine-Techno Co., Inc.).

### (Example 7)

The photoelectric conversion module of Example 7 was produced in the same manner as in Example 1 except that the sealing part-including aluminum PET sheet (manufactured by Tesa, pressure-sensitive adhesive A, moisture-trapping property of 60 mg/100 mm², peel strength: 5 N/1 cm or more, a drying agent: calcium oxide) was changed to S2191 (pressure-sensitive adhesive B, peel strength: 5 N/1 cm or more, including no drying agent) (manufactured by Moresco).

### (Example 8)

The photoelectric conversion module of Example 8 was produced in the same manner as in Example 1 except that the sealing part-including aluminum PET sheet (manufactured by Tesa, pressure-sensitive adhesive A, moisture-trapping property of 60 mg/100 mm², peel strength: 5 N/1 cm or more, a drying agent: calcium oxide) was changed to S9012 (pressure-sensitive adhesive C, peel strength: 5 N/1 cm or more, including no drying agent) (manufactured by Moresco).

### (Example 9, not according to the invention)

The photoelectric conversion module of Example 9 was produced in the same manner as in Example 1 except that no electrode protection layer was formed.

### (Example 10, not according to the invention)

The photoelectric conversion module of Example 10 was produced in the same manner as in Example 1 except that the material of the electrode protection layer was changed to aluminum oxide.

### (Example 11)

The photoelectric conversion module of Example 11 was produced in the same manner as in Example 1 except that the pyridine compound (H-1) used for adjusting the coating liquid for hole transport layer was changed to a pyridine compound expressed by the following (H-3).

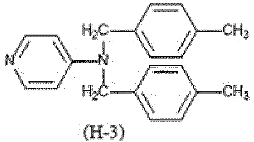

### (Example 12)

The photoelectric conversion module of Example 12 was produced in the same manner as in Example 1 except that the pyridine compound (H-1) used for adjusting the coating liquid for hole transport layer was changed to a pyridine compound expressed by the following (H-5).

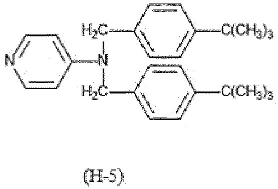

### (Example 13)

The photoelectric conversion module of Example 13 was produced in the same manner as in Example 1 except that the sealing part-including aluminum PET sheet (manufactured by Tesa, pressure-sensitive adhesive A, moisture-trapping property of 60 mg/100 mm², peel strength: 5 N/1 cm or more, a drying agent: calcium oxide) was changed to PSA (manufactured by Tesa, pressure-sensitive adhesive A, moisture-trapping property of 30 mg/100 mm², peel strength: 5 N/1 cm or more, drying agent: calcium oxide) having half moisture-trapping property.

### (Example 14)

The photoelectric conversion module of Example 14 was produced in the same manner as in Example 1 except that the photoelectric conversion layer was changed to a perovskite layer as described below. Specifically, lead iodide(II) (0.5306 g), lead bromide(II) (0.0736 g), methylamine bromide (0.0224 g), formamidinium iodide (0.1876 g), and potassium iodide (0.0112 g) were added to N,N-dimethylformamide (0.8 ml) and dimethyl sulfoxide (0.2 ml), and were heated at 60°C under stirring, to obtain a solution. The solution was coated on the electron transport layer through spin coating method while chlorobenzene (0.3 ml) was added thereto to form a perovskite film. Then, the perovskite film was dried at 150°C for 30 minutes to form a perovskite layer.

### (Comparative Example 1)

A photoelectric conversion module of Comparative Example 1 was produced in the same manner as in Example 1 except that the material of the sealing part was changed to a UV curable resin (product name: WorldRock No. 5910, manufactured by Kyoritsu Chemical & Co., Ltd.).

### <Performance evaluation of photoelectric conversion module>

The performance (initial maximum output electric power Pmax1 and Pmax maintenance rate) of each photoelectric conversion module was evaluated in the following manners. Table 3 presents the result.

The obtained photoelectric conversion module was measured for IV characteristics at 25°C and 200 lx using a solar cell evaluation system (As-510-PV03, manufactured by NF Corporation) to determine the initial maximum output electric power Pmax1 (µW/cm²).

After the photoelectric conversion module was left to stand for about 500 hours under the environment of 60°C and relative humidity of 90% in a thermostat bath, the photoelectric conversion module was measured for the IV characteristics again to determine the Pmax maintenance rate [(Pmax2/Pmax1) × 100] (%).

Table 3 also presents the results of the initial value maintenance rates obtained by continuously irradiating the produced photoelectric conversion modules with LED of 20 klx.

### <Evaluation of moisture-trapping property>

The moisture-trapping property of the sealing part-including aluminum PET sheet was evaluated in the following manner. The sealing part-including aluminum PET sheet was cut so as to have a size of 100 mm² and was measured for the weight using a precision balance, to determine weight (1). After measurement of the weight (1), the sealing part-including aluminum PET sheet was stored for 5 hours or more under the environment of 60°C and 90%, and the weight thereof was measured again, to determine weight (2). The value of the weigh (2) - the weight (1) was defined as the moisture-trapping property to determine the moisture-trapping property. When the moisture-trapping property was evaluated, measurement was performed with a peel film that protected the sealing part being removed.

**Table 2**

| | | Power generation layer | | | Sealing part | | | | Sealing width (mm) | Electrode protection layer |
|---|---|---|---|---|---|---|---|---|---|---|
| | | Compound | Photoelectric conversion layer | Average thickness (µm) | Kind | Resin | Peel strength (N/1 cm) | Amount of drying agent (70 mg/cm²) | | |
| Ex. | 1 | H-1 | Photosensitization compound | 0.7 | A | Rubber-based resin | 5 or more | 60 | 1.0 | Presence |
| | 2 | H-1 | Photosensitization compound | 0.7 | A | Rubber-based resin | 5 or more | 60 | 1.5 | Presence |
| | 3 | H-1 | Photosensitization compound | 0.7 | A | Rubber-based resin | 5 or more | 60 | 0.5 | Presence |
| | 4 | H-1 | Photosensitization compound | 0.4 | A | Rubber-based resin | 5 or more | 60 | 1.0 | Presence |
| | 5 | H-1 | Photosensitization compound | 0.9 | A | Rubber-based resin | 5 or more | 60 | 1.0 | Presence |
| | 6 | H-1 | Photosensitization compound | 0.7 | B | Epoxy-based resin | 5 or more | 20 | 1.0 | Presence |
| | 7 | H-1 | Photosensitization compound | 0.7 | C | Olefin-based resin | 5 or more | 0 | 1.0 | Presence |
| | 8 | H-1 | Photosensitization compound | 0.7 | D | Acrylic resin | 5 or more | 0 | 1.0 | Presence |
| | 9* | H-1 | Photosensitization compound | 0.7 | A | Rubber-based resin | 5 or more | 60 | 1.0 | Absence |
| | 10* | H-1 | Photosensitization compound | 0.7 | A | Rubber-based resin | 5 or more | 60 | 1.0 | Presence |
| | 11 | H-3 | Photosensitization compound | 0.7 | A | Rubber-based resin | 5 or more | 60 | 1.0 | Presence |
| | 12 | H-5 | Photosensitization compound | 0.7 | A | Rubber-based resin | 5 or more | 60 | 1.0 | Presence |
| | 13 | H-1 | Photosensitization compound | 0.7 | A | Rubber-based resin | 5 or more | 30 | 1.0 | Presence |
| | 14 | H-1 | Perovskite | 0.7 | A | Rubber-based resin | 5 or more | 60 | 1.0 | Presence |
| Comp. Ex. | 1 | H-1 | Photosensitization compound | 0.7 | A | UV curable resin | Less than 5 | 0 | 1.0 | Presence |

| | | | | | | | | | | |
|---|---|---|---|---|---|---|---|---|---|---|
| *) Examples 9 and 10 are not according to the invention | | | | | | | | | | |

**Table 3 (Examples 9 and 10 are not according to the invention)**

| | | Evaluation criteria | |
|---|---|---|---|
| | | Initial value maintenance rate (%) after storage at 60°C and relative humidity of 90% | Initial value maintenance rate (%) after use under high illuminance (20 klx) |
| Ex. | 1 | 95 | 94 |
| | 2 | 94 | 93 |
| | 3 | 90 | 92 |
| | 4 | 94 | 89 |
| | 5 | 93 | 88 |
| | 6 | 83 | 82 |
| | 7 | 75 | 77 |
| | 8 | 75 | 77 |
| | 9 | 73 | 72 |
| | 10 | 90 | 91 |
| | 11 | 93 | 92 |
| | 12 | 92 | 93 |
| | 13 | 90 | 89 |
| | 14 | 90 | 94 |
| Comp. Ex. | 1 | 60 | 60 |

From the results of Table 3, it was found that use of the pressure-sensitive adhesive in the sealing part of each of the photoelectric conversion modules of Examples 1 to 6 can achieve high output under light having a low illuminance even after storage under high temperature and high humidity conditions (60°C and relative humidity of 90%).

On the other hand, the photoelectric conversion module of Comparative Example including an ultraviolet-ray curable resin includes a photoacid generator as a polymerization initiator. The photoacid generator absorbs light, followed by decomposition. Then, hydrogen is drawn from a solvent or a photoacid generator itself, to generate acid.

It is believed that the generated acid described above does not undergo a chemical reaction under normal temperature environment, but results in deterioration of the photoelectric conversion element because the acid chemically reacts with the pyridine compound represented by the above Formula (1) or the above Formula (2) under high temperature environment, such as an environment of 60°C.

It was found that inclusion of the drying agent in the pressure-sensitive adhesive maintains high output under light having a low illuminance after storage under high temperature and high humidity environment of 60°C and relative humidity of 90% and after use under an environment of high illuminance (20 klx). It is believed that the reason for this is as follows. Specifically, inclusion of the drying agent in the adhesive allows the pressure-sensitive adhesive to absorb wavelength of infrared rays and visible rays, and the light absorption property at the time of laser processing is improved to thereby improve the precision of laser-processed cross section. As a result, the processing damage to the first electrode is decreased. It was found that the aforementioned improvement of the precision of processed cross section affects the productivity yield, and use of the pressure-sensitive adhesive that includes the drying agent can also improve the productivity yield.

Further, the present invention is not limited to these embodiments, but various variations and modifications may be made without departing from the scope of the present invention as defined in the appended claims.

## Claims

1. A photoelectric conversion element (101) comprising:
a first electrode (2);
a photoelectric conversion layer; and
a second electrode (7),
wherein the photoelectric conversion element includes a sealing part (8) disposed so as to cover at least side surfaces of the photoelectric conversion layer and the second electrode,
the sealing part (8) includes a pressure-sensitive adhesive **characterized in that** the pressure-sensitive adhesive has a 180° peel strength of 5 N/cm or more, wherein the 180° peel strength is measured according to the JIS standard K6854-2,
wherein the sealing part includes at least one selected from the group consisting of olefin-based resins, rubber-based resins, silicon-based resins, and acrylic resins,
wherein the photoelectric conversion element further includes an electrode protection layer (13) between the sealing part and the second electrode, and
wherein the electrode protection layer includes a fluorine compound having a silane structure.

2. The photoelectric conversion element (101) according to claim 1, wherein the photoelectric conversion layer includes a basic compound.

3. The photoelectric conversion element (101) according to claim 2, wherein the basic compound is a pyridine compound.

4. The photoelectric conversion element (101) according to claim 3,
wherein the pyridine compound includes at least one compound selected from the group consisting of a tertiary amine compound represented by Formula (1) below and a tertiary amine compound represented by Formula (2) below, 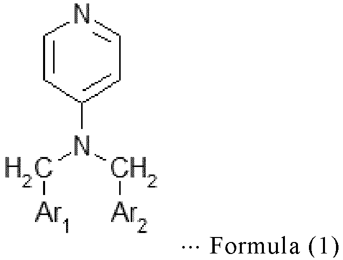 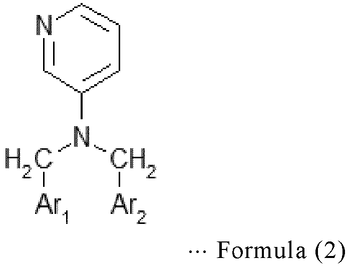
where, in each of the Formula (1) and the Formula (2), Ar₁ and Ar₂ represent an aryl group that may have a substituent, and the Ar₁ and the Ar₂, which may be identical to or different from each other, may be bound to each other.

5. The photoelectric conversion element (101) according to any one of claims 1 to 4,
wherein the photoelectric conversion element further includes a sealing substrate on a surface of the sealing part opposite to a surface of the sealing part facing the second electrode.

6. The photoelectric conversion element (101) according to any one of claims 1 to 5,
wherein the sealing part includes a moisture-trapping material.

7. The photoelectric conversion element (101) according to claim 6,
wherein the moisture-trapping material has a moisture-trapping property of 20 mg/100 mm² or more.

8. The photoelectric conversion element(101) according to claim 6 or 7, wherein the moisture-trapping material is a drying agent.

9. The photoelectric conversion element (101) according to claim 8,
wherein the drying agent is at least one selected from the group consisting of activated carbon, zeolite, calcium compounds, magnesium compounds, silica gel, and organometallic compounds.

10. The photoelectric conversion element according to any of the preceding claims, wherein the sealing part includes rubber-based resins.

11. A photoelectric conversion module comprising
the photoelectric conversion element according to any one of claims 1 to 10.

12. An electronic device comprising:
the photoelectric conversion element (101) according to any one of claims 1 to 10 or the photoelectric conversion module according to claim 11; and
a device configured to be driven by electric power generated through photoelectric conversion of the photoelectric conversion element or the photoelectric conversion module.

13. An electronic device comprising:
the photoelectric conversion element (101) according to any one of claims 1 to 10 or the photoelectric conversion module according to claim 11;
an electricity storage cell that can store electric power generated through photoelectric conversion of the photoelectric conversion element or the photoelectric conversion module; and
a device configured to be driven by the electric power stored in the electricity storage cell.

## Patentansprüche

1. Photoelektrisches Umwandlungselement (101), umfassend:
eine erste Elektrode (2);
eine photoelektrische Umwandlungsschicht; und
eine zweite Elektrode (7),
wobei das photoelektrische Umwandlungselement ein Dichtungsteil (8) beinhaltet, das angeordnet ist, um mindestens Seitenflächen der photoelektrischen Umwandlungsschicht und der zweiten Elektrode abzudecken,
wobei das Dichtungsteil (8) einen Haftkleber beinhaltet, der **dadurch gekennzeichnet ist, dass** der Haftkleber eine 180°-Schälfestigkeit von 5 N/cm oder mehr aufweist, wobei die 180°-Schälfestigkeit gemäß JIS-Standard K6854-2 gemessen wird,
wobei das Dichtungsteil mindestens eines beinhaltet, ausgewählt aus der Gruppe bestehend aus Harzen auf Olefinbasis, Harzen auf Kautschukbasis, Harzen auf Siliziumbasis und Acrylharzen,
wobei das photoelektrische Umwandlungselement ferner eine Elektrodenschutzschicht (13) zwischen dem Dichtungsteil und der zweiten Elektrode beinhaltet, und
wobei die Elektrodenschutzschicht eine Fluorverbindung mit einer Silanstruktur beinhaltet.

2. Photoelektrisches Umwandlungselement (101) nach Anspruch 1,
wobei die photoelektrische Umwandlungsschicht eine basische Verbindung beinhaltet.

3. Photoelektrisches Umwandlungselement (101) nach Anspruch 2,
wobei die basische Verbindung eine Pyridinverbindung ist.

4. Photoelektrisches Umwandlungselement (101) nach Anspruch 3,
wobei die Pyridinverbindung mindestens eine Verbindung beinhaltet, ausgewählt aus der Gruppe bestehend aus einer tertiären Aminverbindung, dargestellt durch Formel (1) unten, und einer tertiären Aminverbindung, dargestellt durch Formel (2) unten, 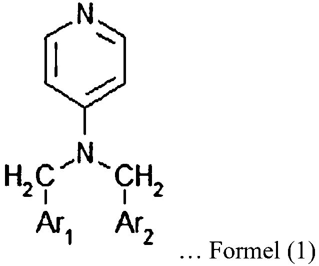 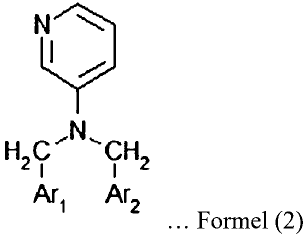
wobei, in jeder aus der Formel (1) und der Formel (2), Ar₁ und Ar₂ eine Arylgruppe darstellen, die einen Substituenten aufweisen kann, und das Ar₁ und das Ar₂, die identisch zueinander oder unterschiedlich voneinander sein können, aneinandergebunden sein können.

5. Photoelektrisches Umwandlungselement (101) nach einem der Ansprüche 1 bis 4,
wobei das photoelektrische Umwandlungselement ferner ein Dichtungssubstrat gegenüber einer Oberfläche des Dichtungsteils beinhaltet, das der zweiten Elektrode zugewandt ist.

6. Photoelektrisches Umwandlungselement (101) nach einem der Ansprüche 1 bis 5,
wobei das Dichtungsteil ein Feuchtigkeit-einfangendes Material beinhaltet.

7. Photoelektrisches Umwandlungselement (101) nach Anspruch 6,
wobei das Feuchtigkeit-einfangende Material eine Feuchtigkeit-einfangende Eigenschaft von 20 mg/100 mm² oder mehr aufweist.

8. Photoelektrisches Umwandlungselement (101) nach Anspruch 6 oder 7,
wobei das Feuchtigkeit-einfangende Material ein Trocknungsmittel ist.

9. Photoelektrisches Umwandlungselement (101) nach Anspruch 8,
wobei das Trocknungsmittel mindestens eines ist, ausgewählt aus der Gruppe bestehend aus Aktivkohle, Zeolith, Calciumverbindungen, Magnesiumverbindungen, Kieselgel und metallorganischen Verbindungen.

10. Photoelektrisches Umwandlungselement nach einem der vorhergehenden Ansprüche, wobei das Dichtungsteil Harze auf Kautschukbasis beinhaltet.

11. Photoelektrisches Umwandlungsmodul, umfassend
das photoelektrische Umwandlungselement nach einem der Ansprüche 1 bis 10.

12. Elektronische Vorrichtung, umfassend:
das photoelektrische Umwandlungselement (101) nach einem der Ansprüche 1 bis 10 oder das photoelektrische Umwandlungsmodul nach Anspruch 11; und
eine Vorrichtung, die konfiguriert ist, um durch elektrische Energie angetrieben zu werden, die durch photoelektrische Umwandlung des photoelektrischen Umwandlungselements oder des photoelektrischen Umwandlungsmoduls generiert wird.

13. Elektronische Vorrichtung, umfassend:
das photoelektrische Umwandlungselement (101) nach einem der Ansprüche 1 bis 10 oder das photoelektrische Umwandlungsmodul nach Anspruch 11;
eine Elektrizitätsspeicherzelle, die elektrische Energie speichern kann, die durch photoelektrische Umwandlung des photoelektrischen Umwandlungselements oder des photoelektrischen Umwandlungsmoduls generiert wird; und
eine Vorrichtung, die konfiguriert ist, um durch elektrische Energie angetrieben zu werden, die in der Elektrizitätsspeicherzelle gespeichert wird.

## Revendications

1. Élément de conversion photoélectrique (101) comprenant :
une première électrode (2),
une couche de conversion photoélectrique, et
une deuxième électrode (7) ;
l'élément de conversion photoélectrique comprenant une pièce de scellage (8) disposée de façon à recouvrir au moins les surfaces latérales de la couche de conversion photoélectrique et de la deuxième électrode,
la pièce de scellage (8) comprenant un adhésif sensible à la pression ;
**caractérisé en ce que** l'adhésif sensible à la pression a une résistance au pelage à 180° supérieure ou égale à 5 N/cm, la résistance au pelage à 180° étant mesurée selon la norme JIS K6854-2,
la pièce de scellage comprenant au moins un type de résine choisi dans le groupe constitué par les résines à base d'oléfines, les résines à base de caoutchouc, les résines à base de silicone et les résines acryliques,
l'élément de conversion photoélectrique comprenant en outre une couche de protection d'électrode (13) entre la pièce de scellage et la deuxième électrode, et
la couche de protection d'électrode comprenant un composé fluoré ayant une structure silane.

2. Élément de conversion photoélectrique (101) selon la revendication 1,
dans lequel la couche de conversion photoélectrique comprend un composé basique.

3. Élément de conversion photoélectrique (101) selon la revendication 2,
dans lequel le composé basique est un composé pyridine.

4. Élément de conversion photoélectrique (101) selon la revendication 3,
dans lequel le composé pyridine comprend au moins un composé choisi dans le groupe constitué par un composé d'amine tertiaire représenté par la formule (1) ci-dessous et un composé d'amine tertiaire représenté par la formule (2) ci-dessous, 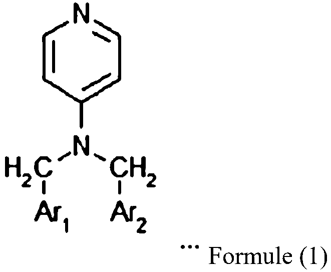 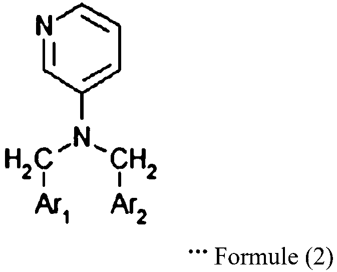
dans lesquelles formules (1) et (2) Ar₁ et Ar₂ représentent un groupe aryle susceptible d'avoir un substituant, et Ar₁ et Ar₂, qui peuvent être identiques ou différents l'un de l'autre, peuvent être liés l'un à l'autre.

5. Élément de conversion photoélectrique (101) selon l'une quelconque des revendications 1 à 4,
dans lequel l'élément de conversion photoélectrique comprend en outre un substrat de scellage sur une surface de la pièce de scellage opposée à une surface de la pièce de scellage tournée vers la deuxième électrode.

6. Élément de conversion photoélectrique (101) selon l'une quelconque des revendications 1 à 5,
dans lequel la pièce de scellage comprend un matériau piégeant l'humidité.

7. Élément de conversion photoélectrique (101) selon la revendication 6,
dans lequel le matériau piégeant l'humidité a une propriété de piégeage d'humidité supérieure ou égale à 20 mg/100 mm².

8. Élément de conversion photoélectrique (101) selon la revendication 6 ou 7,
dans lequel le matériau piégeant l'humidité est un agent dessiccatif.

9. Élément de conversion photoélectrique (101) selon la revendication 8,
dans lequel l'agent dessiccatif est au moins un agent choisi dans le groupe constitué par le charbon actif, la zéolite, les composés de calcium, les composés de magnésium, le gel de silice et les composés organométalliques.

10. Élément de conversion photoélectrique selon l'une quelconque des revendications précédentes, dans lequel la pièce de scellage comprend des résines à base de caoutchouc.

11. Module de conversion photoélectrique comprenant :
l'élément de conversion photoélectrique selon l'une quelconque des revendications 1 à 10.

12. Dispositif électronique comprenant :
l'élément de conversion photoélectrique (101) selon l'une quelconque des revendications 1 à 10 ou le module de conversion photoélectrique selon la revendication 11, et
un dispositif conçu pour fonctionner à l'énergie électrique générée par une conversion photoélectrique assurée par l'élément de conversion photoélectrique ou le module de conversion photoélectrique.

13. Dispositif électronique comprenant :
l'élément de conversion photoélectrique (101) selon l'une quelconque des revendications 1 à 10 ou le module de conversion photoélectrique selon la revendication 11,
une cellule de stockage d'électricité susceptible de stocker l'énergie électrique générée par la conversion photoélectrique assurée par l'élément de conversion photoélectrique ou le module de conversion photoélectrique, et
un dispositif conçu pour fonctionner à l'énergie électrique stockée dans la cellule de stockage d'électricité.
